# EUROPEAN PATENT APPLICATION

(11) **EP 4 760 696 A1**
(43) Date of publication of application: **17.06.2026**
(21) Application number: 25200515.2
(22) Date of filing: 05.09.2025
(51) Int. Cl.: G09G 3/3266, G11C 19/28, G09G 3/3233

(54) **GATE DRIVER AND DISPLAY DEVICE INCLUDING THE SAME**

(30) Priority: 13.12.2024 KR 20240185963
(71) Applicant: LG Display Co., Ltd., Seoul, 07336 (KR)
(72) Inventor: SANG, WooKyu, 10845 Paju-si, Gyeonggi-do (KR); SEO, BoGun, 10845 Paju-si, Gyeonggi-do (KR); LEE, YoungJoon, 10845 Paju-si, Gyeonggi-do (KR)
(74) Representative: Viering, Jentschura & Partner mbB Patent- und Rechtsanwälte

(57) **Abstract**

Provided is a gate driver (120, 620, 1520, 1620). The gate driver (120, 620, 1520, 1620) includes a light emission driver (EDV) comprising a plurality of light emission stages (EST1, ..., EST32) cascaded and configured to output a plurality of light emission control signals (EM1, ..., EM32) on the basis of a light emission start signal (EVST) and a plurality of light emission clock signals (ECLK1, ECLK2) and an output controller (SCTR1, SCTR2) comprising a plurality of stages cascaded and configured to output a plurality of pull-up control signals (PUS1, ..., PUS4) and a plurality of pull-down control signals (PDS1, ..., PDS4) on the basis of the plurality of light emission control signals (EM1, ..., EM32), a plurality of clock signals (CLK1, CLK2), a plurality of control clock signals (CCLK1, ..., CCLK4), a first power source (VGH), and a second power source (VGL) having a lower voltage level than the first power source (VGH), wherein the plurality of stages each includes a carry part (CRY1, ..., CRY4) configured to output a carry signal (CR1, ..., CR4) on the basis of at least one of the plurality of light emission control signals (EM1, ..., EM32), at least one of the plurality of clock signals (CLK1, CLK2), the first power source (VGH), and the second power source (VGL) and an output part (OUT1, ..., OUT4) configured to output the pull-up control signal and the pull-down control signal on the basis of the carry signal (CR1, ..., CR4), at least one of the plurality of control clock signals (CCLK1, ..., CCLK4), the first power source (VGH), and the second power source (VGL).

## Description

### Technical Field

The present specification relates to a gate driver and a display device including the same, and more particularly, for example, without limitation, to a gate driver capable of controlling a driving frequency, and a display device including the same.

### Description of the Related Art

A display field for visually expressing electrical information signals has been rapidly developed as the information age has come in earnest. Therefore, various display devices, which are thin in thickness and light in weight and have excellent performances such as low power consumption, have been developed. Examples of the display devices may include a liquid crystal display device (LCD), an organic light-emitting display device (OLED), and the like.

The display device may include a display panel on which a plurality of pixels configured to display images are disposed, a data driver configured to supply data signals to the plurality of pixels through a plurality of data lines, a gate driver configured to supply gate signals to the plurality of pixels through a plurality of gate lines, and a drive circuit, such as a timing controller, configured to control the data driver and the gate driver.

The description provided in the background section should not be assumed to be prior art merely because it is mentioned in or associated with the background section. The background section may include information that describes one or more aspects of the subject technology.

### SUMMARY

An aspect of the present specification is to provide a gate driver capable of controlling a driving frequency for each area of a display panel, and a display device including the same.

Another aspect of the present specification is to provide a gate driver with a minimized bezel, and a display device including the same.

Still another aspect of the present specification is to provide a gate driver capable of improving quality of a display image, and a display device including the same.

Aspects of the present disclosure are not limited to the above-mentioned aspects, and other aspects, which are not mentioned above, can be clearly understood by those skilled in the art from the following descriptions. According to an aspect of the present disclosure, a gate driver according to claim 1 is provided. Further embodiments are described in the dependent claims.

According to an aspect of the present disclosure, a gate driver includes a light emission driver comprising a plurality of light emission stages cascaded and configured to output a plurality of light emission control signals on the basis of a light emission start signal and a plurality of light emission clock signals and an output controller comprising a plurality of stages cascaded and configured to output a plurality of pull-up control signals and a plurality of pull-down control signals on the basis of the plurality of light emission control signals, a plurality of clock signals, a plurality of control clock signals, a first power source, and a second power source having a lower voltage level than the first power source, wherein the plurality of stages each includes a carry part configured to output a carry signal on the basis of at least one of the plurality of light emission control signals, at least one of the plurality of clock signals, the first power source, and the second power source, and an output part configured to output a respective one of the plurality of pull-up control signals and a respective one of the plurality of pull-down control signals on the basis of the carry signal, at least one of the plurality of control clock signals, the first power source, and the second power source.

According to another aspect of the present disclosure, a gate driver includes an output controller comprising a plurality of stages cascaded and configured to output a plurality of pull-up control signals and a plurality of pull-down control signals on the basis of a plurality of light emission control signals, a plurality of clock signals, a plurality of control clock signals, a first power source, and a second power source having a lower voltage level than the first power source and a scan driver comprising a plurality of gate stages cascaded and configured to output a plurality of gate signals on the basis of a gate start signal, a plurality of gate clock signals, the plurality of pull-up control signals, and the plurality of pull-down control signals, wherein the plurality of stages each includes a carry part configured to output a carry signal on the basis of at least one of the plurality of light emission control signals, at least one of the plurality of clock signals, the first power source, and the second power source, and an output part configured to output a respective one of the plurality of pull-up control signals and a respective one of the plurality of pull-down control signals on the basis of the carry signal, at least one of the plurality of control clock signals, the first power source, and the second power source.

According to an aspect of the present disclosure, a display device includes a display panel comprising a plurality of pixels, a scan driver configured to output a plurality of gate signals to the plurality of pixels, a light emission driver configured to output a plurality of light emission control signals to the plurality of pixels and an output controller comprising a plurality of stages configured to output a plurality of pull-up control signals and a plurality of pull-down control signals on the basis of the plurality of light emission control signals, a plurality of clock signals, a plurality of control clock signals, a first power source, and a second power source having a lower voltage level than the first power source, wherein the plurality of stages each includes a carry part configured to output a carry signal on the basis of at least one of the plurality of light emission control signals, at least one of the plurality of clock signals, the first power source, and the second power source, and an output part configured to output a respective one of the plurality of pull-up control signals and a respective one of the plurality of pull-down control signals on the basis of the carry signal, at least one of the plurality of control clock signals, the first power source, and the second power source.

Other detailed matters of the exemplary embodiments are included in the detailed description and the drawings.

The present specification may include the output controller configured to control the output level of the gate signal outputted from the scan driver. Therefore, the present specification may freely divide the display area in response to the display image and control the driving frequency for each area without being limited to the fixed area. Therefore, the driving frequency is controlled in response to the display image, such that power consumption may be improved.

In addition, the present specification controls the signal level of the gate signal by using the output controller connected in common to the plurality of scan drivers, thereby minimizing the size of the bezel area in which the gate driver is disposed.

In addition, the present specification may include the voltage selector configured to control the voltage level of the bias voltage, which is provided to control the on-bias state of the pixel, for each display area in accordance with the driving frequency. Therefore, even though the driving frequency is differently controlled for each sub-display area of the display area, the display quality may not deteriorate.

The effects according to the present disclosure are not limited to the contents exemplified above, and more various effects are included in the present specification.

It is to be understood that both the foregoing general description and the following detailed description are exemplary and explanatory and are intended to provide further explanation of the inventive concepts as claimed.

### BRIEF DESCRIPTION OF DRAWINGS

The accompanying drawings, which are included to provide a further understanding of the disclosure and are incorporated in and constitute a part of this application, illustrate embodiments of the disclosure and together with the description serve to explain the principle of the disclosure. The above and other aspects, features and other advantages of the present disclosure will be more clearly understood from the following detailed description taken in conjunction with the accompanying drawings, in which:
FIG. 1 is a block diagram illustrating a display device according to an exemplary embodiment of the present specification;
FIGS. 2A and 2B are views illustrating an example of a display panel included in the display device in FIG. 1;
FIG. 3 is a circuit diagram illustrating an example of a pixel included in the display device in FIG. 1;
FIGS. 4A and 4B are waveform diagrams for explaining an example of an operation of the pixel in FIG. 3;
FIG. 5 is a block diagram illustrating a gate driver according to the exemplary embodiment of the present specification;
FIGS. 6A and 6B are block diagrams illustrating an example of the gate driver in FIG. 5;
FIG. 7 is a circuit diagram illustrating an example of a first stage included in an output controller of the gate driver in FIG. 6A;
FIGS. 8A and 8B are waveform diagrams for explaining an example of an operation of the first stage in FIG. 7;
FIG. 9 is a waveform diagram for explaining an example of an operation of the gate driver in FIG. 6A;
FIG. 10 is a block diagram illustrating an example of a scan driver included in the gate driver in FIG. 5;
FIG. 11 is a circuit diagram illustrating an example of a first gate stage included in the scan driver in FIG. 10;
FIG. 12 is a waveform diagram for explaining an example of an operation of the scan driver in FIG. 10;
FIG. 13 is a circuit diagram illustrating another example of a first gate stage included in the scan driver in FIG. 10;
FIG. 14 is a waveform diagram for explaining an example of the operation of the scan driver in FIG. 10;
FIG. 15 is a block diagram illustrating another example of the gate driver in FIG. 5;
FIG. 16 is a block diagram illustrating still another example of the gate driver in FIG. 5;
FIG. 17 is a waveform diagram illustrating an example of a control clock signal provided to the gate driver in FIG. 16;
FIG. 18 is a block diagram illustrating yet another example of the gate driver in FIG. 5;
FIG. 19 is a waveform diagram illustrating an example of a control clock signal provided to the gate driver in FIG. 18;
FIG. 20 is a block diagram illustrating still yet another example of the gate driver in FIG. 5;
FIG. 21 is a waveform diagram illustrating an example of a control clock signal provided to the gate driver in FIG. 20;
FIG. 22 is a block diagram illustrating a further example of the gate driver in FIG. 5;
FIG. 23 is a waveform diagram illustrating an example of a control clock signal provided to the gate driver in FIG. 22;
FIG. 24 is a block diagram illustrating the gate driver according to the exemplary embodiment of the present specification;
FIG. 25 is a circuit diagram illustrating an example of a first selection stage of a voltage selector included in the gate driver in FIG. 24;
FIGS. 26A to 26C are waveform diagrams for explaining an example of an operation of the first selection stage in FIG. 25; and
FIG. 27 is a waveform diagram for explaining another example of the operation of the pixel in FIG. 3.
Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE EMBODIMENT

Reference will now be made in detail to embodiments of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes (e.g., sizes, lengths, widths, heights, thicknesses, locations, radii, diameters, and areas), ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

The word "exemplary" is used to mean serving as an example or illustration. Aspects are example aspects. "Embodiments," "examples," "aspects," and the like should not be construed as preferred or advantageous over other implementations. An embodiment, an example, an example embodiment, an aspect, or the like may refer to one or more embodiments, one or more examples, one or more example embodiments, one or more aspects, or the like, unless stated otherwise. Further, the term "may" encompasses all the meanings of the term "can."

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

The terms, such as "below," "lower," "above," "upper" and the like, may be used herein to describe a relationship between elementitem(s) as illustrated in the drawings. It will be understood that the terms are spatially relative and based on the orientation depicted in the drawings.

When explaining temporal relationships, terms such as "after," "following," "subsequent to," or "before," etc., may include non-consecutive cases unless terms like "immediately" or "directly" are used.

Terms such as "first," "second," etc. are used to describe various components, but these components are not limited by these terms. These terms are merely used to distinguish one component from another. Therefore, a first component mentioned herein could be a second component within the technical scope of the present disclosure.

In describing the components of the present disclosure, terms such as first, second, A, B, (a), or (b) may be used. These terms are only intended to distinguish that one component from other components, and the nature, order, sequence, or number of the respective component is not limited by these terms.

When a component is described as being "connected," "coupled," "joined," or "attached" to another component, it should be understood that the component may be directly connected, coupled, joined, or attached to the other component, but unless explicitly specified otherwise, it may also be indirectly connected, coupled, joined, or attached with another component intervening between each component.

When a component or layer is described as being "in contact with" or "overlapping" another component or layer, the component or layer may directly contact or overlap the other component or layer, but unless explicitly specified otherwise, it should be understood that it may also indirectly contact or overlap with another component intervening between each component.

The term "at least one" should be understood to include all combinations of one or more of the associated components. For example, "at least one of first, second, and third components" means not only the first, second, or third component, but also includes all combinations of two or more components from among the first, second, and third components. The term "or" means "inclusive or" rather than "exclusive or." That is, unless otherwise stated or clear from the context, the expression that "x uses a or b" means any one of natural inclusive permutations. For example, "a or b" may mean "a," "b," or "a and b." For example, "a, b or c" may mean "a," "b," "c," "a and b," "b and c," "a and c," or "a, b and c."

The terms "first direction", "second direction", "third direction", "X-axis direction", "Y-axis direction", and "Z-axis direction" should not be interpreted solely as geometric relationships perpendicular to each other, but may indicate broader directionality within the range where the configuration of the present disclosure can function.

The features of various embodiments in the present disclosure may be partially or wholly combined or associated with each other, various technical interlocking and operations are possible, and each embodiment may be implemented independently of each other or may be implemented together in an associated relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Hereinafter, a display apparatus according to exemplary embodiments of the present disclosure will be described in detail with reference to accompanying drawings.

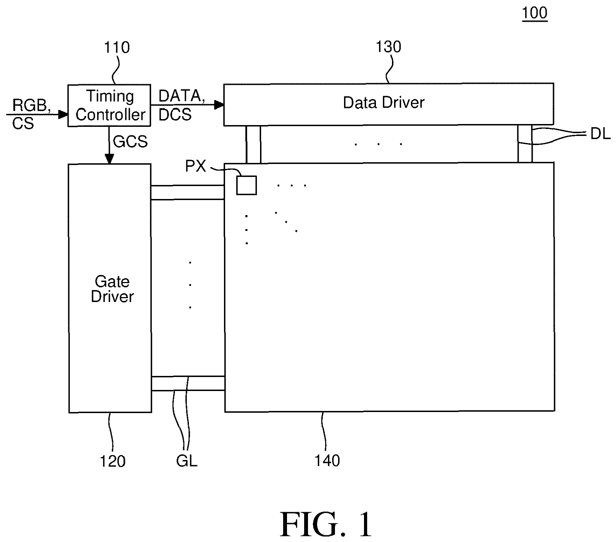

FIG. 1 is a block diagram illustrating a display device according to an exemplary embodiment of the present specification.

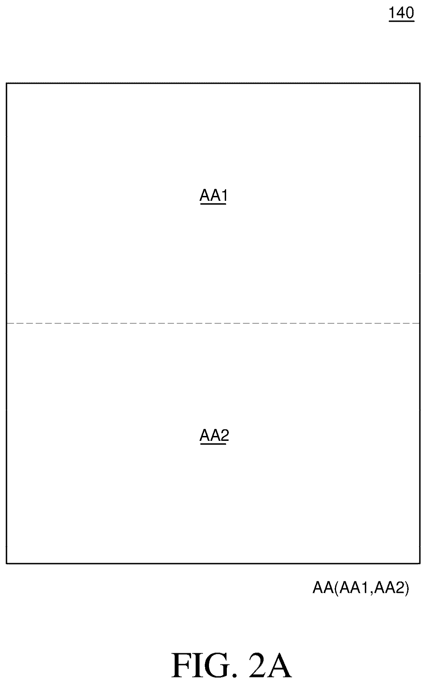

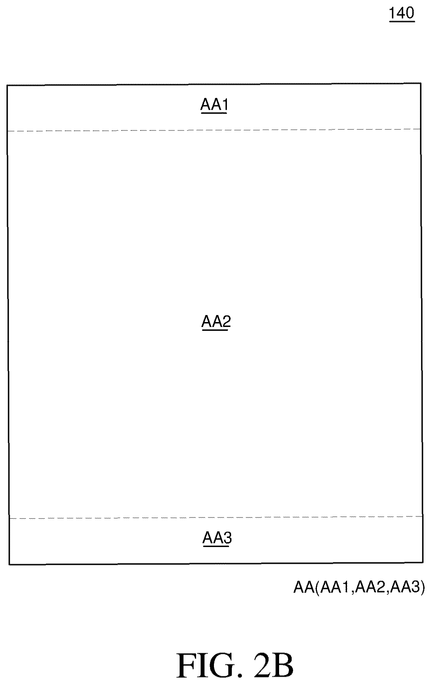

FIGS. 2A and 2B are views illustrating an example of a display panel included in the display device in FIG. 1.

With reference to FIG. 1, a display device 100 according to an exemplary embodiment of the present specification may include a timing controller 110, a gate driver 120, a data driver 130, and a display panel 140.

The display panel 140 may create an image to be provided to a user. For example, the display panel 140 may include a display area in which a plurality of pixels PX are disposed, and a non-display area excluding the display area. As an example, pixel circuits are respectively disposed in the plurality of pixels PX, without being limited thereto. As an example, the non-display area may extend from the display area. As an example, the non-display area may fully or partially surround the display area. As an example, the non-display area may be at least partially or fully invisible from a front side of the display panel 140, for example, by being bent toward a rear side of the display panel 140, without being limited thereto. As an example, the non-display area may be flat.

The plurality of pixels PX may each be connected to a corresponding gate line GL and a corresponding data line DL and display images in response to a gate signal provided to the gate line GL and a data signal provided to the data line DL.

In the exemplary embodiment, the display area of the display panel 140 may be divided into a plurality of areas. For example, the display area may include a plurality of sub-display areas. For example, with reference further to FIG. 2A, a display area AA of the display panel 140 may be divided into a first sub-display area AA1 and a second sub-display area AA2.

The first sub-display area AA1 and the second sub-display area AA2 included in the display area AA may each include at least one pixel PX. For example, at least one pixel PX may be disposed in each of the first sub-display area AA1 and the second sub-display area AA2.

In the exemplary embodiment, the display area AA is divided into the sub-display areas having the same size, such that the first sub-display area AA1 and the second sub-display area AA2 may have the same number of pixels PX. However, this is provided for illustrative purposes only. As an example, the display area AA may be divided into the sub-display areas having different sizes. As an example, the first sub-display area AA1 and the second sub-display area AA2 may have different numbers of pixels PX. As an example, the display area AA may be divided into the sub-display areas in a direction perpendicular to a direction in which the gate lines extend, without being limited thereto. The first sub-display area AA1 and the second sub-display area AA2 included in the display area AA may share one or more pixels PX, and/or the number of pixels PX of any one sub-display area may be larger than the number of pixels PX of another sub-display area.

Meanwhile, for convenience of description, the configuration in which the display area AA is divided into two sub-display areas has been described with reference to FIG. 2A. However, the embodiment of the present specification is not limited thereto. The display area AA may be divided into three or more sub-display areas. For example, as illustrated in FIG. 2B, the display area AA may be divided into the second sub-display area AA2, and the first sub-display area AA1 and a third sub-display area AA3 disposed at two opposite sides of the second sub-display area AA2. For example, the display area AA may be divided into three or more sub-display areas having the same size or differen sizes. As an example, the three or more sub-display areas may have the same or different numbers of pixels PX, without being limited thereto.

With reference back to FIG. 1, the timing controller 110 may control the gate driver 120 and the data driver 130 on the basis of an input image RGB and an input control signal CS provided from the outside (e.g., from a host system or the like). For example, the input control signal CS may include timing signals such as a horizontal synchronizing signal, a vertical synchronizing signal, a data enable signal, and a clock signal. The timing controller 110 may generate a gate control signal GCS and a data control signal DCS on the basis of the input control signal CS. The gate control signal GCS may be provided to the gate driver 120, and the data control signal DCS may be provided to the data driver 130.

In addition, the timing controller 110 may create image data DATA by realigning the input image RGB in a digital video data format to suit the resolution of the display panel 140 and provide the image data DATA to the data driver 130.

The gate driver 120 may generate gate signals on the basis of the gate control signal GCS and output the gate signals to the plurality of gate lines GL. For example, the gate driver 120 may sequentially output the gate signals to the plurality of gate lines GL in the units of pixel rows, without being limited thereto. The gate control signal GCS may include a start signal, a plurality of clock signals, and the like for generating the gate signal, without being limited thereto.

In the exemplary embodiment, the gate driver 120 may generate a scan signal and a light emission control signal on the basis of the gate control signal GCS. For example, the gate driver 120 may include at least one scan driver and at least one light emission driver. The scan driver may generate scan signals, for example, in a row-sequential manner to operate at least one scan line connected to each pixel row and supply the scan signals to a plurality of scan lines. The light emission driver may generate light emission control signals in a row-sequential manner to operate at least one light emission control line connected to each pixel row and supply the light emission signals to a plurality of light emission control lines.

On the basis of the data control signal DCS, the data driver 130 may convert the image data DATA in the digital format, which is provided from the timing controller 110, into the data signal in the analog format and supply the image data DATA to the plurality of data lines DL.

The display device 100 according to the exemplary embodiment of the present specification may display images with various driving frequencies depending on operation conditions, without being limited thereto. In this case, the driving frequency may refer to the frequency at which data signals are substantially written into a driving transistor included in the pixel PX. For example, the driving frequency may represent the frequency at which display images are refreshed for one second. As an example, the display device 100 may display images in response to various driving frequencies. Meanwhile, in the present specification, the driving frequency may be referred to as an image refresh rate, a screen frame rate, or a screen scan rate.

In the exemplary embodiment, an output frequency of the data driver 130 with respect to one horizontal line, e.g., one pixel row and/or an output frequency of the gate driver 120 configured to output the gate signal may be determined in response to the driving frequency of the display device 100. For example, a driving frequency for operating moving images or the like may correspond to a relatively high frequency, i.e., a frequency of about 60 Hz or higher, e.g., 60 Hz, 80 Hz, 96 Hz, 120 Hz, 240 Hz, or the like. In another example, a driving frequency for operating still images or the like may correspond to a relatively low frequency, i.e., a frequency of about 30 Hz or lower, e.g., 30 Hz, 10 Hz, 1 Hz, or the like. Therefore, depending on the operation conditions, the display device 100 may adjust the output frequency of the gate driver 120 with respect to one horizontal line, e.g., one pixel row and adjust the output frequency of the data driver 130 corresponding to the output frequency of the gate driver 120.

In the exemplary embodiment, the display device 100 may independently operate the plurality of sub-display areas included in the display area AA. For example, depending on driving modes of the display device 100, the display device 100 may operate the plurality of sub-display areas, which are included in the display area AA, with the same driving frequency or operate at least some of the plurality of sub-display areas with different driving frequencies.

Meanwhile, the corresponding sub-display areas may not be fixed areas when the display device 100 controls the driving frequency for each sub-display area of the display area AA. As an example, in the display device 100 according to the exemplary embodiment of the present specification, the display area AA may be divided into two or more sub-display areas based on a position at which the driving frequency is intended to be divided in response to the display image, e.g., based on a horizontal line based on which the driving frequency is intended to be divided. The sub-display areas may be operated with different driving frequencies.

As described above, the display device 100 according to the exemplary embodiment of the present specification is not limited to the fixed area. The display area AA of the display device 100 may be freely divided in response to the display image, and the driving frequency may be controlled for each area. Therefore, the driving frequency is controlled for each area in response to the display image, such that power consumption may be improved.

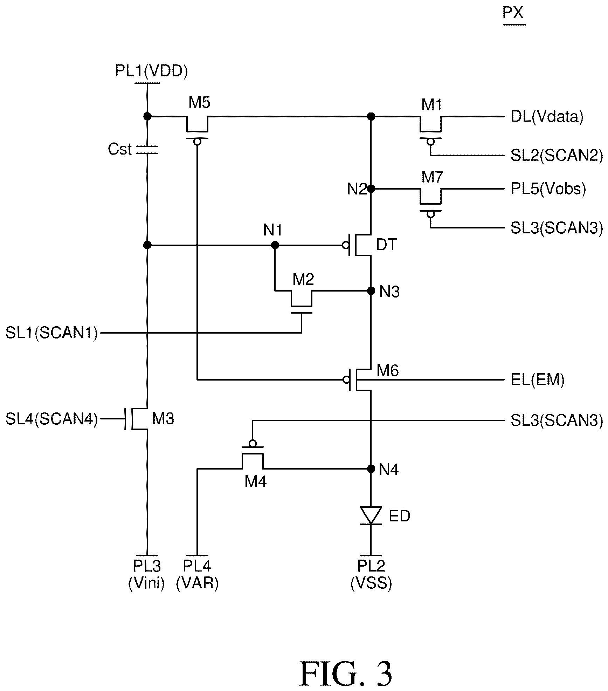

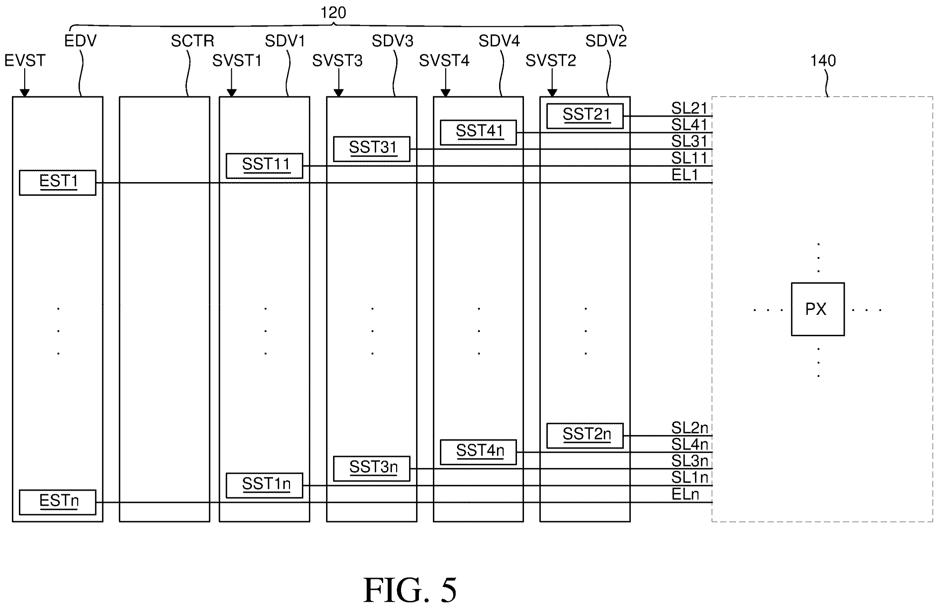

Hereinafter, the pixel PX and a method of operating the same will be described more specifically with reference to FIGS. 3 to 4B. An operating method, which allows the display device 100 according to the exemplary embodiments of the present specification to display images with various driving frequencies, will be described more specifically with reference to FIGS. 5 to 27.

FIG. 3 is a circuit diagram illustrating an example of the pixel included in the display device in FIG. 1.

With reference to FIG. 3, the pixel PX may include a light-emitting element ED, a driving transistor DT, a plurality of switching transistors M1, M2, M3, M4, M5, M6, and M7, and a storage capacitor Cst. Embodiments are not limited thereto. As an example, at least one of the switching transistors M1, M2, M3, M4, M5, M6, and M7 may be omitted depending on the design. As an example, one or more additional transistor or capacitor may be further included, without being limited thereto.

The driving transistor DT may be connected between a first power line PL1 configured to provide a high-potential power voltage VDD and a second power line PL2 configured to provide a low-potential power voltage VSS. The driving transistor DT may control a drive current to be applied to the light-emitting element ED in accordance with a source-gate voltage. For example, the driving transistor DT may control a drive current, which flows from the first power line PL1, which provides the high-potential power voltage VDD, to the second power line PL2, which provides the low-potential power voltage VSS, via the light-emitting element ED, in response to a voltage of a first node N1 that is a gate electrode. To this end, the high-potential power voltage VDD may be set to a voltage higher than the low-potential power voltage VSS. For example, the high-potential power voltage VDD may be a positive voltage, and the low-potential power voltage VSS may be a negative voltage, without being limited thereto.

A first switching transistor M1 may be connected between the data line DL, which provides a data signal Vdata, and a first electrode of the driving transistor DT, e.g., a second node N2 that is a source electrode. A gate electrode of the first switching transistor M1 may be connected to a second scan line SL2. When a second scan signal SCAN2 is supplied to the second scan line SL2, the first switching transistor M1 may be turned on and electrically connect the data line DL and the second node N2.

A second switching transistor M2 may be connected between a second electrode of the driving transistor DT, e.g., a third node N3, which is a drain electrode, and the first node N1 that is the gate electrode. A gate electrode of the second switching transistor M2 may be connected to a first scan line SL1. When a first scan signal SCAN1 is supplied to the first scan line SL1, the second switching transistor M2 may be turned on and electrically connect a gate electrode and a drain electrode of the driving transistor DT, e.g., the first node N1 and the third node N3. When the second switching transistor M2 is turned on, the driving transistor DT may be connected in the form of a diode.

A third switching transistor M3 may be connected between the first node N1 and a third power line PL3 which provides a first initialization voltage Vini. A gate electrode of the third switching transistor M3 may be connected to a fourth scan line SL4. When a fourth scan signal SCAN4 is supplied to the fourth scan line SL4, the third switching transistor M3 may be turned on and supply the first initialization voltage Vini to the first node N1. In this case, the gate electrode of the driving transistor DT, which is the first node N1, may be initialized to the first initialization voltage Vini. To this end, the first initialization voltage Vini may be set to a voltage lower than a lowest level of the data signal Vdata supplied to the data line DL, without being limited thereto.

A fourth switching transistor M4 may be connected between a fourth node N4, which is a first electrode of the light-emitting element ED, and a fourth power line PL4 that provides a second initialization voltage VAR. A gate electrode of the fourth switching transistor M4 may be connected to a third scan line SL3. When a third scan signal SCAN3 is supplied to the third scan line SL3, the fourth switching transistor M4 may be turned on and supply the second initialization voltage VAR to the fourth node N4 that is the first electrode of the light-emitting element ED. In this case, a parasitic capacitor of the light-emitting element ED may be discharged. Therefore, inadvertent micro-light emission may be suppressed, such that a black representation ability of the pixel PX may be improved.

Meanwhile, as an example, a voltage level of the first initialization voltage Vini and a voltage level of the second initialization voltage VAR may be different voltage levels, without being limited thereto. As an example, a voltage for initializing the first node N1 and a voltage for initializing the fourth node N4 may be differently set, without being limited thereto.

In case that the first initialization voltage Vini supplied to the first node N1 is excessively low in a low-frequency operation in which a length of one frame period increases, an intensive on-bias may be applied to the driving transistor DT, a threshold voltage of the driving transistor DT in the corresponding frame period may be shifted. This hysteresis characteristics may cause a flicker phenomenon during the low-frequency operation. Therefore, in a low-frequency operation, the display device 100 may require the first initialization voltage Vini higher than the low-potential power voltage VSS.

However, in case that the voltage level of the second initialization voltage VAR, which is supplied to the fourth node N4 to initialize the light-emitting element ED, becomes higher than a predetermined reference level, the voltage of the parasitic capacitor of the light-emitting element ED is not discharged, but the parasitic capacitor may be charged with the voltage. Therefore, the voltage level of the second initialization voltage VAR needs to be sufficiently low to the extent that the voltage of the parasitic capacitor of the light-emitting element ED may be discharged. For example, in consideration of the threshold voltage of the light-emitting element ED, the voltage level of the second initialization voltage VAR may be set so that the voltage level of the second initialization voltage VAR is lower than a sum of the threshold voltage of the light-emitting element ED and the low-potential power voltage VSS.

However, this is provided for illustrative purposes only. The voltage level of the first initialization voltage Vini and the voltage level of the second initialization voltage VAR may be variously set. For example, the voltage level of the first initialization voltage Vini and the voltage level of the second initialization voltage VAR may be substantially equal to each other.

A fifth switching transistor M5 may be connected between the first power line PL1 and the second node N2. A gate electrode of the fifth switching transistor M5 may be connected to a light emission control line EL. When a light emission control signal EM is supplied to the light emission control line EL, the fifth switching transistor M5 may be turned off. The fifth switching transistor M5 may be turned on in the other case. When the fifth switching transistor M5 is turned on, the second node N2 may be electrically connected to the first power line PL1.

A sixth switching transistor M6 may be connected between the drain electrode of the driving transistor DT, e.g., the third node N3 and the first electrode of the light-emitting element ED, e.g., the fourth node N4. A gate electrode of the sixth switching transistor M6 may be connected to the light emission control line EL. The sixth switching transistor M6 may be controlled in substantially the same way as the fifth switching transistor M5. When the sixth switching transistor M6 is turned on, the third node N3 and the fourth node N4 may be electrically connected.

A seventh switching transistor M7 may be connected between the second node N2 and a fifth power line PL5 which provides a bias voltage Vobs. A gate electrode of the seventh switching transistor M7 may be connected to the third scan line SL3. When the third scan signal SCAN3 is supplied to the third scan line SL3, the seventh switching transistor M7 may be turned on and supply the bias voltage Vobs to the second node N2 that is a source electrode of the driving transistor DT.

In the exemplary embodiment, the bias voltage Vobs may have a level similar to a voltage level of the data signal Vdata with a black gradation. For example, the bias voltage Vobs may have a voltage level of about 5 to 7 V. However, this is provided for illustrative purposes only. The voltage level of the bias voltage Vobs is not limited thereto.

Therefore, as the seventh switching transistor M7 is turned on, a predetermined high voltage may be applied to the source electrode of the driving transistor DT. In this case, when the second switching transistor M2 is in a turned-off state, the driving transistor DT may be in an on-bias state.

In this case, as the bias voltage Vobs is periodically supplied to the second node N2, the bias state of the driving transistor DT may be periodically changed, and the threshold voltage characteristics of the driving transistor DT may be changed. Therefore, it is possible to suppress a situation in which the characteristics of the driving transistor DT are fixed in a particular state and degraded in the low-frequency operation.

The storage capacitor Cst may be connected between the first power line PL1 and the first node N1. One electrode of the storage capacitor Cst is connected to the first power line PL1, such that the high-potential power voltage VDD, which is a constant voltage, may be consistently supplied to one electrode of the storage capacitor Cst. Therefore, the voltage of the first node N1 may be maintained at a voltage level of a voltage supplied to the first node N1 without being affected by other parasitic capacitors. As an example, the storage capacitor Cst may store the voltage applied to the first node N1.

Meanwhile, the driving transistor DT, the first switching transistor M1, the fourth switching transistor M4, the fifth switching transistor M5, the sixth switching transistor M6, and the seventh switching transistor M7 may each be configured as a polysilicon semiconductor transistor, e.g., a PMOS transistor, and the second switching transistor M2 and the third switching transistor M3 may each be configured as an oxide semiconductor transistor, e.g., an NMOS transistor. However, the present specification is not limited thereto. As an example, the driving transistor DT, the first switching transistor M1, the second switching transistor M2, the third switching transistor M3, the fourth switching transistor M4, the fifth switching transistor M5, the sixth switching transistor M6, and the seventh switching transistor M7 may be configured as an NMOS transistor or a PMOS transistor. As an example, the driving transistor DT, the first switching transistor M1, the second switching transistor M2, the third switching transistor M3, the fourth switching transistor M4, the fifth switching transistor M5, the sixth switching transistor M6, and the seventh switching transistor M7 may be configured as a polysilicon semiconductor transistor, an oxide semiconductor transistor, an amorphous silicon semiconductor transistor, a monocrystalline silicon semiconductor transistor, a compound semiconductor transistor, an organic semiconductor transistor, etc., without being limited thereto.

The first electrode, e.g., an anode electrode of the light-emitting element ED may be connected to the fourth node N4, and the second electrode, e.g., a cathode electrode of the light-emitting element ED may be connected to the second power line PL2 that provides the low-potential power voltage VSS. The light-emitting element ED may generate light with predetermined luminance in response to the drive current supplied from the driving transistor DT.

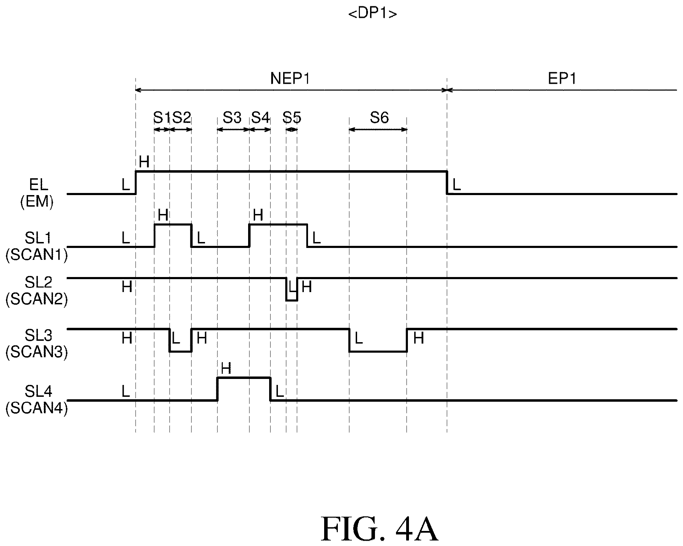

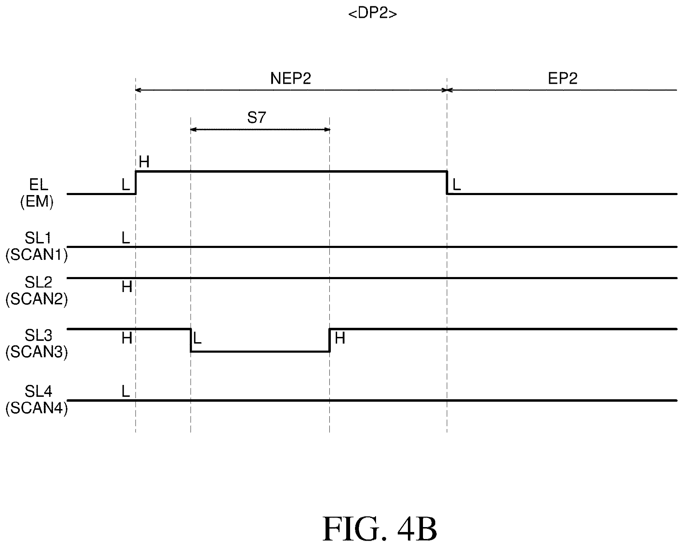

FIGS. 4A and 4B are waveform diagrams for explaining an example of an operation of the pixel in FIG. 3.

For example, FIG. 4A illustrates an example of signals supplied to the pixel PX for a first display period DP1, and FIG. 4B illustrates an example of signals supplied to the pixel PX for a second display period DP2.

With reference to FIGS. 3, 4A, and 4B, the pixel PX may operate for the first display period DP1 and the second display period DP2.

In a variable frequency operation of controlling a frame frequency, one frame period may include the first display period DP1. In addition, the second display period DP2 may be performed at least once in accordance with the frame frequency. For example, during one frame period, the display device 100 may operate for the first display period DP1, and then the display device 100 may operate for the second display period DP2. Although it is illustrated that the pixel PX may operate for two display periods, embodiments are not limited thereto. As an example, the pixel PX may operate for three or more different display periods, without being limited thereto.

The first display period DP1 may include a first non-light emission period NEP1 and a first light emission period EP1. The second display period DP2 may include a second non-light emission period NEP2 and a second light emission period EP2. For example, the first non-light emission period NEP1 and the second non-light emission period NEP2 may refer to periods for which a path of the drive current, which flows from the first power line PL1 to the second power line PL2 via the light-emitting element ED, is blocked. The first light emission period EP1 and the second light emission period EP2 may refer to periods for which the path of the drive current is formed and the light-emitting element ED emits light on the basis of the drive current.

The first display period DP1 may include a period for which the data signal Vdata corresponding to the display image is written into the pixel PX. For example, the data signal Vdata is written for the first non-light emission period NEP1 of the first display period DP1.

For the second display period DP2, the data signal Vdata is not supplied, and the third scan signal SCAN3 may be supplied to the third scan line SL3 to control the driving transistor DT of the pixel PX in the on-bias state and initialize the light-emitting element ED.

As illustrated in FIGS. 4A and 4B, the first non-light emission period NEP1 may include first to sixth operation periods S1, S2, S3, S4, S5, and S6, and the second non-light emission period NEP2 may include a seventh operation period S7.

In the exemplary embodiment, the first scan signal SCAN1, the second scan signal SCAN2, and the fourth scan signal SCAN4 may be supplied only for the first non-light emission period NEP1. Meanwhile, the first scan signal SCAN1 may be supplied multiple times for the first non-light emission period NEP1.

In the exemplary embodiment, the third scan signal SCAN3 may be supplied for the first non-light emission period NEP1 and the second non-light emission period NEP2. In addition, as illustrated in FIGS. 4A and 4B, the third scan signal SCAN3 may be supplied multiple times for the first non-light emission period NEP1 and supplied once for the second non-light emission period NEP2. However, the embodiment of the present specification is not limited thereto. For example, the third scan signal SCAN3 may also be supplied multiple times for the second non-light emission period NEP2.

Meanwhile, the first scan signal SCAN1, the second scan signal SCAN2, the third scan signal SCAN3, and the fourth scan signal SCAN4 may be supplied from at least one scan driver included in the gate driver 120, and the light emission control signal EM may be supplied from at least one light emission driver included in the gate driver 120.

The light emission control signal EM may be maintained at a gate-off level, e..g., a high level H for the first non-light emission period NEP1 and the second non-light emission period NEP2. Therefore, the fifth switching transistor M5 and the sixth switching transistor M6 are each maintained in the turned-off state for the first non-light emission period NEP1 and the second non-light emission period NEP2, such that a path of the drive current, which flows from the first power line PL1 to the second power line PL2 via the light-emitting element ED, may be blocked.

First, the first display period DP1 will be described with reference to FIGS. 3 and 4A. The first scan signal SCAN1 is supplied to the first scan line SL1 for the first operation period S1, such that the second switching transistor M2 may be turned on. Therefore, the gate electrode and the drain electrode of the driving transistor DT may be diode-connected.

Thereafter, for the second operation period S2, the first scan signal SCAN1 may be supplied to the first scan line SL1, and the third scan signal SCAN3 may be supplied to the third scan line SL3. For example, the supply of the first scan signal SCAN1 supplied from the first operation period S1 may be maintained for the second operation period S2. As an example, for the first operation period S1 and the second operation period S2, the second switching transistor M2 may be turned on, and then the fourth switching transistor M4 and the seventh switching transistor M7 may be turned on.

Therefore, when the seventh switching transistor M7 is turned on in the state in which the gate electrode and the drain electrode of the driving transistor DT are connected, the bias voltage Vobs may be transmitted to the first node N1 through the second node N2. For example, a difference in voltage between the second node N2 and the first node N1 may be reduced to a threshold voltage level of the driving transistor DT. Therefore, a magnitude of the gate-source voltage of the driving transistor DT may be significantly decreased for the second operation period S2. For example, the driving transistor DT may be set to an off-bias state. Therefore, in order to suppress an inadvertent increase in luminance caused by the supply of the bias voltage Vobs before the data signal is written for the second operation period S2, the supply of the first scan signal SCAN1 and the third scan signal SCAN3 may be controlled so that the seventh switching transistor M7 is turned on in the state in which the second switching transistor M2 is turned on.

In addition, the fourth switching transistor M4 may be turned on by the third scan signal SCAN3 supplied for the second operation period S2. Therefore, the second initialization voltage VAR may be supplied to the first electrode of the light-emitting element ED, e.g., the fourth node N4. Therefore, the first electrode of the light-emitting element ED is initialized on the basis of the voltage level of the second initialization voltage VAR, such that the parasitic capacitor of the light-emitting element ED may be discharged. Therefore, the black representation ability of the pixel PX may be improved.

Thereafter, the fourth scan signal SCAN4 is supplied to the fourth scan line SL4 for the third operation period S3, such that the third switching transistor M3 may be turned on. When the third switching transistor M3 is turned on, the first initialization voltage Vini may be supplied to the gate electrode of the driving transistor DT. Therefore, the gate voltage of the driving transistor DT may be initialized on the basis of the first initialization voltage Vini. Therefore, a strong on-bias may be applied to the driving transistor DT, and the hysteresis characteristics may change. For example, the threshold voltage may be shifted.

Meanwhile, the supply of the fourth scan signal SCAN4 may be maintained even after the third operation period S3. For example, as illustrated in FIG. 4A, the fourth scan signal SCAN4 may be maintained at a gate-on level, e.g., the high level H for the fourth operation period S4 after the third operation period S3.

Thereafter, the first scan signal SCAN1 is supplied to the first scan line SL1 for the fourth operation period S4, such that the second switching transistor M2 may be turned on again.

Thereafter, the fifth operation period S5 overlaps at least a part of a period for which the first scan signal SCAN1 is supplied, such that the second scan signal SCAN2 may be supplied to the second scan line SL2. Therefore, the first switching transistor M1 may be turned on by the second scan signal SCAN2, and the data signal Vdata may be provided to the second node N2.

In this case, the driving transistor DT is connected in the form of a diode by the turned-on second switching transistor M2, such that an operation of writing the data signal and an operation of compensating for the threshold voltage may be performed together. Meanwhile, because the first scan signal SCAN1 is supplied even before the second scan signal SCAN2 is supplied and even after the supply of the second scan signal SCAN2 is cut off, the threshold voltage of the driving transistor DT may be compensated for a sufficient period of time.

Thereafter, the third scan signal SCAN3 is supplied to the third scan line SL3 again for the sixth operation period S6, such that the fourth switching transistor M4 and the seventh switching transistor M7 may be turned on. The bias voltage Vobs may be supplied to the first node N1 as the seventh switching transistor M7 is turned on.

Meanwhile, the influence of the strong on-bias applied to the third operation period S3 may be removed by the operation of writing the data signal Vdata and the operation of compensating for the threshold voltage. For example, because the threshold voltage is compensated in an interval for supplying the first scan signal SCAN1 including the fourth operation period S4 and the fifth operation period S5, a voltage difference between the gate voltage and the source voltage of the driving transistor DT may be significantly reduced. Then, the characteristics of the driving transistor DT may change again, and the drive current for the first light emission period EP1 may increase, or the separation of the black gradation may be visually recognized.

In order to suppress the change in characteristics, the seventh switching transistor M7 may be turned on by the supply of the third scan signal SCAN3 for the sixth operation period S6. Therefore, the bias voltage Vobs is supplied to the first electrode, e.g., the source electrode of the driving transistor DT for the sixth operation period S6, such that the driving transistor DT may be set to the on-bias state.

In addition, the second initialization voltage VAR may be supplied to the first electrode of the light-emitting element ED by the fourth switching transistor M4 turned on for the sixth operation period S6. Therefore, the first electrode of the light-emitting element ED may be initialized on the basis of the voltage level of the second initialization voltage VAR.

After the sixth operation period S6, the supply of the light emission control signal EM to the light emission control line EL is cut off, e.g., the light emission control signal EM transitions to a low level L, such that the first non-light emission period NEP1 may end, and the first light emission period EP1 may be performed. In this case, the fifth switching transistor M5 and the sixth switching transistor M6 may be turned on.

The drive current, which corresponds to the data signal Vdata written for the fifth operation period S5, may be supplied to the light-emitting element ED for the first light emission period EP1, and the light-emitting element ED may emit light on the basis of the drive current.

Next, the second display period DP2 will be described with reference to FIGS. 3 and 4B. The second display period DP2 may include the second non-light emission period NEP2 and the second light emission period EP2, and the second non-light emission period NEP2 may include the seventh operation period S7.

In the exemplary embodiment, a waveform of the light emission control signal EM for the second display period DP2 may be substantially identical to a waveform of the light emission control signal EM for the first display period DP1.

In the exemplary embodiment, the first scan signal SCAN1, the second scan signal SCAN2, and the fourth scan signal SCAN4 may not be supplied for the second display period DP2. For example, for the second display period DP2, the first scan signal SCAN1 and the fourth scan signal SCAN4 may be maintained at the gate-off level, e.g., the low level L, and the second scan signal SCAN2 may be maintained at the gate-off level, e.g., the high level H. Therefore, the first switching transistor M1, the second switching transistor M2, and the third switching transistor M3 may be maintained in the turned-off state for the second display period DP2.

The third scan signal SCAN3 is supplied for the seventh operation period S7 for the second non-light emission period NEP2, such that the fourth switching transistor M4 and the seventh switching transistor M7 may be turned on. Therefore, the second initialization voltage VAR may be supplied to the first electrode of the light-emitting element ED by the turned-on fourth switching transistor M4, such that the first electrode of the light-emitting element ED may be initialized on the basis of the second initialization voltage VAR. The bias voltage Vobs may be supplied to the source electrode of the driving transistor DT, e.g., the second node N2 by the turned-on seventh switching transistor M7.

After the seventh operation period S7, the supply of the light emission control signal EM to the light emission control line EL is cut off, e.g., the light emission control signal EM transitions to the low level L, such that the second non-light emission period NEP2 may end, and the second light emission period EP2 may be performed. In this case, the fifth switching transistor M5 and the sixth switching transistor M6 may be turned on.

The drive current, which corresponds to the data signal Vdata written for the first display period DP1, may be supplied to the light-emitting element ED for the second light emission period EP2, and the light-emitting element ED may emit light on the basis of the drive current.

Meanwhile, the configuration in which the third scan signal SCAN3 is supplied to the third scan line SL3 once has been described with reference to FIG. 4B. However, the embodiment of the present specification is not limited thereto. For example, the third scan signal SCAN3 may be supplied multiple times for the second non-light emission period NEP2.

FIG. 5 is a block diagram illustrating the gate driver according to the exemplary embodiment of the present specification.

Meanwhile, FIG. 5 illustrates the display panel 140, which has been described with reference to FIG. 1 together with the gate driver 120, and the pixel PX disposed on the display panel 140.

With reference to FIGS. 1 to 5, the gate driver 120 may include a first scan driver SDV1, a second scan driver SDV2, a third scan driver SDV3, a fourth scan driver SDV4, and a light emission driver EDV.

The gate control signal GCS, which is provided to the gate driver 120 from the timing controller 110, may include a first scan start signal SVST1, a second scan start signal SVST2, a third scan start signal SVST3, a fourth scan start signal SVST4, and a light emission start signal EVST. The first scan start signal SVST1, the second scan start signal SVST2, the third scan start signal SVST3, the fourth scan start signal SVST4, and the light emission start signal EVST may be respectively supplied to the first scan driver SDV1, the second scan driver SDV2, the third scan driver SDV3, the fourth scan driver SDV4, and the light emission driver EDV.

Widths, supply timings, and the like of the first scan start signal SVST1, the second scan start signal SVST2, the third scan start signal SVST3, the fourth scan start signal SVST4, and the light emission start signal EVST may be determined depending on the operation condition and the frame frequency of the pixel PX. For example, the first scan signal SCAN1, the second scan signal SCAN2, the third scan signal SCAN3, the fourth scan signal SCAN4, and the light emission control signal EM may be outputted on the basis of the first scan start signal SVST1, the second scan start signal SVST2, the third scan start signal SVST3, the fourth scan start signal SVST4, and the light emission start signal EVST.

The first scan driver SDV1 may supply the first scan signal SCAN1 sequentially to a plurality of first scan lines SL11 to SL1n in response to the first scan start signal SVST1 (here, n is an integer larger than 0). For example, the first scan driver SDV1 may include a plurality of scan stages (e.g., denoted by "SST11 to SST1n" in FIG. 5) configured to output the first scan signal SCAN1 sequentially to the plurality of first scan lines SL11 to SL1n in the unit of the pixel row. Embodiments are not limited thereto. As an example, the first scan signal SCAN1 may be sequentially output to the plurality of first scan lines SL11 to SL1n in the unit of multiple pixel rows. As an example, the first scan signal SCAN1 may be output to the plurality of first scan lines SL11 to SL1n in an order other than a sequential order, without being limited thereto.

The second scan driver SDV2 may supply the second scan signal SCAN2 sequentially to a plurality of second scan lines SL21 to SL2n in response to the second scan start signal SVST2. For example, the second scan driver SDV2 may include a plurality of scan stages (e.g., denoted by "SST21 to SST2n" in FIG. 5) configured to output the second scan signal SCAN2 sequentially to the plurality of second scan lines SL21 to SL2n in the unit of the pixel row, without being limited thereto.

The third scan driver SDV3 may supply the third scan signal SCAN3 sequentially to a plurality of third scan lines SL31 to SL3n in response to the third scan start signal SVST3. For example, the third scan driver SDV3 may include a plurality of scan stages (e.g., denoted by "SST31 to SST3n" in FIG. 5) configured to output the third scan signal SCAN3 sequentially to the plurality of third scan lines SL31 to SL3n in the unit of the pixel row, without being limited thereto.

The fourth scan driver SDV4 may supply the fourth scan signal SCAN4 sequentially to a plurality of fourth scan lines SL41 to SL4n in response to the fourth scan start signal SVST4. For example, the fourth scan driver SDV4 may include a plurality of scan stages (e.g., denoted by "SST41 to SST4n" in FIG. 5) configured to output the fourth scan signal SCAN4 sequentially to the plurality of fourth scan lines SL41 to SL4n in the unit of the pixel row, without being limited thereto.

The light emission driver EDV may supply the light emission control signal EM sequentially to a plurality of light emission control lines EL1 to ELn in response to the light emission start signal EVST. For example, the light emission driver EDV may include a plurality of light emission stages EST1 to ESTn configured to output the light emission control signal EM sequentially to the plurality of light emission control lines EL1 to ELn in the unit of the pixel row, without being limited thereto.

Meanwhile, as described above, the display device 100 according to the exemplary embodiment of the present specification may display images with various driving frequencies depending on the operation conditions. For example, the display device 100 may control the driving frequency of the display panel 140 by adjusting the number of times of the second display period DP2 described with reference to FIGS. 3 to 4B. For example, for the second display period DP2, the third scan driver SDV3 may supply the third scan signal SCAN3 sequentially to the plurality of third scan lines SL31 to SL3n, and the light emission driver EDV may supply the light emission control signal EM sequentially to the plurality of light emission control lines EL1 to ELn. Meanwhile, for the second display period DP2, the first scan driver SDV1, the second scan driver SDV2, and the fourth scan driver SDV4 may not supply the first scan signal SCAN1, the second scan signal SCAN2, and the fourth scan signal SCAN4. As an example, the first scan signal SCAN1, the second scan signal SCAN2, and the fourth scan signal SCAN4 may each be maintained at the gate-off level for the second display period DP2.

In addition, as described with reference to FIGS. 1 to 2B, in the exemplary embodiment, the plurality of sub-display areas included in the display area AA of the display device 100 may independently operate the driving frequency. For example, in case that the first sub-display area AA1 and the third sub-display area AA3 operate at a low frequency and the second sub-display area AA2 operates at a high frequency in the display panel 140 in FIG. 2B, the number of times the pixel PX disposed in the first sub-display area AA1 and the pixel PX disposed in the third sub-display area AA3 operate for the second display period DP2 for one frame period may be larger than the number of times the pixel PX disposed in the second sub-display area AA2 operates for the second display period DP2. As an example, in case that the first sub-display area AA1 and the third sub-display area AA3 operate at a low frequency and the second sub-display area AA2 operates at a high frequency in the display panel 140 in FIG. 2B, the display device 100 may perform the low-frequency operation by increasing the number of times the pixel PX operates for the second display period DP2 in the first sub-display area AA1 and the third sub-display area AA3.

Meanwhile, a general gate driver in the related art is implemented in a shift register manner, and a current stage outputs a gate signal in response to a carry signal outputted from a previous stage. In order to control a driving frequency of a pixel disposed on a display panel, a display device in the related art may output a start signal for generating the corresponding scan signal at a gate-off level and provide the start signal to the gate driver to maintain a signal level of the gate signal, e.g., the first scan signal SCAN1, the second scan signal SCAN2, and the fourth scan signal SCAN4 for the second display period DP2 as the gate-off level or perform control so that a carry signal of the gate driver is outputted at a gate-off level.

However, as described above, in case that the first sub-display area AA1 and the third sub-display area AA3 operate at a low frequency and the second sub-display area AA2 operates at a high frequency in the display panel 140, the gate driver in the related art implemented in the general shift register manner outputs the carry signal, which is outputted from the stage configured to provide the gate signal (scan signal) to the pixel disposed in the first sub-display area AA1, at the gate-off level. Therefore, the gate signal (scan signal) provided to the pixel disposed in the second sub-display area AA2 is inevitably maintained at the gate-off level. Therefore, the gate driver and the display device including the same in the related art have a limitation in controlling the driving frequency by dividing the display area into areas.

Therefore, the gate driver 120 according to the exemplary embodiment of the present specification may further include an output controller SCTR configured to control signal levels of the gate signals outputted from at least one scan driver, e.g., the first scan signal SCAN1, the second scan signal SCAN2, and the fourth scan signal SCAN4 outputted from the first scan driver SDV1, the second scan driver SDV2, and the fourth scan driver SDV4, without being limited thereto.

In the exemplary embodiment, the output controller SCTR may control the output of the gate signal (scan signal) outputted from each of the first scan driver SDV1, the second scan driver SDV2, and the fourth scan driver SDV4 in the variable frequency operation of controlling the frame frequency. For example, the output controller SCTR may be connected in common to the first scan driver SDV1, the second scan driver SDV2, and the fourth scan driver SDV4 and control the first scan driver SDV1, the second scan driver SDV2, and the fourth scan driver SDV4. Embodiments are not limited thereto. As an example, the output controller SCTR may be separately connected to any one or more of the first scan driver SDV1, the second scan driver SDV2, and the fourth scan driver SDV4. As an example, the output controller SCTR may be further connected to the light emission driver EDV or the third scan driver SDV3, without being limited thereto.

For example, the output controller SCTR may perform control such that the first scan signal SCAN1, the second scan signal SCAN2, and the fourth scan signal SCAN4 each have a pulse at the gate-on level in case that the pixel PX operates for the first display period DP1. The output controller SCTR may perform control such that the first scan signal SCAN1, the second scan signal SCAN2, and the fourth scan signal SCAN4 each have the gate-off level in case that the pixel PX operates for the second display period DP2.

Therefore, the gate driver 120 and the display device 100 including the same according to the exemplary embodiment of the present specification may control the driving frequency by dividing the display area AA into areas.

In addition, the gate driver 120 and the display device 100 including the same according to the exemplary embodiment of the present specification control the signal levels of the gate signals (scan signals) by using the output controller SCTR connected in common to the first scan driver SDV1, the second scan driver SDV2, and the fourth scan driver SDV4 without including a separate controller for controlling the signal levels of the gate signals (scan signals) outputted from the first scan driver SDV1, the second scan driver SDV2, and the fourth scan driver SDV4, thereby reducing or minimizing a size of a bezel area in which the gate driver 120 is disposed.

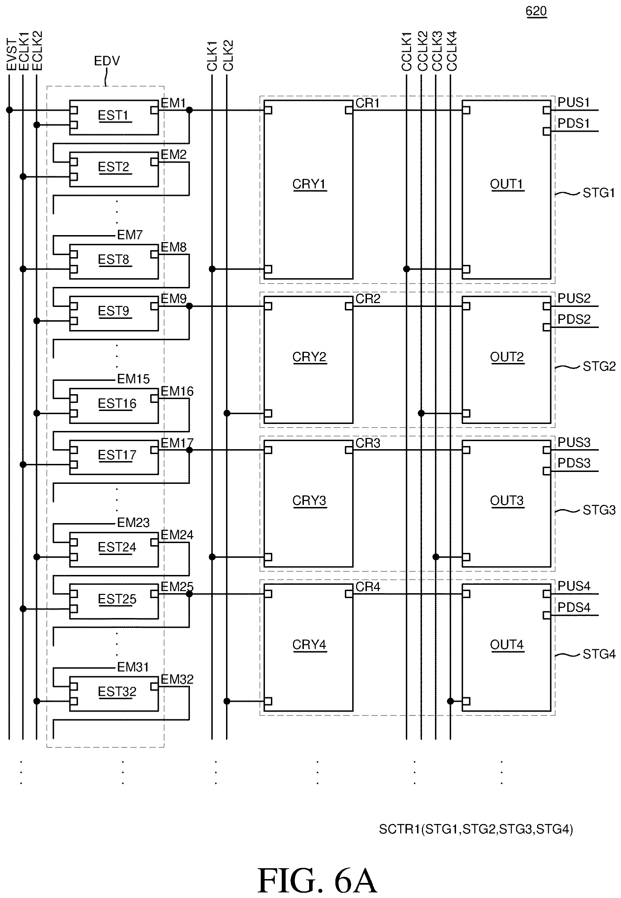

The output controller SCTR will be described specifically below with reference to FIGS. 6A to 23.

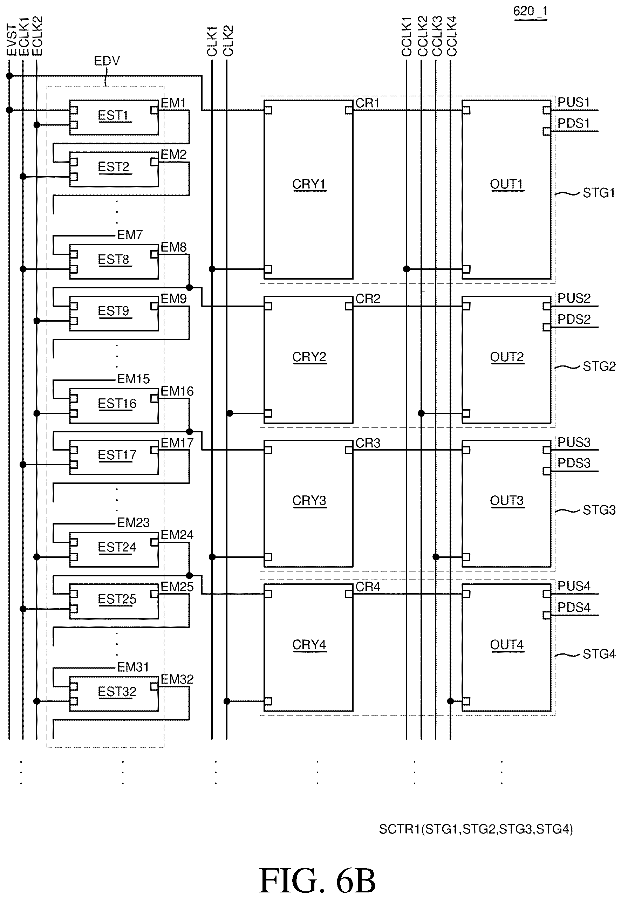

FIGS. 6A and 6B are block diagrams illustrating an example of the gate driver in FIG. 5.

Meanwhile, FIGS. 6A and 6B illustrate only the light emission driver EDV and an output controller SCTR1 related to various components included in gate drivers 620 and 620_1.

Meanwhile, for convenience of description, FIGS. 6A and 6B illustrate thirty-two stages EST1 to EST32 among the plurality of light emission stages included in the light emission driver EDV, a plurality of light emission control signals EM1 to EM32 outputted from the thirty-two stages EST1 to EST32, four stages STG1 to STG4 among the plurality of stages included in the output controller SCTR1, and a plurality of pull-up control signals PUS1 to PUS4 and a plurality of pull-down control signals PDS1 to PDS4 outputted from the four stages STG1 to STG4.

With reference to FIG. 6A, the gate driver 620 according to the exemplary embodiment of the present specification may include the light emission driver EDV and the output controller SCTR1.

The light emission driver EDV may include the plurality of light emission stages EST1 to EST32. The plurality of light emission stages EST1 to EST32 may each be connected to the corresponding light emission control signal and output the light emission control signals EM1 to EM32 on the basis of a first light emission clock signal ECLK1 and a second light emission clock signal ECLK2.

In the exemplary embodiment, the plurality of light emission stages EST1 to EST32 included in the light emission driver EDV may be cascaded, and the plurality of light emission stages EST1 to EST32 may have substantially the same configuration.

The plurality of light emission stages EST1 to EST32 may receive the light emission start signal EVST or a carry signal of the previous light emission stage, e.g., the light emission control signals EM1 to EM32 of the previous light emission stage.

The plurality of light emission stages EST1 to EST32 may each receive any one of the first light emission clock signal ECLK1 and the second light emission clock signal ECLK2. For example, the even-numbered light emission stage may receive the first light emission clock signal ECLK1, and the odd-numbered light emission stage may receive the second light emission clock signal ECLK2. However, the present specification is not limited thereto.

The first light emission clock signal ECLK1 and the second light emission clock signal ECLK2 may have waveforms having the same cycle and having phases that do not overlap each other, without being limited thereto. For example, the second light emission clock signal ECLK2 may be set as a signal shifted by about 1/2 cycle from the first light emission clock signal ECLK1, without being limited thereto.

The light emission control signals EM1 to EM32 may be outputted through output terminals of the plurality of light emission stages EST1 to EST32 and provided to the next light emission stages. In addition, the light emission control signals of at least some of the plurality of light emission control signals EM1 to EM32 outputted from the plurality of light emission stages EST1 to EST32 may be provided to the output controller SCTR1. A more detailed description related to the output controller SCTR1 will be described below.

The output controller SCTR1 may include the plurality of stages STG1 to STG4. The plurality of stages STG1 to STG4 may output the plurality of pull-up control signals PUS1 to PUS4 and the plurality of pull-down control signals PDS1 to PDS4 on the basis of a plurality of clock signals CLK1 and CLK2 and a plurality of control clock signals CCLK1, CCLK2, CCLK3, and CCLK4.

In the exemplary embodiment, the plurality of stages STG1 to STG4 included in the output controller SCTR1 may be cascaded.

For example, a second stage STG2 may be cascaded to a first stage STG1, a third stage STG3 may be cascaded to the second stage STG2, and a fourth stage STG4 may be cascaded to the third stage STG3. In this case, the plurality of stages STG1 to STG4 may have substantially the same configuration.

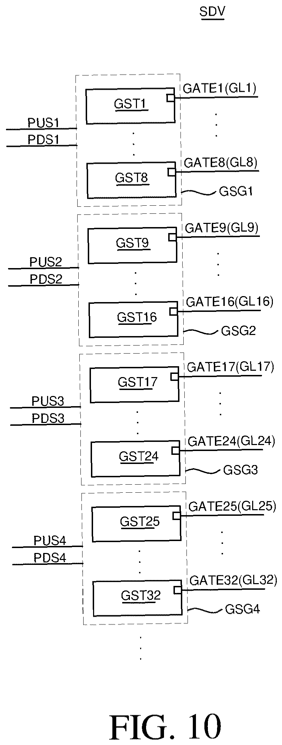

In the exemplary embodiment, the plurality of stages STG1 to STG4 included in the output controller SCTR1 may be formed in the unit of at least two or more horizontal lines instead of being formed in the unit of the horizontal line, e.g., the pixel row. For example, as illustrated in FIG. 6A, the plurality of stages STG1 to STG4 may be formed in the unit of eight horizontal lines. Therefore, in the exemplary embodiment in FIG. 6A, the plurality of stages STG1 to STG4 included in the output controller SCTR1 may control in common the eight scan stages formed in the unit of eight horizontal lines among the plurality of scan stages included in the scan driver. This will be described more specifically with reference to FIGS. 10 to 14.

The plurality of stages STG1 to STG4 may each include a carry part configured to output the carry signal, and an output part configured to output the pull-up control signal and the pull-down control signal. For example, the first stage STG1 may include a first carry part CRY1 configured to generate a first carry signal CR1, and a first output part OUT1 configured to generate a first pull-up control signal PUS1 and a first pull-down control signal PDS1, the second stage STG2 may include a second carry part CRY2 configured to generate a second carry signal CR2, and a second output part OUT2 configured to generate a second pull-up control signal PUS2 and a second pull-down control signal PDS2, the third stage STG3 may include a third carry part CRY3 configured to generate a third carry signal CR3, and a third output part OUT3 configured to generate a third pull-up control signal PUS3 and a third pull-down control signal PDS3, and the fourth stage STG4 may include a fourth carry part CRY4 configured to generate a fourth carry signal CR4, and a fourth output part OUT4 configured to generate a fourth pull-up control signal PUS4 and a fourth pull-down control signal PDS4.

The plurality of carry parts CRY1 to CRY4 included in the plurality of stages STG1 to STG4 may each receive the light emission control signal from the light emission driver EDV.

In the exemplary embodiment, a k-th (here, k is an integer larger than 0) stage may receive a light emission control signal outputted from a (8k-7)th light emission stage. For example, the first carry part CRY1 included in the first stage STG1 may receive a first light emission control signal EM1 outputted from a first light emission stage EST1, the second carry part CRY2 included in the second stage STG2 may receive a ninth light emission control signal EM9 outputted from a ninth light emission stage EST9, the third carry part CRY3 included in the third stage STG3 may receive a seventeenth light emission control signal EM17 outputted from a seventeenth light emission stage EST17, and the fourth carry part CRY4 included in the fourth stage STG4 may receive a twenty-fifth light emission control signal EM25 outputted from a twenty-fifth light emission stage EST25. Because the plurality of stages STG1 to STG4 control in common the eight scan stages formed in the unit of eight horizontal lines as described above, the plurality of carry parts CRY1 to CRY4 respectively included in the plurality of stages STG1 to STG4 may receive the light emission control signal from one light emission stage among the eight light emission stages formed in the unit of eight horizontal lines. Embodiments are not limited thereto. As an example, the plurality of carry parts CRY1 to CRY4 respectively included in the plurality of stages STG1 to STG4 may receive the light emission control signal from any one light emission stage among the eight light emission stages formed in the unit of eight horizontal lines, other than the (8k-7)th light emission stage. As an example, the k-th stage may receive a light emission control signal outputted from any one of a (8k-7)th to 8k th light emission stage, without being limited thereto.

In addition, the plurality of carry parts CRY1 to CRY4 may be provided with a plurality of clock signals, e.g., any one of a first clock signal CLK1 and a second clock signal CLK2.

In the exemplary embodiment, the carry part included in the odd-numbered stage may receive the first clock signal CLK1, and the carry part included in the even-numbered stage may receive the second clock signal CLK2. For example, the first carry part CRY1 and the third carry part CRY3 may each receive the first clock signal CLK1, and the second carry part CRY2 and the fourth carry part CRY4 may each receive the second clock signal CLK2. But the present disclosure is not limited thereto.

The first clock signal CLK1 and the second clock signal CLK2 may have waveforms having the same cycle and having phases that do not overlap each other. For example, the second clock signal CLK2 may be set as a signal shifted by about 1/2 cycle from the first clock signal CLK1.

The plurality of carry parts CRY1 to CRY4 may output the carry signals CR1 to CR4 through the output terminals. In addition, the plurality of carry signals CR1 to CR4 outputted from the plurality of carry parts CRY1 to CRY4 respectively included in the plurality of stages STG1 to STG4 may be provided to the output parts OUT1 to OUT4 of the corresponding stages.

For example, the first carry signal CR1 outputted from the first carry part CRY1 of the first stage STG1 may be provided to the first output part OUT1, the second carry signal CR2 outputted from the second carry part CRY2 of the second stage STG2 may be provided to the second output part OUT2, the third carry signal CR3 outputted from the third carry part CRY3 of the third stage STG3 may be provided to the third output part OUT3, and the fourth carry signal CR4 outputted from the fourth carry part CRY4 of the fourth stage STG4 may be provided to the fourth output part OUT4.

In addition, the plurality of output parts OUT1 to OUT4 may each receive any one of the plurality of control clock signals, e.g., a first control clock signal CCLK1, a second control clock signal CCLK2, a third control clock signal CCLK3, and a fourth control clock signal CCLK4.

In the exemplary embodiment, the output part included in the i-th (here, i is an integer larger than 0) stage may receive the first control clock signal CCLK1, the output part included in the (i+1)th stage may receive the second control clock signal CCLK2, the output part included in the (i+2)th stage may receive the third control clock signal CCLK3, and the output part included in the (i+3)th stage may receive the fourth control clock signal CCLK4.

For example, the first output part OUT1 may receive the first control clock signal CCLK1, the second output part OUT2 may receive the second control clock signal CCLK2, the third output part OUT3 may receive the third control clock signal CCLK3, and the fourth output part OUT4 may receive the fourth control clock signal CCLK4.

The first control clock signal CCLK1 and the second control clock signal CCLK2 may have waveforms having the same cycle and having phases that do not overlap each other. For example, the second control clock signal CCLK2 may be set as a signal shifted by about 1/2 cycle from the first control clock signal CCLK1.

In addition, the third control clock signal CCLK3 and the fourth control clock signal CCLK4 may have waveforms having the same cycle and having phases that do not overlap each other. For example, the fourth control clock signal CCLK4 may be set as a signal shifted by about 1/2 cycle from the third control clock signal CCLK3.

In the exemplary embodiment, the signal level of at least any one of the first control clock signal CCLK1, the second control clock signal CCLK2, the third control clock signal CCLK3, and the fourth control clock signal CCLK4 may be controlled depending on the driving mode. For example, the signal levels of the first control clock signal CCLK1, the second control clock signal CCLK2, the third control clock signal CCLK3, and the fourth control clock signal CCLK4 may be independently controlled.

For example, in case that the pixel PX operates for the first display period DP1 as described above, all the first control clock signal CCLK1, the second control clock signal CCLK2, the third control clock signal CCLK3, and the fourth control clock signal CCLK4 may have the gate-on level, e.g., the low level for the corresponding period. In this case, the plurality of pull-up control signals PUS1 to PUS4 outputted from the plurality of output parts OUT1 to OUT4 may have the gate-on level, e.g., the low level, and the plurality of pull-down control signals PDS1 to PDS4 outputted from the plurality of output parts OUT1 to OUT4 may have the gate-off level, e.g., the high level. Therefore, the scan driver connected to the output controller SCTR1 may output the gate signal (scan signal) having the pulse with the gate-on level for the first display period DP1.

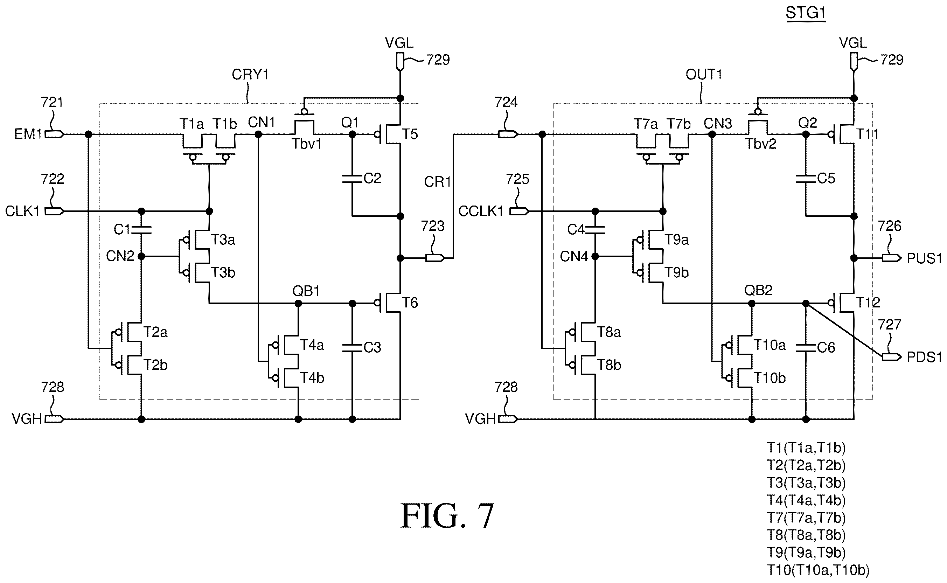

In contrast, in case that the pixel PX operates for the second display period DP2 as described above, at least one of the first control clock signal CCLK1, the second control clock signal CCLK2, the third control clock signal CCLK3, and the fourth control clock signal CCLK4 may toggle between the gate-off level and the gate-on level, e.g., the high level and the low level for the corresponding period. In this case, by the operations of the plurality of output parts OUT1 to OUT4, the pull-up control signals PUS1 to PUS4 may have the pulses with the gate-off level, e.g., the high level in at least a partial interval, and the pull-down control signals PDS1 to PDS4 may have the pulses with the gate-on level, e.g., the low level in at least a partial interval. Therefore, the gate signal (scan signal) outputted from the scan driver connected to the output controller SCTR1 may have the gate-off level for the second display period DP2. A more detailed description thereof will be described below with reference to FIGS. 7 to 14.

In the exemplary embodiment, the first control clock signal CCLK1 and the third control clock signal CCLK3 may have the same waveform, and the second control clock signal CCLK2 and the fourth control clock signal CCLK4 may have the same waveform in a case excluding the case in which the first control clock signal CCLK1, the second control clock signal CCLK2, the third control clock signal CCLK3, and the fourth control clock signal CCLK4 are maintained at the gate-on level, e.g., the low level in response to the first display period DP1 of the pixel PX as described above.

The plurality of output parts OUT1 to OUT4 included in the plurality of stages STG1 to STG4 may output the pull-up control signals PUS1 to PUS4 and the pull-down control signals PDS1 to PDS4.

Meanwhile, although not separately illustrated in FIG. 6A, the plurality of stages STG1 to STG4 may include a plurality of power input terminals, and a power voltage required to operate the plurality of stages STG1 to STG4 may be applied through the plurality of power input terminals.

For example, the plurality of stages STG1 to STG4 may receive a voltage of a first power source (e.g., a first power source VGH in FIG. 7) and a voltage of a second power source (e.g., a second power source VGL in FIG. 7). The voltage of the first power source and the voltage of the second power source may have direct current voltage levels. In this case, a voltage level of the first power source may be set to be higher than a voltage level of the second power source.

Meanwhile, the configuration in which the plurality of carry parts CRY1 to CRY4 included in the plurality of stages STG1 to STG4 each receive the light emission control signal from the light emission driver EDV has been described. However, the embodiment of the present specification is not limited thereto.

For example, with reference to FIG. 6B, at least some of the plurality of carry parts CRY1 to CRY4 respectively included in the plurality of stages STG1 to STG4 of the output controller SCTR1 included in the gate driver 620_1 may receive the light emission start signal EVST, and the remaining carry parts CRY1 to CRY4 may receive the light emission control signal from the light emission driver EDV.

For example, the first carry part CRY1, which is included in the first stage STG1 among the plurality of stages STG1 to STG4 included in the output controller SCTR1, may receive the light emission start signal EVST, and a 1-th (here, l is an integer larger than 1) stage, among the remaining stages excluding the first stage STG1, may receive the light emission control signal outputted from a (8(l-1))th light emission stage. For example, the second carry part CRY2 included in the second stage STG2 may receive an eighth light emission control signal EM8 outputted from an eighth light emission stage EST8, the third carry part CRY3 included in the third stage STG3 may receive a sixteenth light emission control signal EM16 outputted from a sixteenth light emission stage EST16, and the fourth carry part CRY4 included in the fourth stage STG4 may receive a twenty-fourth light emission control signal EM24 outputted from a twenty-fourth light emission stage EST24.

In this case, the first light emission control signal EM1 outputted from the first light emission stage EST1 has the same pulse width as the light emission start signal EVST and has a waveform shifted by one horizontal period. Therefore, in case that the first carry part CRY1 included in the first stage STG1 receives the light emission start signal EVST, as illustrated in FIG. 6B, the remaining stages excluding the first stage STG1 may receive the light emission control signal outputted from the (8(l-1))th light emission stage.

In this case, the gate driver 620_1 in FIG. 6B may operate substantially identically or similarly to the gate driver 620 in FIG. 6A, except that the plurality of carry signals CR1 to CR4 outputted from the plurality of carry parts CRY1 to CRY4 and the plurality of pull-up control signals PUS1 to PUS4 and the plurality of pull-down control signals PDS1 to PDS4 outputted from the plurality of stages STG1 to STG4 are shifted by one horizontal period in accordance with a connection relationship between the plurality of carry parts CRY1 to CRY4 in comparison with the gate driver 620 in FIG. 6A. Therefore, redundant descriptions will not be repeated or briefly given.

With reference back to FIG. 6A, in the exemplary embodiment, the plurality of stages STG1 to STG4 included in the output controller SCTR1 may have substantially the same configuration, except for an inputted signal. For example, the plurality of stages STG1 to STG4 may have substantially the same circuit configuration and operate in substantially the same manner.

Therefore, hereinafter, for convenience of description, in the description of the plurality of stages STG1 to STG4 included in the output controller SCTR1, a configuration of and a method of operating the plurality of stages STG1 to STG4 included in the output controller SCTR1 will be described based on the first stage STG1.

Meanwhile, the transistors, which constitute the stages, may be implemented as transistors having n-type or p-type MOSFET structures. In the following exemplary embodiment, the p-type transistor will be described. However, the embodiment of the present specification is not limited thereto.

FIG. 7 is a circuit diagram illustrating an example of the first stage included in the output controller of the gate driver in FIG. 6A.

With reference to FIGS. 6A and 7, the first stage STG1 may include the first carry part CRY1 configured to output the first carry signal CR1, and the first output part OUT1 configured to output the first pull-up control signal PUS1 and a first pull-down control signal PDS1. More specifically, the first output part OUT1 may output the first pull-up control signal PUS1 having the gate-on level and the first pull-down control signal PDS1 having the gate-off level depending on the driving mode. Alternatively, the first output part OUT1 may output the first pull-up control signal PUS1 having the pulse with the gate-off level and the first pull-down control signal PDS1 having the pulse with the gate-on level in at least a partial interval.

The first carry part CRY1 may receive the first light emission control signal EM1, i.e., an input signal through a first input terminal 721 and receive the first clock signal CLK1 through a second input terminal 722, and the first carry part CRY1 may be connected to the first power source VGH through a first power input terminal 728 and connected to the second power source VGL through a second power input terminal 729. The first carry part CRY1 may generate and output the first carry signal CR1 through a first output terminal 723 on the basis of the first light emission control signal EM1, the first clock signal CLK1, the first power source VGH, and the second power source VGL.

Meanwhile, as described with reference to FIG. 6B, according to the exemplary embodiment, the first carry part CRY1 may receive the light emission start signal EVST, i.e., an input signal through the first input terminal 721.

The first output part OUT1 may receive the first carry signal CR1 through a third input terminal 724, e.g., the third input terminal 724 connected to the first output terminal 723 of the first carry part CRY1 and receive the first control clock signal CCLK1 through a fourth input terminal 725, and the first output part OUT1 may be connected to the first power source VGH through the first power input terminal 728 and connected to the second power source VGL through the second power input terminal 729. On the basis of the first carry signal CR1, the first control clock signal CCLK1, the first power source VGH, and the second power source VGL, the first output part OUT1 may generate and output the first pull-up control signal PUS1 through a second output terminal 726 and generate and output the first pull-down control signal PDS1 through a third output terminal 727.

More specifically, the first carry part CRY1 of the first stage STG1 may include first to sixth transistors T1, T2, T3, T4, T5, and T6, a first capacitor C1, a second capacitor C2, and a third capacitor C3. According to the exemplary embodiment, the first carry part CRY1 may further include a first bridge voltage transistor Tbv1.

The first transistor T1 may be connected between the first input terminal 721 and a first control node CN1 and may include a gate electrode connected to the second input terminal 722. When the first clock signal CLK1 supplied through the second input terminal 722 has the gate-on level, e.g., the low level, the first transistor T1 may be turned on and electrically connect the first input terminal 721 and the first control node CN1. In case that the first transistor T1 is turned on, the first light emission control signal EM1 supplied through the first input terminal 721 may be supplied to the first control node CN1.

In the exemplary embodiment, the first transistor T1 may include first and second sub-transistors T1a and T1b connected to each other in series. The first and second sub-transistors T1a and T1b may each include a gate electrode connected in common to the second input terminal 722. For example, the first transistor T1 may have a dual gate structure. Therefore, a leak of electric current caused by the first transistor T1 may be reduced or minimized.

The second transistor T2 may be connected between the first power input terminal 728 and a second control node CN2 and may include a gate electrode connected to the first input terminal 721. When the first light emission control signal EM1 supplied through the first input terminal 721 has the gate-on level, e.g., the low level, the second transistor T2 may be turned on and provide the second control node CN2 with the voltage of the first power source VGH with the gate-off level, e.g., the high level provided from the first power input terminal 728.

In the exemplary embodiment, the second transistor T2 may include third and fourth sub-transistors T2a and T2b connected to each other in series. The third and fourth sub-transistors T2a and T2b may each include a gate electrode connected in common to the first input terminal 721. For example, the second transistor T2 may have a dual gate structure. Therefore, a leak of electric current caused by the second transistor T2 may be reduced or minimized.

The third transistor T3 may be connected between the second input terminal 722 and a first QB node QB1 and may include a gate electrode connected to the second control node CN2. The third transistor T3 may be turned on or turned off on the basis of a voltage of the second control node CN2. When the third transistor T3 is turned on, the second input terminal 722 and the first QB node QB1 may be electrically connected, such that the first clock signal CLK1 provided to the second input terminal 722 may be provided to the first QB node QB1.

In the exemplary embodiment, the third transistor T3 may include fifth and sixth sub-transistors T3a and T3b connected to each other in series. The fifth and sixth sub-transistors T3a and T3b may include a gate electrode connected in common to the second control node CN2. For example, the third transistor T3 may have a dual gate structure. Therefore, a leak of electric current caused by the third transistor T3 may be reduced or minimized.

The fourth transistor T4 may be connected between the first power input terminal 728 and the first QB node QB1 and may include a gate electrode connected to the first control node CN1. The fourth transistor T4 may be turned on or turned off on the basis of a voltage of the first control node CN1. When the fourth transistor T4 may be turned on, the voltage of the first power source VGH provided through the first power input terminal 728 may be provided to the first QB node QB1.

In the exemplary embodiment, the fourth transistor T4 may include seventh and eighth sub-transistors T4a and T4b connected to each other in series. The seventh and eighth sub-transistors T4a and T4b may include a gate electrode connected in common to the first control node CN1. For example, the fourth transistor T4 may have a dual gate structure. Therefore, a leak of electric current caused by the fourth transistor T4 may be reduced or minimized.

The fifth transistor T5 may be connected between the second power input terminal 729 and the first output terminal 723 and may include a gate electrode connected to a first Q node Q1. For example, the gate electrode of the fifth transistor T5 connected to the first Q node Q1 may be connected to the first control node CN1 via the first bridge voltage transistor Tbv1. The fifth transistor T5 may be turned on or turned off by a voltage of the first Q node Q1.

In this case, the first bridge voltage transistor Tbv1 may be connected between the first control node CN1 and the first Q node Q1 and may include a gate electrode connected to the second power input terminal 729. Because the gate electrode of the first bridge voltage transistor Tbv1 is connected to the second power input terminal 729 through which the voltage of the second power source VGL having the gate-on level, e.g., the low level is supplied, the first bridge voltage transistor Tbv1 may always be kept in a turned-on state. Therefore, the voltage of the first control node CN1 and the voltage of the first Q node Q1 may have substantially the same value. Therefore, the fifth transistor T5 may be turned on or turned off in accordance with a voltage of the first control node CN1.

For example, when the voltage of the first Q node Q1 or the voltage of the first control node CN1 has the gate-on level, e.g., the low level, the fifth transistor T5 may be turned on and electrically connect the second power input terminal 729 and the first output terminal 723. Therefore, the first carry signal CR1 outputted through the first output terminal 723 may have the gate-on level, e.g., the low level in the interval in which the fifth transistor T5 is turned on.

The sixth transistor T6 may be connected between the first power input terminal 728 and the first output terminal 723 and may include a gate electrode connected to the first QB node QB1. The sixth transistor T6 may be turned on or turned off by a voltage of the first QB node QB1.

For example, when the voltage of the first QB node QB1 has the gate-on level, e.g., the low level, the sixth transistor T6 may be turned on and electrically connect the first power input terminal 728 and the first output terminal 723. Therefore, the first carry signal CR1 outputted through the first output terminal 723 may have the gate-off level, e.g., the high level in the interval in which the sixth transistor T6 is turned on.

As described above, the fifth transistor T5 of the first carry part CRY1 may be responsible for performing a pull-up function, and the sixth transistor T6 of the first carry part CRY1 may be responsible for performing a pull-down function.

The first capacitor C1 (or first boosting capacitor) may be connected between the second input terminal 722 and the second control node CN2. For example, the first capacitor C1 may include a first electrode connected to the second input terminal 722, and a second electrode connected to the second control node CN2.

The second capacitor C2 may be connected between the first Q node Q1 and the first output terminal 723. For example, the second capacitor C2 may include a first electrode connected to the first Q node Q1, and a second electrode connected to the first output terminal 723.

The third capacitor C3 may be connected between the first QB node QB1 and the the first power input terminal 728. For example, the third capacitor C3 may include a first electrode connected to the first QB node QB1, and a second electrode connected to the first power input terminal 728.

Next, the first output part OUT1 of the first stage STG1 may be similar in circuit structure to the first carry part CRY1 and different from the first carry part CRY1 only in terms of an inputted signal and an outputted signal. For example, the first output part OUT1 may include seventh to twelfth transistors T7, T8, T9, T10, T11, and T12, a fourth capacitor C4, a fifth capacitor C5, and a sixth capacitor C6. According to the exemplary embodiment, the first output part OUT1 may further include a second bridge voltage transistor Tbv2.

The seventh transistor T7 may be connected between the third input terminal 724 and a third control node CN3 and may include a gate electrode connected to the fourth input terminal 725. When the first control clock signal CCLK1 supplied through the fourth input terminal 725 has the gate-on level, e.g., the low level, the seventh transistor T7 may be turned on and electrically connect the third input terminal 724 and the third control node CN3. In case that the seventh transistor T7 is turned on, the first carry signal CR1 supplied through the third input terminal 724 may be supplied to the third control node CN3.

In the exemplary embodiment, the seventh transistor T7 may include ninth and tenth sub-transistors T7a and T7b connected to each other in series. The ninth and tenth sub-transistors T7a and T7b may each include a gate electrode connected in common to the fourth input terminal 725. For example, the seventh transistor T7 may have a dual gate structure. Therefore, a leak of electric current caused by the seventh transistor T7 may be reduced or minimized.

The eighth transistor T8 may be connected between the first power input terminal 728 and a fourth control node CN4 and may include a gate electrode connected to the third input terminal 724. When the first carry signal CR1 supplied through the third input terminal 724 has the gate-on level, e.g., the low level, the eighth transistor T8 may be turned on and provide the fourth control node CN4 with the voltage of the first power source VGH with the gate-off level, e.g., the high level provided from the first power input terminal 728.

In the exemplary embodiment, the eighth transistor T8 may include eleventh and twelfth sub-transistors T8a and T8b connected to each other in series. The eleventh and twelfth sub-transistors T8a and T8b may each include a gate electrode connected in common to the third input terminal 724. For example, the eighth transistor T8 may have a dual gate structure. Therefore, a leak of electric current caused by the eighth transistor T8 may be reduced or minimized.

The ninth transistor T9 may be connected between the fourth input terminal 725 and a second QB node QB2 and may include a gate electrode connected to the fourth control node CN4. The ninth transistor T9 may be turned on or turned off on the basis of a voltage of the fourth control node CN4. When the ninth transistor T9 is turned on, the fourth input terminal 725 and the second QB node QB2 are electrically connected, such that the first control clock signal CCLK1 provided to the fourth input terminal 725 may be provided to the second QB node QB2.

In the exemplary embodiment, the ninth transistor T9 may include thirteenth and fourteenth sub-transistors T9a and T9b connected to each other in series. The thirteenth and fourteenth sub-transistors T9a and T9b may include a gate electrode connected in common to the fourth control node CN4. For example, the ninth transistor T9 may have a dual gate structure. Therefore, a leak of electric current caused by the ninth transistor T9 may be reduced or minimized.

The tenth transistor T10 may be connected between the first power input terminal 728 and the second QB node QB2 and may include a gate electrode connected to the third control node CN3. The tenth transistor T10 may be turned on or turned off on the basis of a voltage of the third control node CN3. When the tenth transistor T10 is turned on, the voltage of the first power source VGH provided through the first power input terminal 728 may be provided to the second QB node QB2.

In the exemplary embodiment, the tenth transistor T10 may include fifteenth and sixteenth sub-transistors T10a and T10b connected to each other in series. The fifteenth and sixteenth sub-transistors T10a and T10b may each include a gate electrode connected in common to the third control node CN3. For example, the tenth transistor T10 may have a dual gate structure. Therefore, a leak of electric current caused by the tenth transistor T10 may be reduced or minimized.

The eleventh transistor T11 may be connected between the second power input terminal 729 and the second output terminal 726 and may include a gate electrode connected to a second Q node Q2. For example, the gate electrode of the eleventh transistor T11 connected to the second Q node Q2 may be connected to the third control node CN3 via the second bridge voltage transistor Tbv2. The eleventh transistor T11 may be turned on or turned off by a voltage of the second Q node Q2.

In this case, because the second bridge voltage transistor Tbv2 includes a gate electrode connected to the second power input terminal 729, like the first bridge voltage transistor Tbv1, the second bridge voltage transistor Tbv2 may always be kept in a turned-on state. Therefore, the voltage of the third control node CN3 and the voltage of the second Q node Q2 may have substantially the same value. Therefore, the eleventh transistor T11 may be turned on or turned off in accordance with a voltage of the third control node CN3.

For example, when the voltage the second Q node Q2 or the voltage of the third control node CN3 has the gate-on level, e.g., the low level, the eleventh transistor T11 may be turned on and electrically connect the second power input terminal 729 and the second output terminal 726. Therefore, the first pull-up control signal PUS1 outputted through the second output terminal 726 may have the gate-on level, e.g., the low level in the interval in which the eleventh transistor T11 is turned on.

The twelfth transistor T12 may be connected between the first power input terminal 728 and the second output terminal 726 and may include a gate electrode connected to the second QB node QB2. The twelfth transistor T12 may be turned on or turned off by a voltage of the second QB node QB2.

For example, when the voltage of the second QB node QB2 has the gate-on level, e.g., the low level, the twelfth transistor T12 may be turned on and electrically connect the first power input terminal 728 and the second output terminal 726. Therefore, the first pull-up control signal PUS1 outputted through the second output terminal 726 may have the gate-off level, e.g., the high level in the interval in which the twelfth transistor T12 is turned on.

As described above, the eleventh transistor T11 of the first output part OUT1 may be responsible for performing the pull-up function, and the twelfth transistor T12 of the first output part OUT1 may be responsible for performing the pull-down function.

In addition, the first pull-down control signal PDS1 may be outputted through the third output terminal 727 corresponding to the second QB node QB2. In this case, because the second Q node Q2 and the second QB node QB2 move phases opposite to each other, the first pull-up control signal PUS1 outputted through the second output terminal 726 and the first pull-down control signal PDS1 outputted through the third output terminal 727 may have phases opposite to each other.

The fourth capacitor C4 (or second boosting capacitor) may be connected between the fourth input terminal 725 and the fourth control node CN4. For example, the fourth capacitor C4 may include a first electrode connected to the fourth input terminal 725, and a second electrode connected to the fourth control node CN4.

The fifth capacitor C5 may be connected between the second Q node Q2 and the second output terminal 726. For example, the fifth capacitor C5 may include a first electrode connected to the second Q node Q2, and a second electrode connected to the second output terminal 726.

The sixth capacitor C6 may be connected between the second QB node QB2 and the the first power input terminal 728. For example, the sixth capacitor C6 may include a first electrode connected to the second QB node QB2, and a second electrode connected to the first power input terminal 728.

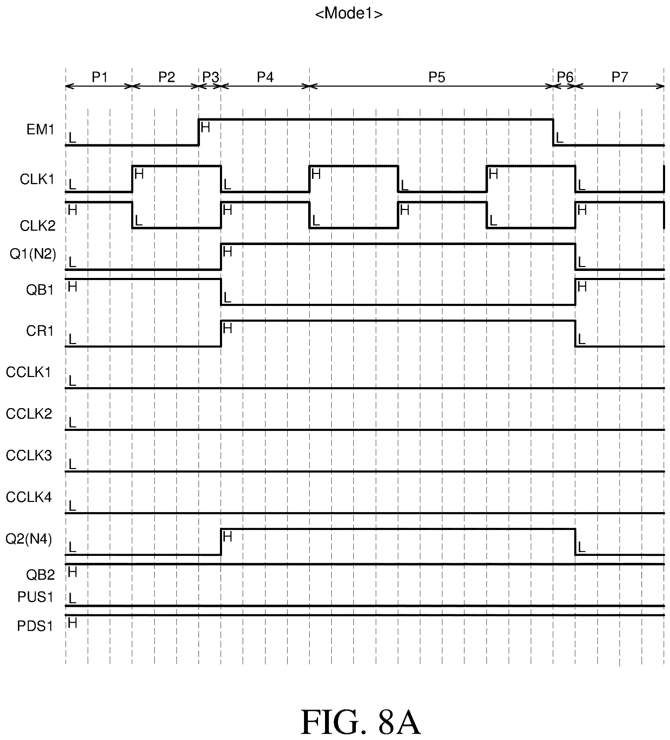

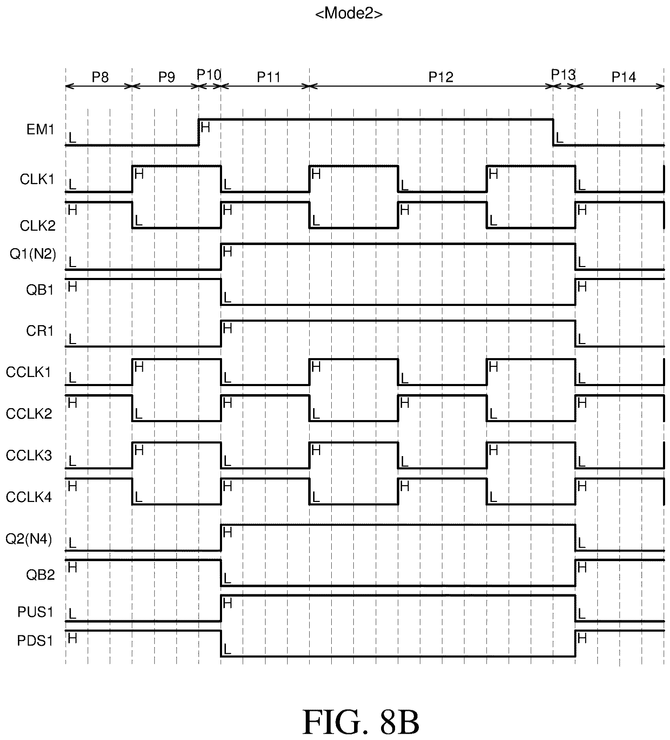

FIGS. 8A and 8B are waveform diagrams for explaining an example of an operation of the first stage in FIG. 7.

For example, FIG. 8A illustrates examples of signals inputted to the first stage STG1 and signals outputted from the first stage STG1 in case that the output controller SCTR1, e.g., the first stage STG1 operates in a first mode, and FIG. 8B illustrates examples of signals inputted to the first stage STG1 and signals outputted from the first stage STG1 in case that the output controller SCTR1, e.g., the first stage STG1 operates in a second mode.

Meanwhile, in the present specification, the first mode may refer to a mode in which a plurality of gate signals (scan signals) are sequentially outputted from all the pixel rows, i.e., a mode in which the pixels PX disposed in all the pixel rows operate for the first display period DP1 described with reference to FIG. 4A, and the second mode may refer to a mode in which the pixels PX operate for the second display period DP2 for which the gate signal (scan signal) outputted to the pixel PX disposed in at least one pixel row, among the plurality of pixel rows, is maintained at the gate-off level.

Meanwhile, as described with reference to FIG. 7, the gate electrode of the first bridge voltage transistor Tbv1 and the gate electrode of the second bridge voltage transistor Tbv2 are connected to the second power input terminal 729 through which the voltage of the second power source VGL is supplied, such that the first bridge voltage transistor Tbv1 and the second bridge voltage transistor Tbv2 may be kept in the turned-on state in all the intervals in which the output controller SCTR1 operates. Therefore, the voltage of the first control node CN1 and the voltage of the first Q node Q1 may have substantially the same value in all the intervals, and the voltage of the third control node CN3 and the voltage of the second Q node Q2 may have substantially the same value in all the intervals.

With reference to FIGS. 7 to 8B, the first clock signal CLK1 and the second clock signal CLK2 may be supplied at different timings. For example, the second clock signal CLK2 may be set as a signal shifted by 1/2 cycle from the first clock signal CLK1.

With reference to FIG. 8A, in the exemplary embodiment, in the first mode, the first control clock signal CCLK1, the second control clock signal CCLK2, the third control clock signal CCLK3, and the fourth control clock signal CCLK4 may be maintained at the gate-on level, e.g., the low level L.

In addition, with reference to FIG. 8B, in the exemplary embodiment, in the second mode, the first control clock signal CCLK1, the second control clock signal CCLK2, the third control clock signal CCLK3, and the fourth control clock signal CCLK4 may toggles between the gate-off level and the gate-on level, e.g., the low level L and the high level H in at least a partial interval. In this case, the first control clock signal CCLK1 and the third control clock signal CCLK3 may have the same waveform as the first clock signal CLK1, and the second control clock signal CCLK2 and the fourth control clock signal CCLK4 may have the same waveform as the second clock signal CLK2.

Meanwhile, the high voltage level, e.g., the high level H illustrated in FIGS. 8A and 8B may correspond to the voltage of the first power source VGH, and the low voltage level, e.g., the low level L may correspond to the voltage of the second power source VGL. For example, the voltage of the first power source VGH may be a positive voltage, and the voltage of the second power source VGL may be a negative voltage. However, this is provided for illustrative purposes only. The high level H and the low level L are not limited thereto. For example, the voltage with the high level H and the voltage with the low level L may be set in accordance with the type of transistor, the environment in which the display device is used, and the like.

Hereinafter, an operation of the output controller SCTR1, e.g., the first stage STG1 according to the exemplary embodiment of the present specification will be described with reference to FIGS. 6A, 7, 8A, and 8B. For convenience of description, the operation of the first carry part CRY1 for each mode will be described first, and then the operation of the first output part OUT1 will be described.

First, the first mode will be described with reference to FIGS. 6A, 7, and 8A. For a first period P1 and a second period P2, the first Q node Q1 may be maintained at the low level L, and the first QB node QB1 may be maintained at the high level H.

For example, the first transistor T1 is turned on by the first clock signal CLK1 with the gate-on level, e.g., the low level L for the first period P1, and the first light emission control signal EM1 with the low level L is supplied to the first control node CN1, such that the first Q node Q1 may have the low level L. The fourth transistor T4 is turned on by the voltage of the first control node CN1 with the low level L, and the voltage of the first power source VGH is supplied to the first QB node QB1, such that the first QB node QB1 may have the high level H.

In addition, even though the first clock signal CLK1 transitions to the high level H for the second period P2, the voltages applied to the first Q node Q1 and the first QB node QB1 are maintained for the first period P1, such that the first Q node Q1 may have the low level L, and the first QB node QB1 may have the high level H.

Therefore, for the first period P1 and the second period P2, the fifth transistor T5 is kept in the turned-on state, and the sixth transistor T6 is kept in the turned-off state, such that the first carry signal CR1 with the low level L may be outputted.

Thereafter, the first light emission control signal EM1 with the high level H may be provided for third to fifth periods P3, P4, and P5. Therefore, the second transistor T2 may be turned off or kept in the turned-off state for the third to fifth periods P3, P4, and P5.

In addition, the first clock signal CLK1 may transition from the existing high level H to the low level L for the fourth period P4. Therefore, for the fourth period P4, the first transistor T1 may be turned on, and the first light emission control signal EM1 with the high level H may be provided to the first control node CN1. Therefore, the first Q node Q1 may transition from the existing low level L to the high level H for the fourth period P4.

In addition, because the second transistor T2 is kept in the turned-off state for the third to fifth periods P3, P4, and P5 as described above, the signal level of the first clock signal CLK1 transitions from the existing high level H to the low level L for the fourth period P4, such that the voltage of the second control node CN2 may also transition from the existing high level H to the low level L by a coupling operation of the first capacitor C1. Therefore, the third transistor T3 is turned on for the fourth period P4, the first clock signal CLK1 with the low level L is provided to the first QB node QB1, such that the first QB node QB1 may transition from the existing high level H to the low level L.

Therefore, for the fourth period P4, by the voltages of the first Q node Q1 and the first QB node QB1, the fifth transistor T5 is turned off, and the sixth transistor T6 is turned on, such that the first carry signal CR1 with the high level H may be outputted.

Thereafter, even though the first clock signal CLK1 toggles between the high level H and the low level L for the fifth period P5, the first light emission control signal EM1 is maintained at the high level H, such that the first Q node Q1 may be maintained at the high level H, and the first QB node QB1 may be maintained at the low level L.

Thereafter, the first light emission control signal EM1 may transition from the high level H to the low level L for a sixth period P6, and then the first clock signal CLK1 may transition from the high level H to the low level L for a seventh period P7. The first transistor T1 is turned on by the first clock signal CLK1 with the low level L for the seventh period P7, and the first light emission control signal EM1 with the low level L is supplied to the first control node CN1 by the turned-on first transistor T1, such that the first Q node Q1 may transition from the existing high level H to the low level L.

In addition, because the first control node CN1 has the low level L for the seventh period P7, the fourth transistor T4 may be turned on, and the first QB node QB1 may transition from the existing low level L to the high level H by the voltage of the first power source VGH.

Therefore, for the seventh period P7, by the voltages of the first Q node Q1 and the first QB node QB1, the fifth transistor T5 is turned on, and the sixth transistor T6 is turned off, such that the first carry signal CR1 with the low level L may be outputted.

Next, an operation of the first output part OUT1 in the first mode will be described. As described above, the first control clock signal CCLK1, the second control clock signal CCLK2, the third control clock signal CCLK3, and the fourth control clock signal CCLK4 may have the gate-on level, e.g., the low level L in the first mode. Therefore, the seventh transistor T7 may always be kept in the turned-on state in the first mode.

In this case, the first carry signal CR1 with the low level L may be provided to the third control node CN3 by the turned-on seventh transistor T7 in the interval in which the first carry signal CR1 has the low level L, e.g., for the first period P1, the second period P2, the sixth period P6, and the seventh period P7. Therefore, the second Q node Q2 may have the low level L, and the tenth transistor T10 is turned on by the voltage of the third control node CN3 with the low level L, such that the second QB node QB2 may have the high level H.

Therefore, for the first period P1, the second period P2, the sixth period P6, and the seventh period P7, the eleventh transistor T11 is turned on, and the twelfth transistor T12 is turned off, such that the first pull-up control signal PUS1 with the low level L may be outputted, and the first pull-down control signal PDS1 with the high level H may be outputted through the third output terminal 727 in response to the voltage of the second QB node QB2.

Next, the first carry signal CR1 with the high level H may be provided to the third control node CN3 by the turned-on seventh transistor T7 in the interval in which the first carry signal CR1 has the high level H, e.g., for the third to fifth periods P3, P4, and P5. Therefore, the second Q node Q2 may have the high level H.

However, the fourth control node CN4 may have the high level H before the third period P3 in the interval in which the first light emission control signal EM1 has the low level L, e.g., by the eighth transistor T8 turned on by the first carry signal CR1 with the low level L for the first period P1 and the second period P2. In this case, because the first control clock signal CCLK1 is maintained at the low level L in the entire interval, the fourth control node CN4 is also maintained at the high level H by the fourth capacitor C4 for the third to fifth periods P3, P4, and P5, such that the ninth transistor T9 may always be kept in the turned-off state. Therefore, the second QB node QB2 may be maintained at the existing high level H because a separate voltage or signal is not supplied for the third to fifth periods P3, P4, and P5. As an examle, the second QB node QB2 may be maintained at the gate-off level, e.g., the high level H in the first mode.

Therefore, because both the second Q node Q2 and the second QB node QB2 have the high level H for the third to fifth periods P3, P4, and P5, both the eleventh transistor T11 and the twelfth transistor T12 are turned off or kept in the turned-off state, such that the voltage levels of the second output terminal 726 and the third output terminal 727 may be maintained, for the corresponding period, at the voltage level of the previous period.

Therefore, in the entire interval in which the operation is performed in the first mode, the first pull-up control signal PUS1 outputted through the second output terminal 726 may have the gate-on level, e.g., the low level L, and a first pull-down control signal PDS1 outputted through the third output terminal 727 may have the gate-off level, e.g., the high level H.

Next, the second mode will be described with reference to FIGS. 6A, 7, and 8B. The operation of the first carry part CRY1 in the second mode may be substantially identical to the operation of the first carry part CRY1 in the first mode. For example, the first carry part CRY1 may generate and output the first carry signal CR1 having the pulse with the high level H on the basis of the first light emission control signal EM1, the first clock signal CLK1, the first power source VGH, and the second power source VGL.

Next, the operation of the first output part OUT1 in the second mode will be described. For an eighth period P8 and a ninth period P9, the second Q node Q2 may be maintained at the low level L, and the second QB node QB2 may be maintained at the high level H.

For example, the seventh transistor T7 is turned on by the first control clock signal CCLK1 with the gate-on level, e.g., the low level L for the eighth period P8, and the first carry signal CR1 with the low level L is supplied to the third control node CN3, such that the second Q node Q2 may have the low level L. The tenth transistor T10 is turned on by the voltage of the third control node CN3 with the low level L, and the voltage of the first power source VGH is supplied to the second QB node QB2, such that the second QB node QB2 may have the high level H.

In addition, even though the first control clock signal CCLK1 transitions to the high level H for the ninth period P9, the voltages applied to the second Q node Q2 and the second QB node QB2 are maintained for the eighth period P8, such that the second Q node Q2 may have the low level L, and the second QB node QB2 may have the high level H.

Therefore, for the eighth period P8 and the ninth period P9, the eleventh transistor T11 is kept in the turned-on state, and the twelfth transistor T12 is kept in the turned-off state, such that the first pull-up control signal PUS1 with the low level L may be outputted.

In addition, the first pull-down control signal PDS1 with the high level H may be outputted through the third output terminal 727 for the eighth period P8 and the ninth period P9 in response to the voltage of the second QB node QB2.

Thereafter, the first carry signal CR1 with the high level H may be provided for tenth to twelfth periods P10, P11, and P12. Therefore, the eighth transistor T8 may be turned off or kept in the turned-off state for the tenth to twelfth periods P10, P11, and P12.

In addition, the first control clock signal CCLK1 may transition from the existing high level H to the low level L for the eleventh period P11. Therefore, for the eleventh period P11, the seventh transistor T7 may be turned on, and the first carry signal CR1 with the high level H may be provided to the third control node CN3. Therefore, the second Q node Q2 may transition from the existing low level L to the high level H for the eleventh period P11.

In addition, because the eighth transistor T8 is kept in the turned-off state for the tenth to twelfth periods P10, P11, and P12 as described above, and the signal level of the first control clock signal CCLK1 may transition from the existing high level H to the low level L for the eleventh period P11, the voltage of the fourth control node CN4 may also transition from the existing high level H to the low level L by a coupling operation of the fourth capacitor C4. Therefore, the ninth transistor T9 is turned on for the eleventh period P11, the first control clock signal CCLK1 with the low level L is provided to the second QB node QB2, such that the second QB node QB2 may transition from the existing high level H to the low level L.

Therefore, for the eleventh period P11, by the voltages of the second Q node Q2 and the second QB node QB2, the eleventh transistor T11 is turned off, and the twelfth transistor T12 is turned on, such that the first pull-up control signal PUS1 with the high level H may be outputted.

In addition, the first pull-down control signal PDS1 with the low level L may be outputted for the eleventh period P11 in response to the voltage of the second QB node QB2.

Thereafter, even though the first control clock signal CCLK1 toggles between the high level H and the low level L for the twelfth period P12, the first carry signal CR1 is maintained at the high level H, such that the second Q node Q2 may be maintained at the high level H, and the second QB node QB2 may be maintained at the low level L.

Thereafter, the first carry signal CR1 may transition from the high level H to the low level L for a thirteenth period P13, and then the first control clock signal CCLK1 may transition from the high level H to the low level L for a fourteenth period P14. The seventh transistor T7 is turned on by the first control clock signal CCLK1 with the low level L for the fourteenth period P14, and the first carry signal CR1 with the low level L is supplied to the third control node CN3 by the turned-on seventh transistor T7, such that the second Q node Q2 may transition from the existing high level H to the low level L.

In addition, because the third control node CN3 has the low level L for the fourteenth period P14, the tenth transistor T10 may be turned on, and the second QB node QB2 may transition from the existing low level L to the high level H by the voltage of the first power source VGH.

Therefore, for the fourteenth period P14, by the voltages of the second Q node Q2 and the second QB node QB2, the eleventh transistor T11 is turned on, and the twelfth transistor T12 is turned off, such that the first pull-up control signal PUS1 with the low level L may be outputted.

In addition, the first pull-down control signal PDS1 with the high level H may be outputted for the fourteenth period P14 in response to the voltage of the second QB node QB2.

As described above, in the first mode, the first pull-up control signal PUS1 may have the low level L, and the first pull-down control signal PDS1 may have the high level H. In addition, in the second mode, the first pull-up control signal PUS1 may have the pulse with the high level H in at least a partial interval, and the first pull-down control signal PDS1 may have the pulse with the low level L in at least a partial interval.

In this case, the output of the gate signal (scan signal) of the scan driver connected to the output controller SCTR1, e.g., the first stage STG1 may be controlled in the second mode, e.g., in the interval in which the first pull-up control signal PUS1 has the pulse with the high level H and the first pull-down control signal PDS1 has the pulse with the low level L in the second mode. For example, the gate signal (scan signal) outputted from the scan driver may have the gate-off level in the interval in which the first pull-up control signal PUS1 has the pulse with the high level H and the first pull-down control signal PDS1 has the pulse with the low level L.

Therefore, the gate driver 620 and the display device 100 including the same according to the exemplary embodiment of the present specification may control the signal levels of the pull-up control signal and the pull-down control signal outputted from the output part by controlling the signal level of the plurality of control clock signals CCLK1 to CCLK4 applied to the output part of each of the stages included in the output controller SCTR1. In this case, the scan drivers, e.g., the first scan driver SDV1, the second scan driver SDV2, and the fourth scan driver SDV4 connected to the output controller SCTR1 may control the signal level of the gate signal (scan signal) outputted in accordance with the signal levels of the pull-up control signal and the pull-down control signal, such that the output frequencies of the first scan driver SDV1, the second scan driver SDV2, and the fourth scan driver SDV4 may be controlled.

Therefore, the gate driver 620 and the display device 100 including the same according to the exemplary embodiment of the present specification may freely control the driving frequency for each area of the display area AA, e.g., in the unit of the pixel row.

A more detailed description thereof will be described below with reference to FIGS. 10 to 14.

Meanwhile, as described above, the first pull-up control signal PUS1 and the first pull-down control signal PDS1 may have phases opposite to each other in each of the first and second modes.

Meanwhile, by the operations of the first carry part CRY1 and the first output part OUT1, a pulse width of the high level H of the first pull-up control signal PUS1 and a pulse width of the low level L of the first pull-down control signal PDS1 may be equal to a pulse width of the first light emission control signal EM1 provided to the corresponding stage. As an example, the pulse of the high level H of the first pull-up control signal PUS1 and the pulse of the low level L of the first pull-down control signal PDS1 may at least partially overlap the pulse of the first light emission control signal EM1 provided to the corresponding stage, without being limited thereto. As an example, the pulse of the high level H of the first pull-up control signal PUS1 and the pulse of the low level L of the first pull-down control signal PDS1 may be later than a pulse of the first light emission control signal EM1 provided to the corresponding stage, without being limited thereto.

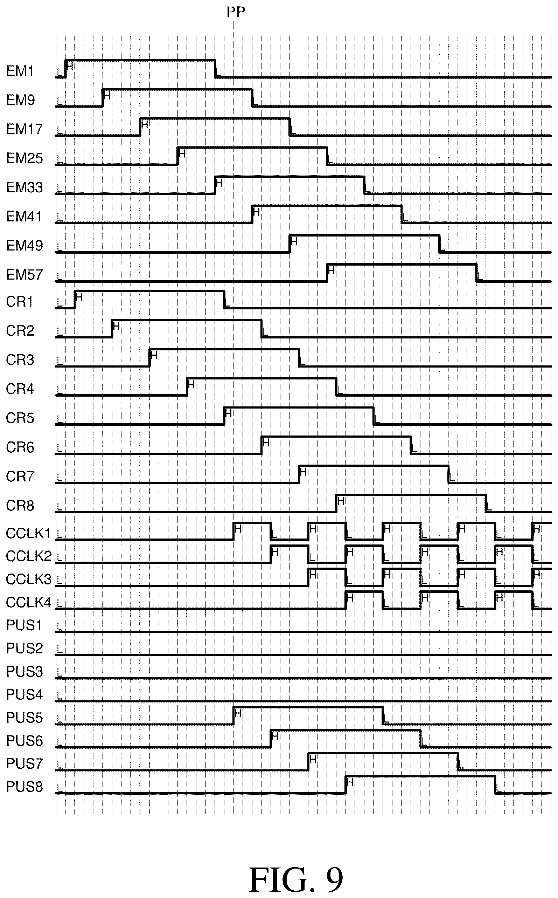

FIG. 9 is a waveform diagram for explaining an example of an operation of the gate driver in FIG. 6A.

For example, FIG. 9 illustrates waveform diagrams of light emission control signals (e.g., EM1, EM9, EM17, EM25, EM33, EM41, EM49, and EM57) applied to an output controller STCR1, the plurality of control clock signals CCLK1 to CCLK4 applied to the output controller STCR1 among the plurality of light emission control signals outputted from the light emission driver EDV, the plurality of carry signals CR1 to CR8 outputted from a carry part of the output controller STCR1, and the plurality of pull-up control signals PUS1 to PUS8 outputted from an output part of the output controller STCR1 in accordance with a connection relationship between the output controller STCR1 and the plurality of light emission stages of the light emission driver EDV.

Meanwhile, although not separately illustrated in FIG. 9, the pull-down control signal may have the phase opposite to the phase of the pull-up control signal, as described above.

With reference to FIGS. 6A to 9, the plurality of carry parts of the output controller STCR1 may sequentially output the plurality of carry signals CR1 to CR8 on the basis of the light emission control signals (e.g., EM1, EM9, EM17, EM25, EM33, EM41, EM49, and EM57) outputted from the light emission stages connected to the output controller SCTR1 among the plurality of light emission stages of the light emission driver EDV.

In the exemplary embodiment, at least some of the first control clock signal CCLK1, the second control clock signal CCLK2, the third control clock signal CCLK3, and the fourth control clock signal CCLK4 may be maintained at the gate-on level, e.g., the low level L in at least a partial interval. For example, at least one of the first control clock signal CCLK1, the second control clock signal CCLK2, the third control clock signal CCLK3, and the fourth control clock signal CCLK4 does not toggle in the corresponding interval.

Meanwhile, in an example related thereto, FIG. 9 illustrates a case in which the first control clock signal CCLK1, the second control clock signal CCLK2, the third control clock signal CCLK3, and the fourth control clock signal CCLK4 are maintained at the low level L for a period prior to a switching time point PP.

In this case, the stages, which receive the first control clock signal CCLK1, the second control clock signal CCLK2, the third control clock signal CCLK3, and the fourth control clock signal CCLK4 maintained at the low level L for the period prior to the switching time point PP among the plurality of stages included in the output controller SCTR1, may output the pull-up control signal having the gate-on level, e.g., the low level L.

For example, as illustrated in FIG. 9, the first to fourth pull-up control signals PUS1, PUS2, PUS3, and PUS4 may have the low level L.

In contrast, the stages, which receive the first control clock signal CCLK1, the second control clock signal CCLK2, the third control clock signal CCLK3, and the fourth control clock signal CCLK4 having the pulses with the high level H for a period subsequent to the switching time point PP, may output the pull-up control signal having the pulse with the gate-off level, e.g., the high level H.

For example, as illustrated in FIG. 9, the fifth to eighth pull-up control signals PUS5, PUS6, PUS7, and PUS8 may have the pulses with the high level H.

In this case, as described above, the scan stage, which receives the first to fourth pull-up control signals PUS1, PUS2, PUS3, and PUS4 among the plurality of scan stages included in the scan driver connected to the output controller SCTR1, may output the gate signal (scan signal) having the pulse with the gate-on level, and the scan stage, which receives the fifth to eighth pull-up control signals PUS5, PUS6, PUS7, and PUS8, may output the gate signal (scan signal) maintained at the gate-off level.

A more detailed description thereof will be described below with reference to FIGS. 10 to 14.

FIG. 10 is a block diagram illustrating an example of the scan driver included in the gate driver in FIG. 5.

For example, a scan driver SDV illustrated in FIG. 10 may be any one of the first scan driver SDV1, the second scan driver SDV2, and the fourth scan driver SDV4 included in the gate driver 120 described with reference to FIG. 5. As an example, the scan driver SDV illustrated in FIG. 10 may be a scan driver configured to control the output level of the gate signal (scan signal) by the output controller SCTR1 included in the gate driver 120.

Meanwhile, for convenience of description, FIG. 10 illustrates thirty-two gate stages GST1 to GST32 included in the scan driver SDV, and a plurality of gate signals GATE1 to GATE32 outputted from the thirty-two gate stages GST1 to GST32. In this case, because the scan driver SDV in FIG. 10 is any one of the first scan driver SDV1, the second scan driver SDV2, and the fourth scan driver SDV4 described with reference to FIG. 5, as described above, the plurality of gate signals GATE1 to GATE32 illustrated in FIG. 10 may correspond to a plurality of first scan signals SCAN1 outputted from the first scan driver SDV1, a plurality of second scan signals SCAN2 outputted from the second scan driver SDV2, or a plurality of fourth scan signals SCAN4 outputted from the fourth scan driver SDV4. Embodiments are not limited thereto. As an example, the circuit configuration of the pixel as shown in Fig. 3 may be changed in various ways. As an example, the pixel may be configured to be controlled by one or more scan signals, two or more scan signals, or three or more scan signals, without being limited thereto. In this sense, as an example, the plurality of gate signals GATE1 to GATE32 may correspond to any one or more of the one or more scan signals. As an example, the plurality of gate signals GATE1 to GATE32 may correspond to any one scan signal that may not be supplied for the second display period DP2, without being limited thereto. As an example, the plurality of gate signals GATE1 to GATE32 may correspond to any one scan signal that may be maintained at the gate-off level for the second display period DP22, without being limited thereto.

With reference to FIGS. 6A and 10, the scan driver SDV may include a plurality of gate stage groups GSG1 to GSG4. The plurality of gate stages groups GSG1 to GSG4 may each include a plurality of gate stages. For example, the plurality of gate stages GST1 to GST32 included in the scan driver SDV may be grouped into the plurality of gate stages groups GSG1 to GSG4. For example, in case that the plurality of stages STG1 to STG4 of the output controller STCR1 are formed in the unit of eight horizontal lines, as described above, the plurality of gate stages groups GSG1 to GSG4 may each be formed in the unit of eight horizontal lines and include eight gate stages.

For example, a first gate stage group GSG1 may include first to eighth gate stages GST1, GST2, GST3, GST4, GST5, GST6, GST7, and GST8, a second gate stage group GSG2 may include ninth to sixteenth gate stages GST9, GST10, GST11, GST12, GST13, GST14, GST15, and GST16, a third gate stage group GSG3 may include seventeenth to twenty-fourth gate stages GST17, GST18, GST19, GST20, GST21, GST22, GST23, and GST24, and a fourth gate stage group GSG4 may include twenty-fifth to thirty-second gate stages GST25, GST26, GST27, GST28, GST29, GST30, GST31, and GST32.

In the exemplary embodiment, the plurality of gate stages included in each of the plurality of gate stages groups GSG1 to GSG4 may receive the same pull-up control signal and the same pull-down control signal.

For example, the first gate stage group GSG1 may receive the first pull-up control signal PUS1 and the first pull-down control signal PDS1 provided from the first stage STG1 of the output controller SCTR1, the second gate stage group GSG2 may receive the second pull-up control signal PUS2 and the second pull-down control signal PDS2 provided from the second stage STG2 of the output controller SCTR1, the third gate stage group GSG3 may receive the third pull-up control signal PUS3 and the third pull-down control signal PDS3 provided from the third stage STG3 of the output controller SCTR1, and the fourth gate stage group GSG4 may receive the fourth pull-up control signal PUS4 and the fourth pull-down control signal PDS4 provided from the fourth stage STG4 of the output controller SCTR1.

Therefore, the plurality of gate stages included in each of the gate stage groups GSG1 to GSG4 may receive the same pull-up control signal and the same pull-down control signal.

The plurality of gate stages GST1 to GST32 included in the plurality of gate stages groups GSG1 to GSG4 may be cascaded, respectively connected to the corresponding gate lines GL1 to GL32, and configured to output the gate signals GATE1 to GATE32 to the corresponding gate lines.

In the exemplary embodiment, the plurality of gate stages GST1 to GST32 included in the plurality of gate stages groups GSG1 to GSG4 may each control the output signal levels of the gate signals GATE1 to GATE32 outputted to the corresponding gate lines GL1 to GL32 on the basis of the pull-up control signal and the pull-down control signal provided to the corresponding gate stage group.

For example, the plurality of gate stages included in the corresponding gate stage group may output the gate signal having the pulse with the gate-on level in case that the pull-up control signal has the gate-on level and the pull-down control signal has the gate-off level. The gate signals outputted from the plurality of gate stages included in the corresponding gate stage group may have the gate-off level in case that the pull-up control signal has the gate-off level and the pull-down control signal has the gate-on level.

In the exemplary embodiment, the plurality of gate stages GST1 to GST32 included in the scan driver SDV may have substantially the same configuration, except for inputted signals. Therefore, hereinafter, for convenience of description, in the description of the plurality of gate stages GST1 to GST32 included in the scan driver SDV, a configuration of and a method of operating the stages included in the scan driver SDV will be described based on the first gate stage GST1.

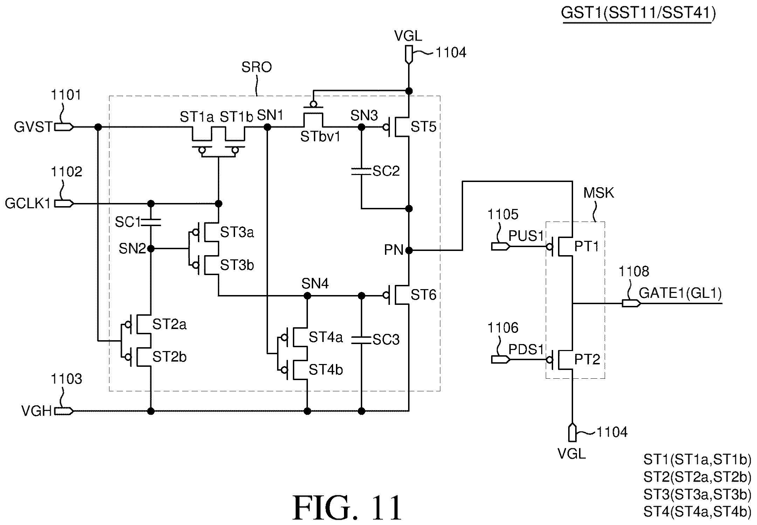

FIG. 11 is a circuit diagram illustrating an example of the first gate stage included in the scan driver in FIG. 10.

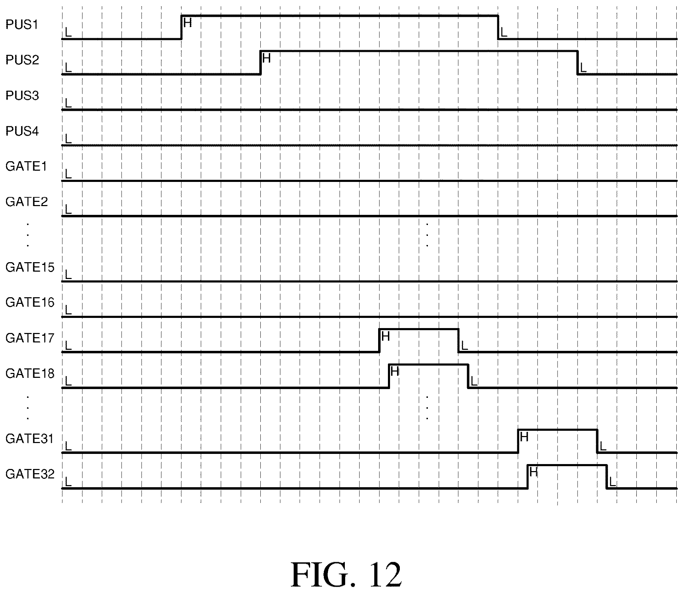

FIG. 12 is a waveform diagram for explaining an example of an operation of the scan driver in FIG. 10.

With reference to FIGS. 10 and 11, the first gate stage GST1 may include a gate signal generator SRO configured to control a voltage level of an output node PN, and a masking part MSK configured to control the signal level of a first gate signal GATE1 on the basis of the voltage of the output node PN, the first pull-up control signal PUS1, and the first pull-down control signal PDS1.

The gate signal generator SRO may receive a gate start signal GVST, i.e., an input signal through a first gate input terminal 1101 and receive a first gate clock signal GCLK1 through a second gate input terminal 1102, and the gate signal generator SRO may be connected to the first power source VGH through a first power input terminal 1103 and connected to the second power source VGL through a second power input terminal 1104. The gate signal generator SRO may control the voltage level of the output node PN on the basis of the gate start signal GVST, the first gate clock signal GCLK1, the first power source VGH, and the second power source VGL.

The masking part MSK may receive the first pull-up control signal PUS1 through a first masking input terminal 1105, e.g., the first masking input terminal 1105 connected to the second output terminal 726 of the first output part OUT1 included in the first stage STG1 of the output controller SCTR1 and receive the first pull-down control signal PDS1 through a second masking input terminal 1106, e.g., the second masking input terminal 1106 connected to the third output terminal 727 of the first output part OUT1 included in the first stage STG1 of the output controller SCTR1. The masking part MSK may output the voltage of the output node PN or the voltage of the second power source VGL as the first gate signal GATE1 through a gate output terminal 1108 on the basis of the signal levels of the first pull-up control signal PUS1 and the first pull-down control signal PDS1.

More specifically, the gate signal generator SRO of the first gate stage GST1 may include first to sixth scan transistors ST1, ST2, ST3, ST4, ST5, and ST6, a first scan capacitor SC1, a second scan capacitor SC2, and a third scan capacitor SC3. According to the exemplary embodiment, the gate signal generator SRO may further include a first scan bridge voltage transistor STbv1. As an example, the first scan bridge voltage transistor STbv1 may be omitted depending one the design.

The first scan transistor ST1 may be connected between the first gate input terminal 1101 and a first scan control node SN1 and may include a gate electrode connected to the second gate input terminal 1102. In the exemplary embodiment, the first scan transistor ST1 may have a dual gate structure and include first and second scan sub-transistors ST1a and ST1b connected to each other in series, for example.

The second scan transistor ST2 may be connected between the first power input terminal 1103 and a second scan control node SN2 and may include a gate electrode connected to the first gate input terminal 1101. In the exemplary embodiment, the second scan transistor ST2 may have a dual gate structure and include third and fourth scan sub-transistors ST2a and ST2b connected to each other in series, for example.

The third scan transistor ST3 may be connected between the second gate input terminal 1102 and a fourth scan control node SN4 and may include a gate electrode connected to the second scan control node SN2. In the exemplary embodiment, the third scan transistor ST3 may have a dual gate structure and include fifth and sixth scan sub-transistors ST3a and ST3b connected to each other in series, for example.

The fourth scan transistor ST4 may be connected between the first power input terminal 1103 and the fourth scan control node SN4 and may include a gate electrode connected to the first scan control node SN1. In the exemplary embodiment, the fourth scan transistor ST4 may have a dual gate structure and include seventh and eighth scan sub-transistors ST4a and ST4b connected to each other in series, for example. Although it illustrated and described that the first scan transistor ST1 to the fourth scan transistor ST4 all have a dual gate structure, embodiments are not limited thereto. As an example, at least one of or each of the first scan transistor ST1 to the fourth scan transistor ST4 may have a single gate structure, or a three gate structure in which three scan sub-transistors are connected to each other in series, without being limited thereto.

The fifth scan transistor ST5 may be connected between the second power input terminal 1104 and the output node PN and may include a gate electrode connected to a third scan control node SN3. For example, the gate electrode of the fifth scan transistor ST5 connected to the third scan control node SN3 may be connected to the first scan control node SN1 via the first scan bridge voltage transistor STbv1.

In this case, because the first scan bridge voltage transistor STbv1 may be connected between the first scan control node SN1 and the third scan control node SN3 and includes the gate electrode connected to the second power input terminal 1104, the first scan bridge voltage transistor STbv1 may always be kept in the turned-on state. Therefore, the voltage of the first scan control node SN1 and the voltage of the third scan control node SN3 may have substantially the same value.

Therefore, when the voltage of the third scan control node SN3 or the voltage of the first scan control node SN1 has the gate-on level, e.g., the low level, the fifth scan transistor ST5 may be turned on and electrically connect the second power input terminal 1104 and the output node PN. Therefore, the voltage of the output node PN may have the gate-on level, e.g., the low level in the interval in which the fifth scan transistor ST5 is turned on.

The sixth scan transistor ST6 may be connected between the first power input terminal 1103 and the output node PN and may include a gate electrode connected to the fourth scan control node SN4.

Therefore, when the voltage of the fourth scan control node SN4 has the gate-on level, e.g., the low level, the sixth scan transistor ST6 may be turned on and electrically connect the first power input terminal 1103 and the output node PN. Therefore, the voltage of the output node PN may have the gate-off level, e.g., the high level in the interval in which the sixth scan transistor ST6 is turned on.

The first scan capacitor SC1 may be connected between the second gate input terminal 1102 and the second scan control node SN2. Further, the second scan capacitor SC2 may be connected between the third scan control node SN3 and the output node PN, and the third scan capacitor SC3 may be connected between the fourth scan control node SN4 and the first power input terminal 1103.

The masking part MSK may include a first masking transistor PT1 and a second masking transistor PT2.

The first masking transistor PT1 may be connected between the output node PN and the gate output terminal 1108 and may include a gate electrode connected to the first masking input terminal 1105 through which the first pull-up control signal PUS1 is provided.

When the first pull-up control signal PUS1 has the gate-on level, e.g., the low level, the first masking transistor PT1 may be turned on and electrically connect the output node PN and the gate output terminal 1108. In case that the first masking transistor PT1 is turned on, the voltage of the output node PN may be outputted as the first gate signal GATE1 to a first gate line GL1 through the gate output terminal 1108.

The second masking transistor PT2 may be connected between the second power input terminal 1104 and the gate output terminal 1108 and may include a gate electrode connected to the second masking input terminal 1106 through which the first pull-down control signal PDS1 is provided.

When the first pull-down control signal PDS1 has the gate-on level, e.g., the low level, the second masking transistor PT2 may be turned on and electrically connect the second power input terminal 1104 and the gate output terminal 1108. In case that the second masking transistor PT2 is turned on, the voltage of the second power source VGL, i.e., the low level L may be outputted as the first gate signal GATE1 to the first gate line GL1 through the gate output terminal 1108.

More specifically, with reference to FIG. 12, in case that the first pull-up control signal PUS1 and the second pull-up control signal PUS2 applied to the first gate stage group GST1 and the second gate stage group GST2, among the plurality of gate stages groups GST1 to GST4 included in the scan driver SDV, have the pulses with the gate-off level, e.g., the high level H, the plurality of gate stages, e.g., the first to sixteenth gate stages GST1 to GST16 included in the first gate stage group GST1 and the second gate stage group GST2 may output the gate signals GATE1 to GATE16 maintained at the gate-off level, e.g., the low level L on the basis of the corresponding pull-up control signal.

In contrast, in case that the third pull-up control signal PUS3 and the fourth pull-up control signal PUS4 applied to the third gate stage group GST3 and the fourth gate stage group GST4 have the gate-on level, e.g., the low level L, the plurality of gate stages, e.g., the seventeenth to thirty-second gate stages GST17 to GST32 included in the third gate stage group GST3 and the fourth gate stage group GST4 may output the gate signals GATE17 to GATE32 having the pulses with the gate-on level, e.g., the high level H on the basis of the corresponding pull-up control signal. Embodiments are not limited thereto. As an example, the gate-off level for the the first to sixteenth gate stages GST1 to GST16 may also be the high level H, and the gate-on level for the the first to sixteenth gate stages GST1 to GST16 may also be the low level L, depending on the type of the transistors connected to the first gate line GL1, without being limited thereto.

Meanwhile, FIG. 12 illustrates only the plurality of pull-up control signals PUS1, PUS2, PUS3, and PUS4 applied to the plurality of gate stages groups GSG1 to GSG4. However, as described above, the plurality of pull-down control signals PDS1 to PDS4 applied to the plurality of gate stages groups GSG1 to GSG4 may each have the phase opposite to that of the corresponding pull-up control signal.

According to the exemplary embodiment, the first gate stage GST1 described with reference to FIG. 11 may be a circuit configured to output the first gate signal GATE1 having the pulse with the gate-on level, i.e., the high level H and be the plurality of scan stages SST11 to SST1n included in the first scan driver SDV1 described with reference to FIG. 5 and/or the plurality of scan stages SST41 to SST4n included in the fourth scan driver SDV4. However, the present specification is not limited thereto.

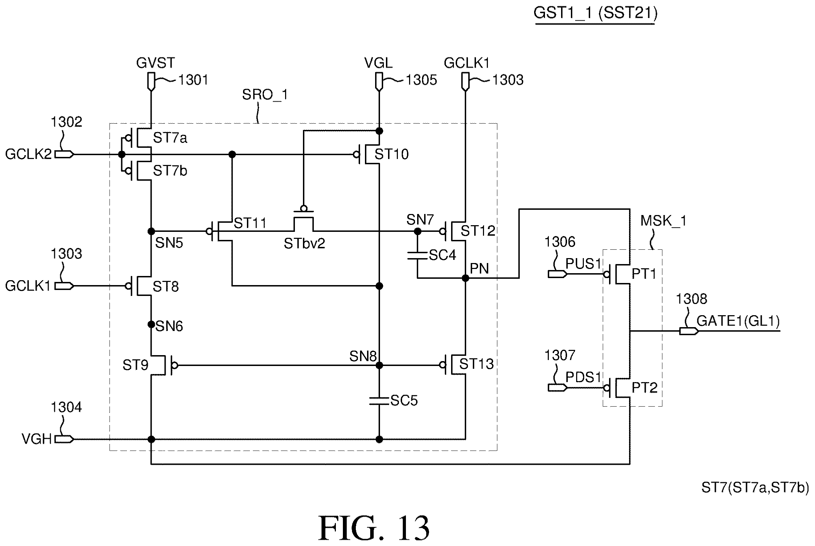

FIG. 13 is a circuit diagram illustrating another example of the first gate stage included in the scan driver in FIG. 10.

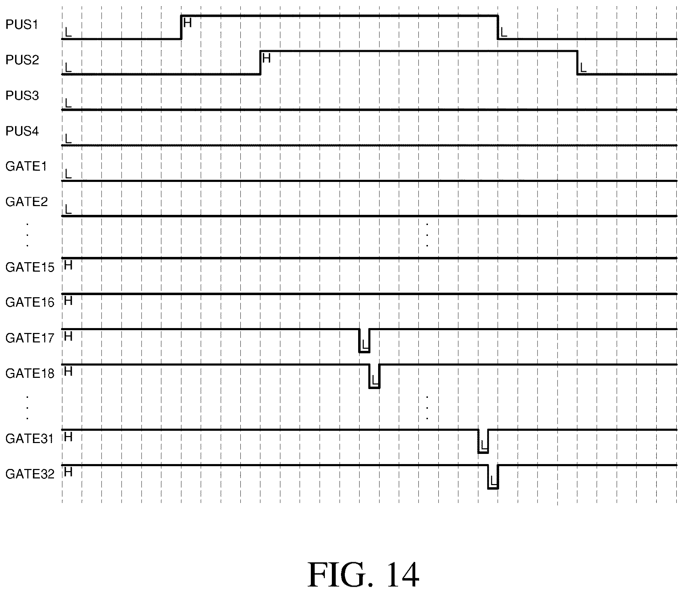

FIG. 14 is a waveform diagram for explaining an example of the operation of the scan driver in FIG. 10.

Meanwhile, a first gate stage GST1_1 in FIG. 13 represents a modified exemplary embodiment of the first gate stage GST1 described with reference to FIG. 11 and relates to a gate signal generator SRO_1.

With reference to FIGS. 10 and 13, the first gate stage GST1_1 may include the gate signal generator SRO_1 configured to control the voltage level of the output node PN, and a masking part MSK_1 configured to control the signal level of the first gate signal GATE1 on the basis of the voltage of the output node PN, the first pull-up control signal PUS1, and the first pull-down control signal PDS1.

The gate signal generator SRO_1 may receive the gate start signal GVST, i.e., an input signal through a first gate input terminal 1301, receive a second gate clock signal GCLK2 through a second gate input terminal 1302, and receive the first gate clock signal GCLK1 through a third gate input terminal 1303, and the gate signal generator SRO_1 may be connected to the first power source VGH through a first power input terminal 1304 and connected to the second power source VGL through a second power input terminal 1305. The gate signal generator SRO_1 may control the voltage level of the output node PN on the basis of the gate start signal GVST, the first gate clock signal GCLK1, the second gate clock signal GCLK2, the first power source VGH, and the second power source VGL.

The masking part MSK_1 may receive the first pull-up control signal PUS1 through a first masking input terminal 1306 and receive the first pull-down control signal PDS1 through a second masking input terminal 1307. The masking part MSK may output the voltage of the output node PN or the voltage of the first power source VGH as the first gate signal GATE1 through a gate output terminal 1308 on the basis of the signal levels of the first pull-up control signal PUS1 and the first pull-down control signal PDS1.

More specifically, the gate signal generator SRO_1 of the first gate stage GST1_1 may include seventh to thirteenth scan transistors ST7, ST8, ST9, ST10, ST11, ST12, and ST13, a fourth scan capacitor SC4, and a fifth scan capacitor SC5. According to the exemplary embodiment, the gate signal generator SRO_1 may further include a second scan bridge voltage transistor STbv2. As an example, the second scan bridge voltage transistor STbv2 may be omitted depending on the design.

The seventh scan transistor ST7 may be connected between the first gate input terminal 1301 and a fifth scan control node SN5 and may include a gate electrode connected to the second gate input terminal 1302. In the exemplary embodiment, the seventh scan transistor ST7 may have a dual gate structure and include ninth and tenth scan sub-transistors ST7a and ST7b connected to each other in series, for example, without being limited thereto.

The eighth scan transistor ST8 may be connected between the fifth scan control node SN5 and a sixth scan control node SN6 and may include a gate electrode connected to the third gate input terminal 1303.

The ninth scan transistor ST9 may be connected between the sixth scan control node SN6 and the first power input terminal 1304 and may include a gate electrode connected to an eighth scan control node SN8.

The tenth scan transistor ST10 may be connected between the second power input terminal 1305 and the eighth scan control node SN8 and may include a gate electrode connected to the second gate input terminal 1302.

The eleventh scan transistor ST11 may be connected between the second gate input terminal 1302 and the eighth scan control node SN8 and may include a gate electrode connected to the fifth scan control node SN5.

The twelfth scan transistor ST12 may be connected between the third gate input terminal 1303 and the output node PN and may include a gate electrode connected to a seventh scan control node SN7. For example, the gate electrode of the twelfth scan transistor ST12 connected to the seventh scan control node SN7 may be connected to the fifth scan control node SN5 via the second scan bridge voltage transistor STbv2.

In this case, because the second scan bridge voltage transistor STbv2 is connected between the fifth scan control node SN5 and the seventh scan control node SN7 and includes the gate electrode connected to the second power input terminal 1305, the second scan bridge voltage transistor STbv2 may always be kept in the turned-on state. Therefore, the voltage of the fifth scan control node SN5 and the voltage of the seventh scan control node SN7 may have substantially the same value.

Therefore, when the voltage of the seventh scan control node SN7 or the voltage of the fifth scan control node SN5 has the gate-on level, e.g., the low level, the twelfth scan transistor ST12 may be turned on and electrically connect the third gate input terminal 1303 and the output node PN. Therefore, the voltage of the output node PN may have the gate-on level, e.g., the low level by the first gate clock signal GCLK1 having the low level in the interval in which the twelfth scan transistor ST12 is turned on.

The thirteenth scan transistor ST13 may be connected between the first power input terminal 1304 and the output node PN and may include a gate electrode connected to the eighth scan control node SN8.

Therefore, when the voltage of the eighth scan control node SN8 has the gate-on level, e.g., the low level, the thirteenth scan transistor ST13 may be turned on and electrically connect the first power input terminal 1304 and the output node PN. Therefore, the voltage of the output node PN may have the gate-off level, e.g., the high level in the interval in which the thirteenth scan transistor ST13 is turned on.

In addition, the masking part MSK_1 may include a first masking transistor PT1 and a second masking transistor PT2.

The first masking transistor PT1 may be connected between the output node PN and the gate output terminal 1308 and may include a gate electrode connected to the first masking input terminal 1306 through which the first pull-up control signal PUS1 is provided.

When the first pull-up control signal PUS1 has the gate-on level, e.g., the low level, the first masking transistor PT1 may be turned on and electrically connect the output node PN and the gate output terminal 1308. In case that the first masking transistor PT1 is turned on, the voltage of the output node PN may be outputted as the first gate signal GATE1 to the first gate line GL1 through the gate output terminal 1308.

The second masking transistor PT2 may be connected between the second power input terminal 1304 and the gate output terminal 1308 and may include the gate electrode connected to the second masking input terminal 1307 through which the first pull-down control signal PDS1 is provided.

When the first pull-down control signal PDS1 has the gate-on level, e.g., the low level, the second masking transistor PT2 may be turned on and electrically connect the first power input terminal 1304 and the gate output terminal 1308. In case that the second masking transistor PT2 is turned on, the voltage of the first power source VGH, i.e., the high level H may be outputted as the first gate signal GATE1 to the first gate line GL1 through the gate output terminal 1308.

More specifically, with reference to FIG. 14, in case that the first pull-up control signal PUS1 and the second pull-up control signal PUS2 applied to the first gate stage group GST1 and the second gate stage group GST2, among the plurality of gate stages groups GST1 to GST4 included in the scan driver SDV, have the pulses with the gate-off level, e.g., the high level H, the plurality of gate stages, e.g., the first to sixteenth gate stages GST1 to GST16 included in the first gate stage group GST1 and the second gate stage group GST2 may output the gate signals GATE1 to GATE16 maintained at the gate-off level, e.g., the low level L on the basis of the corresponding pull-up control signal.

In contrast, in case that the third pull-up control signal PUS3 and the fourth pull-up control signal PUS4 applied to the third gate stage group GST3 and the fourth gate stage group GST4 have the gate-on level, e.g., the low level L, the plurality of gate stages, e.g., the seventeenth to thirty-second gate stages GST17 to GST32 included in the third gate stage group GST3 and the fourth gate stage group GST4 may output the gate signals GATE17 to GATE32 having the pulses with the gate-on level, e.g., the high level H on the basis of the corresponding pull-up control signal.

Meanwhile, FIG. 14 illustrates only the plurality of pull-up control signals PUS1, PUS2, PUS3, and PUS4 applied to the plurality of gate stages groups GSG1 to GSG4. However, as described above, the plurality of pull-down control signals PDS1 to PDS4 applied to the plurality of gate stages groups GSG1 to GSG4 may each have the phase opposite to that of the corresponding pull-up control signal.

According to the exemplary embodiment, the first gate stage GST1_1 described with reference to FIG. 13 may be a circuit configured to output the first gate signal GATE1 having the pulse with the gate-on level, i.e., the low level L and be the plurality of scan stages SST21 to SST2n included in the second scan driver SDV2 described with reference to FIG. 5. However, the present specification is not limited thereto.

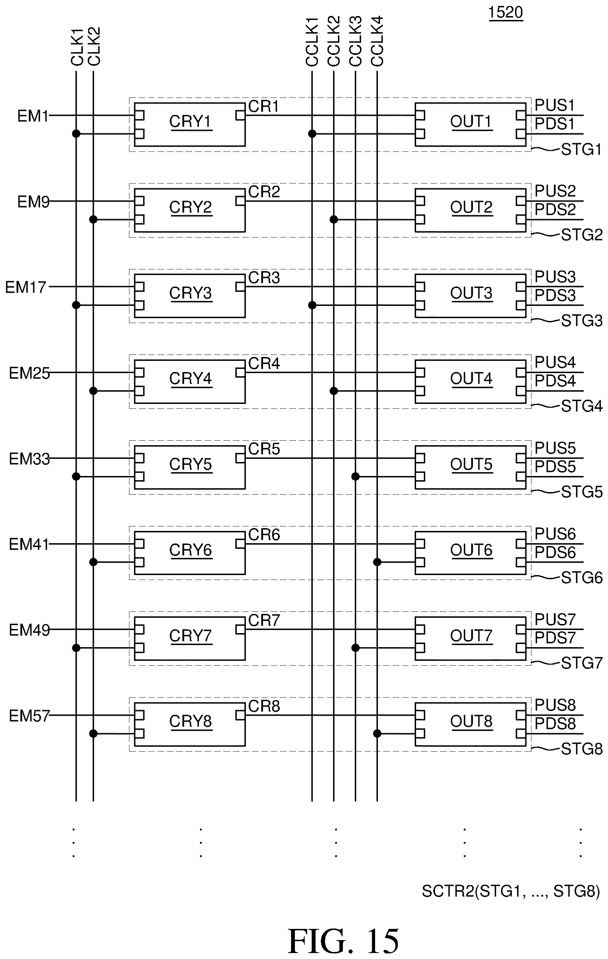

FIG. 15 is a block diagram illustrating another example of the gate driver in FIG. 5.

Meanwhile, a gate driver 1520 illustrated in FIG. 15 represents a modified examplary embodiment of the gate driver 620 including the output controller SCTR1 described with reference to FIG. 6A and relates to a plurality of control clock signals CCLK1, CCLK2, CCLK3, and CCLK4 connected to an output controller SCTR2 and the connection relationship between the plurality of control clock signals CCLK1, CCLK2, CCLK3, and CCLK4 and the output controller SCTR2. Therefore, for convenience of description, redundant descriptions will not be repeated or briefly given.

Meanwhile, FIG. 15 illustrates only the output controller SCTR2 among various components included in the gate driver 1520 and illustrates eight stages STG1 to STG8, among the plurality of stages included in the output controller SCTR2, and a plurality of pull-up control signals PUS1 to PUS8 and a plurality of pull-down control signals PDS1 to PDS8 outputted from the eight stages STG1 to STG8.

Meanwhile, even though FIG. 15 does not illustrate the light emission driver EDV included in the gate driver 1520, the output controller SCTR2 may receive the light emission signal from the plurality of light emission stages included in the light emission driver EDV, as described above.

With reference to FIG. 15, the gate driver 1520 according to the exemplary embodiment of the present specification may include the output controller SCTR2.

The output controller SCTR2 may include the plurality of stages STG1 to STG8. The plurality of stages STG1 to STG8 may output the plurality of pull-up control signals PUS1 to PUS8 and the plurality of pull-down control signals PDS1 to PDS8 on the basis of the plurality of clock signals CLK1 and CLK2 and the plurality of control clock signals CCLK1, CCLK2, CCLK3, and CCLK4. In this case, the plurality of stages STG1 to STG8 may have substantially the same configuration.

In the exemplary embodiment, the plurality of stages STG1 to STG8 included in the output controller SCTR2 may be formed in the unit of at least two or more horizontal lines. For example, as illustrated in FIG. 15, the plurality of stages STG1 to STG8 may be formed in the unit of eight horizontal lines. Therefore, in the exemplary embodiment in FIG. 15, the plurality of stages STG1 to STG8 included in the output controller SCTR2 may control in common the eight scan stages formed in the unit of eight horizontal lines among the plurality of scan stages included in the scan driver.

The plurality of stages STG1 to STG8 may include carry parts CRY1 to CRY8 configured to output the carry signals CR1 to CR8, and output parts OUT1 to OUT8 configured to output the pull-up control signals PUS1 to PUS8 and the pull-down control signals PDS1 to PDS8.

The carry signals CR1 to CR8 outputted through the output terminals of the plurality of carry parts CRY1 to CRY8 may be provided to the output parts OUT1 to OUT8 of the corresponding stages.

In addition, the plurality of output parts OUT1 to OUT8 may each receive any one of the plurality of control clock signals, e.g., the first control clock signal CCLK1, the second control clock signal CCLK2, the third control clock signal CCLK3, and the fourth control clock signal CCLK4.

In the exemplary embodiment, the output parts included in the i-th (here, i is an integer larger than 0) stage and the (i+2)th stage may receive the first control clock signal CCLK1, the output parts included in the (i+1)th stage and the (i+3)th stage may receive the second control clock signal CCLK2, the output parts included in the (i+4)th stage and the (i+6)th stage may receive the third control clock signal CCLK3, and the output parts included in the (i+5)th stage and the (i+7)th stage may receive the fourth control clock signal CCLK4. Embodiments are not limited thereto. As an example, the order of the stages configured to receive the same control clock signal may be changed in various ways. As an example, every two stages may be configured to receive the same control clock signal, without being limited thereto.

For example, the first output part OUT1 and the third output part OUT3 may receive the first control clock signal CCLK1, the second output part OUT2 and the fourth output part OUT4 may receive the second control clock signal CCLK2, the fifth output part OUT5 and the seventh output part OUT7 may receive the third control clock signal CCLK3, and the sixth output part OUT6 and the eighth output part OUT8 may receive the fourth control clock signal CCLK4. But the present disclosure is not limited thereto.

In the exemplary embodiment, the signal level of at least any one of the first control clock signal CCLK1, the second control clock signal CCLK2, the third control clock signal CCLK3, and the fourth control clock signal CCLK4 may be controlled depending on the driving mode. For example, the signal levels of the first control clock signal CCLK1, the second control clock signal CCLK2, the third control clock signal CCLK3, and the fourth control clock signal CCLK4 may be independently controlled. Therefore, the signal levels of the plurality of pull-up control signals PUS1 to PUS8 and the plurality of pull-down control signals PDS1 to PDS8 outputted from the plurality of output parts OUT1 to OUT8 may be controlled.

Meanwhile, substantially similar to the configuration described with reference to FIG. 6B, the first carry part CRY1 included in the first stage STG1 may receive the light emission start signal EVST or any emission control signal other than the first emission control signal EM1.

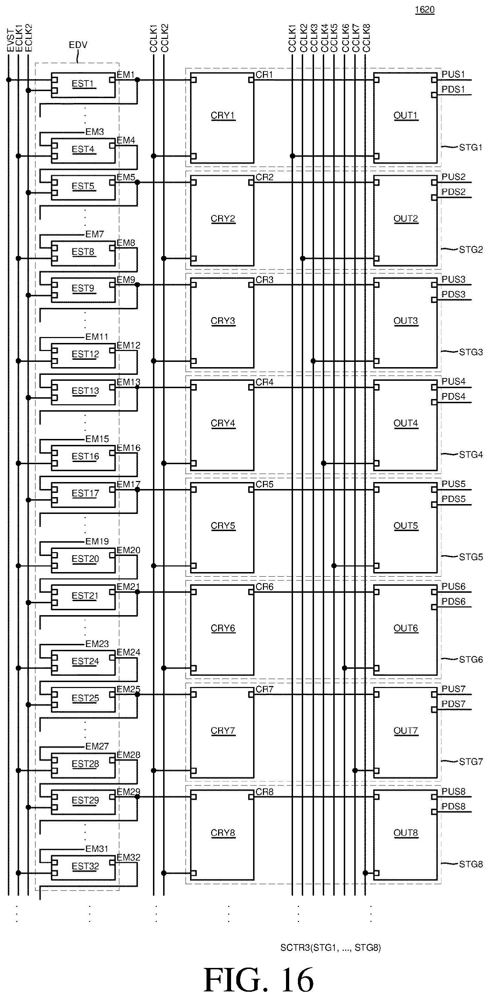

FIG. 16 is a block diagram illustrating still another example of the gate driver in FIG. 5.

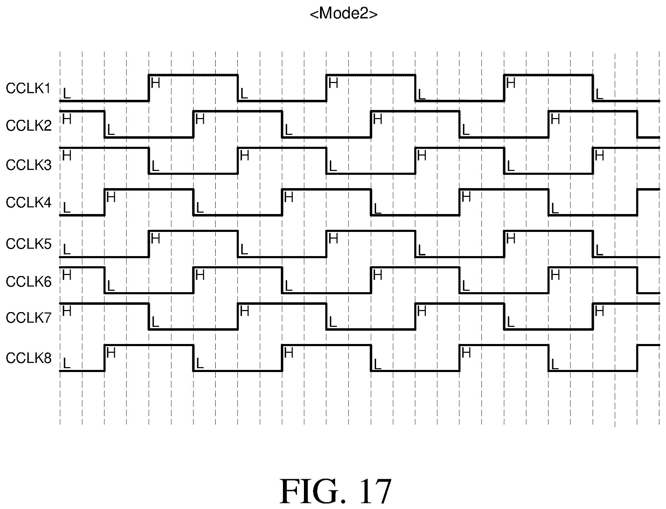

FIG. 17 is a waveform diagram illustrating an example of the control clock signal provided to the gate driver in FIG. 16.

Meanwhile, a gate driver 1620 illustrated in FIG. 16 represents a modified exemplary embodiment of the gate driver 620 including the output controller SCTR1 described with reference to FIG. 6A and relates to the connection relationship between an output controller SCTR3 and the light emission driver EDV, the plurality of control clock signals CCLK1 to CCLK8 connected to the output controller SCTR3, and a connection relationship between the plurality of control clock signals CCLK1 to CCLK8 and the the output controller SCTR3. Therefore, for convenience of description, redundant descriptions will not be repeated or briefly given.

Meanwhile, FIG. 16 illustrates only the light emission driver EDV and the output controller SCTR3 related to various components included in the gate driver 1620. In addition, for convenience of description, FIG. 16 illustrates thirty-two stages EST1 to EST32 among the plurality of light emission stages included in the light emission driver EDV, the plurality of light emission control signals EM1 to EM32 outputted from the thirty-two stages EST1 to EST32, the eight stages STG1 to STG8 among the plurality of stages included in the output controller SCTR3, and the plurality of pull-up control signals PUS1 to PUS8 and the plurality of pull-down control signals PDS1 to PDS8 outputted from the eight stages STG1 to STG8.

With reference to FIG. 16, the gate driver 1620 according to the exemplary embodiment of the present specification may include the light emission driver EDV and the output controller SCTR3.

The output controller SCTR3 may include the plurality of stages STG1 to STG8. The plurality of stages STG1 to STG8 may output the plurality of pull-up control signals PUS1 to PUS8 and the plurality of pull-down control signals PDS1 to PDS8 on the basis of the plurality of clock signals CLK1 and CLK2 and the plurality of control clock signals CCLK1 to CCLK8. In this case, the plurality of stages STG1 to STG8 may have substantially the same configuration.

In the exemplary embodiment, the plurality of stages STG1 to STG8 included in the output controller SCTR3 may be formed in the unit of at least two or more horizontal lines. For example, as illustrated in FIG. 16, the plurality of stages STG1 to STG8 may be formed in the unit of four horizontal lines. Therefore, in the exemplary embodiment in FIG. 16, the plurality of stages STG1 to STG8 included in the output controller SCTR3 may control in common the four scan stages formed in the unit of four horizontal lines among the plurality of scan stages included in the scan driver.

The plurality of stages STG1 to STG8 may include the carry parts CRY1 to CRY8 configured to output the carry signals CR1 to CR8, and the output parts OUT1 to OUT8 configured to output the pull-up control signals PUS1 to PUS8 and the pull-down control signals PDS1 to PDS8.

The plurality of carry parts CRY1 to CRY8 included in the plurality of stages STG1 to STG8 may each receive the light emission control signal from the light emission driver EDV.

In the exemplary embodiment, the k-th (here, k is an integer larger than 0) stage may receive the light emission control signal outputted from the (4k-3)th light emission stage. For example, the first carry part CRY1 included in the first stage STG1 may receive the first light emission control signal EM1 outputted from the first light emission stage EST1, the second carry part CRY2 included in the second stage STG2 may receive the fifth light emission control signal EM5 outputted from the fifth light emission stage EST5, the third carry part CRY3 included in the third stage STG3 may receive the ninth light emission control signal EM9 outputted from the ninth light emission stage EST9, the fourth carry part CRY4 included in the fourth stage STG4 may receive the thirteenth light emission control signal EM13 outputted from the thirteenth light emission stage EST13, the fifth carry part CRY5 included in the fifth stage STG5 may receive the seventeenth light emission control signal EM17 outputted from the seventeenth light emission stage EST17, the sixth carry part CRY6 included in the sixth stage STG6 may receive the twenty-first light emission control signal EM21 outputted from the twenty-first light emission stage EST21, the seventh carry part CRY7 included in the seventh stage STG7 may receive the twenty-fifth light emission control signal EM25 outputted from the twenty-fifth light emission stage EST25, and the eighth carry part CRY8 included in the eighth stage STG8 may receive the twenty-ninth light emission control signal EM29 outputted from the twenty-ninth light emission stage EST29. Embodiments are not limited thereto. As an example, the k-th (here, k is an integer larger than 0) stage may receive the light emission control signal outputted from any one of the (4k-3)th light emission stage to the (4k-1)th light emission stage, without being limited thereto.

Because the plurality of stages STG1 to STG8 control in common the four scan stages formed in the unit of four horizontal lines as described above, the plurality of carry parts CRY1 to CRY8 respectively included in the plurality of stages STG1 to STG8 may receive the light emission control signal from one light emission stage among the four light emission stages formed in the unit of four horizontal lines.

Meanwhile, substantially similar to the configuration described with reference to FIG. 6B, the first carry part CRY1 included in the first stage STG1 may receive the light emission start signal EVST. In this case, in the case of the remaining stages excluding the first stage STG1, the l-th (here, l is an integer larger than 1) stage may receive the light emission control signal outputted from the (4(l-1))th light emission stage. Embodiments are not limited thereto. As an example, in the case of the remaining stages excluding the first stage STG1, the l-th stage may receive the light emission control signal outputted from any one of the (4(l-1))th light emission stage to the (4l-1))th light emission stage, without being limited thereto.

The carry signals CR1 to CR8 outputted through the output terminals of the plurality of carry parts CRY1 to CRY8 may be provided to the output parts OUT1 to OUT8 of the corresponding stages.

In addition, the plurality of output parts OUT1 to OUT8 may each receive any one of the plurality of control clock signals CCLK1 to CCKL8.

In the exemplary embodiment, the output part included in the i-th (here, i is an integer larger than 0) stage may receive the first control clock signal CCLK1, the output part included in the (i+1)th stage may receive the second control clock signal CCLK2, the output part included in the (i+2)th stage may receive the third control clock signal CCLK3, the output part included in the (i+3)th stage may receive the fourth control clock signal CCLK4, the output part included in the (i+4)th stage may receive the fifth control clock signal CCLK5, the output part included in the (i+5)th stage may receive the sixth control clock signal CCLK6, the output part included in the (i+6)th stage may receive the seventh control clock signal CCLK7, and the output part included in the (i+7)th stage may receive the eighth control clock signal CCLK8. Embodiments are not limited thereto. As an example, the output part included in each stage may receive different ones among the first control clock signal CCLK1 to the eighth control clock signal CCLK8, without being limited thereto.

For example, the first output part OUT1 may receive the first control clock signal CCLK1, the second output part OUT2 may receive the second control clock signal CCLK2, the third output part OUT3 may receive the third control clock signal CCLK3, the fourth output part OUT4 may receive the fourth control clock signal CCLK4, the fifth output part OUT5 may receive the fifth control clock signal CCLK5, the sixth output part OUT6 may receive the sixth control clock signal CCLK6, the seventh output part OUT7 may receive the seventh control clock signal CCLK7, and the eighth output part OUT8 may receive the eighth control clock signal CCLK8. But the present disclosure is not limited thereto.

The plurality of control clock signals CCLK1 to CCLK8 may have waveforms having the same cycle and the same pulse width and having phases that do not overlap one another.

For example, with reference further to FIG. 17, in case that the gate driver 1620 operates in the second mode and the plurality of control clock signals CCLK1 to CCLK8 toggle, as described above, the second control clock signal CCLK2 may be set to a signal shifted by about 1/4 cycle from the first control clock signal CCLK1, the third control clock signal CCLK3 may be set to a signal shifted by about 1/4 cycle from the second control clock signal CCLK2, the fourth control clock signal CCLK4 may be set to a signal shifted by about 1/4 cycle from the third control clock signal CCLK3, the fifth control clock signal CCLK5 may be set to a signal shifted by about 1/4 cycle from the fourth control clock signal CCLK4, the sixth control clock signal CCLK6 may be set to a signal shifted by about 1/4 cycle from the fifth control clock signal CCLK5, the seventh control clock signal CCLK7 may be set to a signal shifted by about 1/4 cycle from the sixth control clock signal CCLK6, and the eighth control clock signal CCLK8 may be set to a signal shifted by about 1/4 cycle from the seventh control clock signal CCLK7.

As an example, the first control clock signal CCLK1 and the fifth control clock signal CCLK5 may be set to have a difference of 1 cycle and have substantially the same waveform, the second control clock signal CCLK2 and the sixth control clock signal CCLK6 may be set to have a difference of 1 cycle and have substantially the same waveform, the third control clock signal CCLK3 and the seventh control clock signal CCLK7 may be set to have a difference of 1 cycle and have substantially the same waveform, and the fourth control clock signal CCLK4 and the eighth control clock signal CCLK8 may be set to have a difference of 1 cycle and have substantially the same waveform. Embodiments are not limited thereto. As an example, each control clock signal may be set to a signal shifted by about 1/4 cycle from another control clock signal, without being limited thereto. As an example, the each control clock signal and the another control clock signal may be adjacent control clock signal or separated control clock signals, without being limited thereto.

In the exemplary embodiment, the signal level of at least any one of the plurality of control clock signals CCLK1 to CCLK8 may be controlled depending on the driving mode. For example, the signal levels of the plurality of control clock signals CCLK1 to CCLK8 may be controlled independently.

Therefore, the signal levels of the plurality of pull-up control signals PUS1 to PUS8 and the plurality of pull-down control signals PDS1 to PDS8 outputted from the plurality of output parts OUT1 to OUT8 may be controlled.

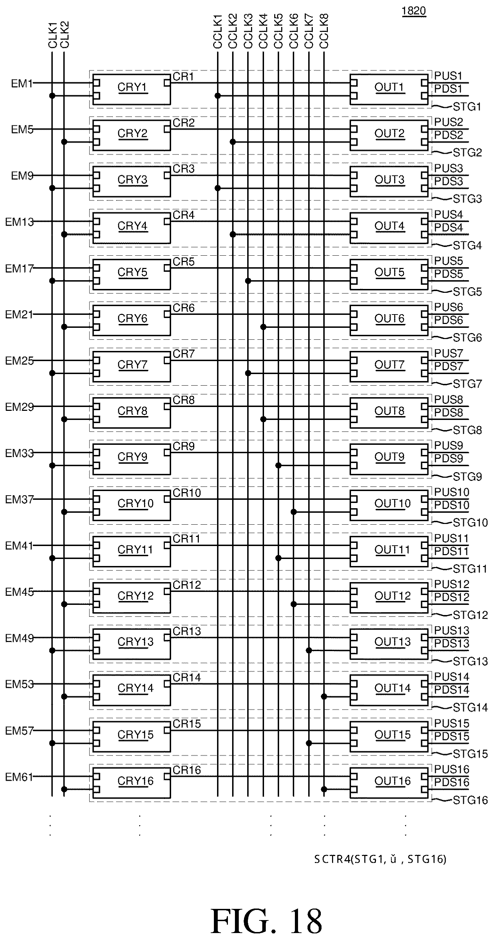

FIG. 18 is a block diagram illustrating yet another example of the gate driver in FIG. 5.

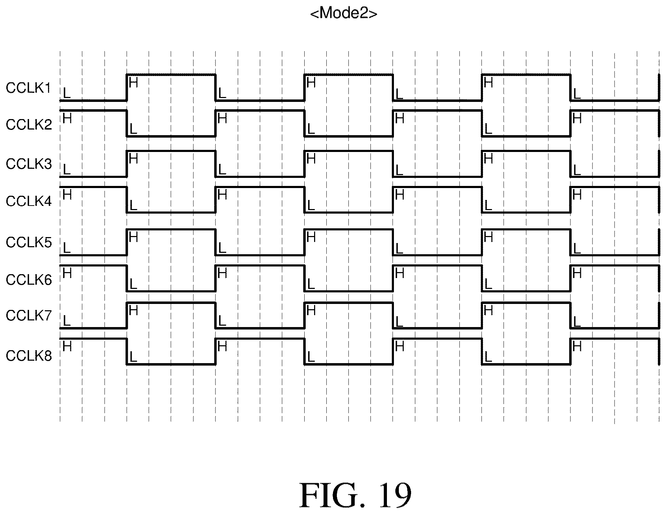

FIG. 19 is a waveform diagram illustrating an example of the control clock signal provided to the gate driver in FIG. 18.

Meanwhile, a gate driver 1820 illustrated in FIG. 18 represents a modified exemplary embodiment of the gate driver 1620 including the output controller SCTR3 described with reference to FIG. 16 and relates to a plurality of control clock signals CCLK1 to CCLK8 connected to an output controller SCTR4, and the connection relationship between the plurality of control clock signals CCLK1 to CCLK8 and the output controller SCTR4. Therefore, for convenience of description, redundant descriptions will not be repeated or biefly given.

Meanwhile, FIG. 18 illustrates only the output controller SCTR4 among various components included in the gate driver 1820 and illustrates sixteen stages STG1 to STG16, among the plurality of stages included in the output controller SCTR4, and a plurality of pull-up control signals PUS1 to PUS16 and a plurality of pull-down control signals PDS1 to PDS16 outputted from the sixteen stages STG1 to STG16.

Meanwhile, even though FIG. 18 does not illustrate the light emission driver EDV included in the gate driver 1820, the output controller SCTR4 may receive the light emission signal from the plurality of light emission stages included in the light emission driver EDV, as described above.

With reference to FIG. 18, the gate driver 1820 according to the exemplary embodiment of the present specification may include the output controller SCTR4.

The output controller SCTR4 may include the plurality of stages STG1 to STG16. The plurality of stages STG1 to STG16 may output the plurality of pull-up control signals PUS1 to PUS16 and the plurality of pull-down control signals PDS1 to PDS16 on the basis of the plurality of clock signals CLK1 and CLK2 and the plurality of control clock signals CCLK1 to CCLK8. In this case, the plurality of stages STG1 to STG16 may have substantially the same configuration.

In the exemplary embodiment, the plurality of stages STG1 to STG16 included in the output controller SCTR4 may be formed in the unit of at least two or more horizontal lines. For example, as illustrated in FIG. 18, the plurality of stages STG1 to STG16 may be formed in the unit of four horizontal lines. Therefore, in the exemplary embodiment in FIG. 18, the plurality of stages STG1 to STG16 included in the output controller SCTR4 may control in common the four scan stages formed in the unit of four horizontal lines among the plurality of scan stages included in the scan driver.

The plurality of stages STG1 to STG16 may include carry parts CRY1 to CRY16 configured to output carry signals CR1 to CR16, and output parts OUT1 to OUT16 configured to output the pull-up control signals PUS1 to PUS16 and the pull-down control signals PDS1 to PDS16.

The carry signals CR1 to CR16 outputted through the output terminals of the plurality of carry parts CRY1 to CRY16 may be provided to the output parts OUT1 to OUT16 of the corresponding stages.

In addition, the plurality of output parts OUT1 to OUT16 may each receive any one of the plurality of control clock signals CCLK1 to CCLK8.

In the exemplary embodiment, the output parts included in the i-th (here, i is an integer larger than 0) stage and the (i+2)th may receive the first control clock signal CCLK1, the output parts included in the (i+1)th stage and the (i+3)th stage may receive the second control clock signal CCLK2, the output parts included in the (i+4)th stage and the (i+6)th stage may receive the third control clock signal CCLK3, the output parts included in the (i+5)th stage and the (i+7)th stage may receive the fourth control clock signal CCLK4, the output parts included in the (i+8)th stage and the (i+10)th stage may receive the fifth control clock signal CCLK5, the output parts included in the (i+9)th stage and the (i+11)th stage may receive the sixth control clock signal CCLK6, the output parts included in the included in the (i+12)th stage and the (i+14)th stage may receive the seventh control clock signal CCLK7, and the output parts included in the (i+13)th stage and the (i+15)th stage may receive the eighth control clock signal CCLK8. Embodiments are not limited thereto. As an example, the output parts included in every two stages may receive the same control clock signal, without being limited thereto. As an example, the orders of the stages configured to receive the same control clock signal may be changed in various ways, without being limited thereto.

For example, the first output part OUT1 and the third output part OUT3 may receive the first control clock signal CCLK1, the second output part OUT2 and the fourth output part OUT4 may receive the second control clock signal CCLK2, the fifth output part OUT5 and the seventh output part OUT7 may receive the third control clock signal CCLK3, and the sixth output part OUT6 and the eighth output part OUT8 may receive the fourth control clock signal CCLK4. In addition, the ninth output part OUT9 and the eleventh output part OUT11 may receive the fifth control clock signal CCLK5, the tenth output part OUT10 and the twelfth output part OUT12 may receive the sixth control clock signal CCLK6, the thirteenth output part OUT13 and the fifteenth output part OUT15 may receive the seventh control clock signal CCLK7, and the fourteenth output part OUT14 and the sixteenth output part OUT16 may receive the eighth control clock signal CCLK8. But the present disclosure is not limited thereto.

In the exemplary embodiment, the signal level of at least any one of the first control clock signal CCLK1, the second control clock signal CCLK2, the third control clock signal CCLK3, the fourth control clock signal CCLK4, the fifth control clock signal CCLK5, the sixth control clock signal CCLK6, the seventh control clock signal CCLK7, and the eighth control clock signal CCLK8 may be controlled depending on the driving mode. For example, the signal levels of the first control clock signal CCLK1, the second control clock signal CCLK2, the third control clock signal CCLK3, the fourth control clock signal CCLK4, the fifth control clock signal CCLK5, the sixth control clock signal CCLK6, the seventh control clock signal CCLK7, and the eighth control clock signal CCLK8 may be independently controlled.

As an example, the plurality of control clock signals CCLK1 to CCLK8 may have waveforms having the same cycle and the same pulse width and having phases that do not overlap one another, without being limited thereto.

For example, with reference further to FIG. 19, in case that the gate driver 1820 operates in the second mode and the plurality of control clock signals CCLK1 to CCLK8 toggle, as described above, the second control clock signal CCLK2 may be set to a signal shifted by about 1/2 cycle from the first control clock signal CCLK1, the third control clock signal CCLK3 may be set to a signal shifted by about 1/2 cycle from the second control clock signal CCLK2, the fourth control clock signal CCLK4 may be set to a signal shifted by about 1/2 cycle from the third control clock signal CCLK3, the fifth control clock signal CCLK5 may be set to a signal shifted by about 1/2 cycle from the fourth control clock signal CCLK4, the sixth control clock signal CCLK6 may be set to a signal shifted by about 1/2 cycle from the fifth control clock signal CCLK5, the seventh control clock signal CCLK7 may be set to a signal shifted by about 1/2 cycle from the sixth control clock signal CCLK6, and the eighth control clock signal CCLK8 may be set to a signal shifted by about 1/2 cycle from the seventh control clock signal CCLK7. But the present disclure is not limited thereto.

As an example, the first control clock signal CCLK1, the third control clock signal CCLK3, the fifth control clock signal CCLK5, and the seventh control clock signal CCLK7 may be set to have a difference of a multiple of 1 cycle and have substantially the same waveform, and the second control clock signal CCLK2, the fourth control clock signal CCLK4, the sixth control clock signal CCLK6, and the eighth control clock signal CCLK8 may be set to have a difference of a multiple of 1 cycle and have substantially the same waveform. But the present disclure is not limited thereto.

In the exemplary embodiment, the signal level of at least any one of the plurality of control clock signals CCLK1 to CCLK8 may be controlled depending on the driving mode. For example, the signal levels of the plurality of control clock signals CCLK1 to CCLK8 may be controlled independently.

Therefore, the signal levels of the plurality of pull-up control signals PUS1 to PUS16 and the plurality of pull-down control signals PDS1 to PDS16 outputted from the plurality of output parts OUT1 to OUT16 may be controlled.

Meanwhile, substantially similar to the configuration described with reference to FIG. 6B, the first carry part CRY1 included in the first stage STG1 may receive the light emission start signal EVST.

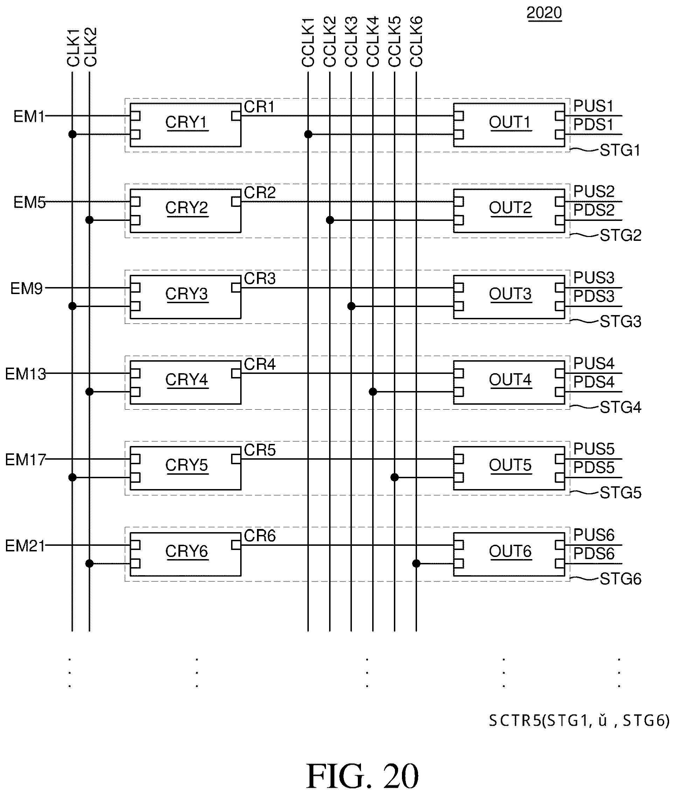

FIG. 20 is a block diagram illustrating still yet another example of the gate driver in FIG. 5.

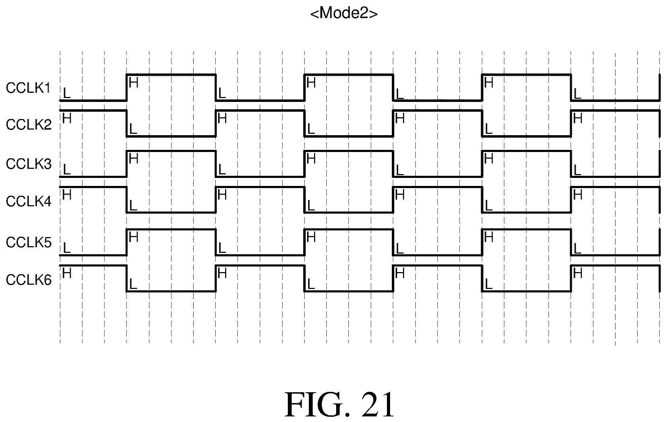

FIG. 21 is a waveform diagram illustrating an example of the control clock signal provided to the gate driver in FIG. 20.

Meanwhile, a gate driver 2020 illustrated in FIG. 20 represents a modified exemplary embodiment of the gate driver 1620 including the output controller SCTR3 described with reference to FIG. 16 and relates to a plurality of control clock signals CCLK1 to CCLK6 connected to an output controller SCTR5 and the connection relationship between the plurality of control clock signals CCLK1 to CCLK6 and the output controller SCTR5. Therefore, for convenience of description, redundant descriptions will not be repeated or briefly given.

Meanwhile, FIG. 20 illustrates only the output controller SCTR5 among various components included in the gate driver 2020 and illustrates six stages STG1 to STG6, among the plurality of stages included in the output controller SCTR5, and a plurality of pull-up control signals PUS1 to PUS6 and a plurality of pull-down control signals PDS1 to PDS6 outputted from the six stages STG1 to STG6.

Meanwhile, even though FIG. 20 does not illustrate the light emission driver EDV included in the gate driver 2020, the output controller SCTR5 may receive the light emission signal from the plurality of light emission stages included in the light emission driver EDV, as described above.

With reference to FIG. 20, the gate driver 2020 according to the exemplary embodiment of the present specification may include the output controller SCTR5.

The output controller SCTR5 may include the plurality of stages STG1 to STG6. The plurality of stages STG1 to STG6 may output the plurality of pull-up control signals PUS1 to PUS6 and the plurality of pull-down control signals PDS1 to PDS6 on the basis of the plurality of clock signals CLK1 and CLK2 and the plurality of control clock signals CCLK1 to CCLK6. In this case, the plurality of stages STG1 to STG6 may have substantially the same configuration.

In the exemplary embodiment, the plurality of stages STG1 to STG6 included in the output controller SCTR5 may be formed in the unit of at least two or more horizontal lines. For example, as illustrated in FIG. 20, the plurality of stages STG1 to STG6 may be formed in the unit of four horizontal lines. Therefore, in the exemplary embodiment in FIG. 20, the plurality of stages STG1 to STG6 included in the output controller SCTR5 may control in common the four scan stages formed in the unit of four horizontal lines among the plurality of scan stages included in the scan driver.

The plurality of stages STG1 to STG6 may include carry parts CRY1 to CRY6 configured to output carry signals CR1 to CR6, and output parts OUT1 to OUT6 configured to output the pull-up control signals PUS1 to PUS6 and the pull-down control signals PDS1 to PDS6.

The carry signals CR1 to CR6 outputted through the output terminals of the plurality of carry parts CRY1 to CRY6 may be provided to the output parts OUT1 to OUT6 of the corresponding stages.

In addition, the plurality of output parts OUT1 to OUT6 may each receive any one of the plurality of control clock signals CCLK1 to CCLK6.

In the exemplary embodiment, the output part included in the i-th (here, i is an integer larger than 0) stage may receive the first control clock signal CCLK1, the output part included in the (i+1)th stage may receive the second control clock signal CCLK2, the output part included in the (i+2)th stage may receive the third control clock signal CCLK3, the output part included in the (i+3)th stage may receive the fourth control clock signal CCLK4, the output part included in the (i+4)th stage may receive the fifth control clock signal CCLK5, and the output part included in the (i+5)th stage may receive the sixth control clock signal CCLK6. Embodiments are not limited thereto. As an example, the output part included in each stage may receive different ones among the first control clock signal CCLK1 to the sixth control clock signal CCLK6, without being limited thereto.

For example, the first output part OUT1 may receive the first control clock signal CCLK1, the second output part OUT2 may receive the second control clock signal CCLK2, the third output part OUT3 may receive the third control clock signal CCLK3, the fourth output part OUT4 may receive the fourth control clock signal CCLK4, the fifth output part OUT5 may receive the fifth control clock signal CCLK5, and the sixth output part OUT6 may receive the sixth control clock signal CCLK6.

In the exemplary embodiment, the signal level of at least any one of the plurality of control clock signals CCLK1 to CCLK6 may be controlled depending on the driving mode. For example, the signal levels of the plurality of control clock signals CCLK1 to CCLK6 may be controlled independently.

As an example, the plurality of control clock signals CCLK1 to CCLK6 may have waveforms having the same cycle and the same pulse width and having phases that do not overlap one another, without being limited thereto.

For example, with reference further to FIG. 21, in case that the gate driver 2020 operates in the second mode and the plurality of control clock signals CCLK1 to CCLK6 toggle, as described above, the second control clock signal CCLK2 may be set to a signal shifted by about 1/2 cycle from the first control clock signal CCLK1, the third control clock signal CCLK3 may be set to a signal shifted by about 1/2 cycle from the second control clock signal CCLK2, the fourth control clock signal CCLK4 may be set to a signal shifted by about 1/2 cycle from the third control clock signal CCLK3, the fifth control clock signal CCLK5 may be set to a signal shifted by about 1/2 cycle from the fourth control clock signal CCLK4, and the sixth control clock signal CCLK6 may be set to a signal shifted by about 1/2 cycle from the fifth control clock signal CCLK5. Embodiments are not limited thereto. As an example, the shifted phase between adjacent control clock signal is not limited to 1/2 cycle, but could be 1/6 cycle, 1/4 cycle, 1 cycle, etc., without being limited thereto. As an example, the control clock signals shifted by about 1/2 cycle from each other may be control clock signals adjacent to each other or not adjacent to each other, without being limited thereto.

As an example, the first control clock signal CCLK1, the third control clock signal CCLK3, and the fifth control clock signal CCLK5 may be set to have a difference of a multiple of 1 cycle and have substantially the same waveform, and the second control clock signal CCLK2, the fourth control clock signal CCLK4, and the sixth control clock signal CCLK6 may be set to have a difference of a multiple of 1 cycle and have substantially the same waveform, without being limited thereto.

In the exemplary embodiment, the signal level of at least any one of the plurality of control clock signals CCLK1 to CCLK6 may be controlled depending on the driving mode. For example, the signal levels of the plurality of control clock signals CCLK1 to CCLK6 may be controlled independently.

Therefore, the signal levels of the plurality of pull-up control signals PUS1 to PUS6 and the plurality of pull-down control signals PDS1 to PDS6 outputted from the plurality of output parts OUT1 to OUT6 may be controlled.

Meanwhile, substantially similar to the configuration described with reference to FIG. 6B, the first carry part CRY1 included in the first stage STG1 may receive the light emission start signal EVST.

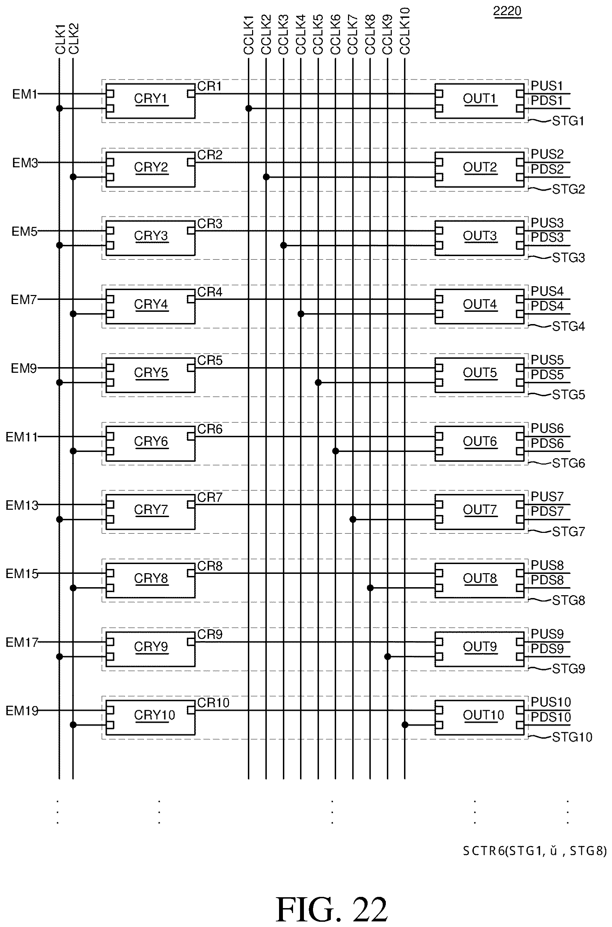

FIG. 22 is a block diagram illustrating a further example of the gate driver in FIG. 5.

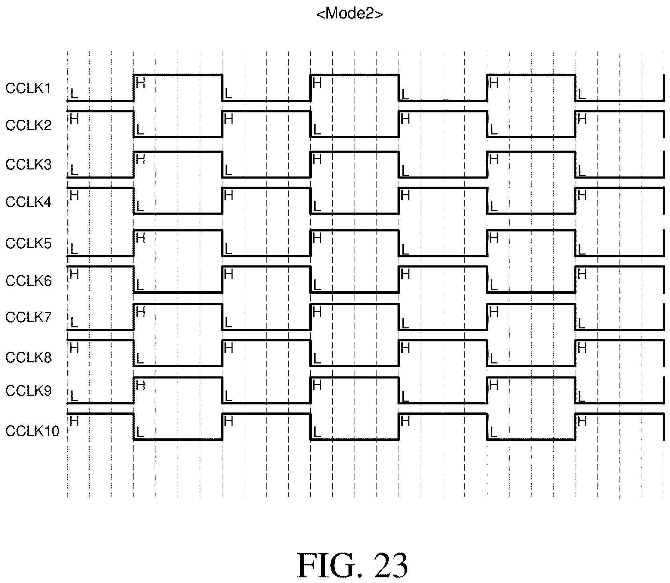

FIG. 23 is a waveform diagram illustrating an example of the control clock signal provided to the gate driver in FIG. 22.

Meanwhile, a gate driver 2220 illustrated in FIG. 22 represents a modified exemplary embodiment of the gate driver 620 including the output controller SCTR1 described with reference to FIG. 6A and relates to the connection relationship between an output controller SCTR6 and the light emission driver EDV, a plurality of control clock signals CCLK1 to CCLK10 connected to an output controller SCTR6, and a connection relationship between the plurality of control clock signals CCLK1 to CCLK10 and the output controller SCTR6. Therefore, for convenience of description, redundant descriptions will not be repeated or briefly given.

Meanwhile, FIG. 22 illustrates only the output controller SCTR6 among various components included in the gate driver 2220 and illustrates ten stages STG1 to STG10, among the plurality of stages included in the output controller SCTR6, and a plurality of pull-up control signals PUS1 to PUS10 and a plurality of pull-down control signals PDS1 to PDS 10 outputted from the ten stages STG1 to STG10.

With reference to FIG. 22, the gate driver 2220 according to the exemplary embodiment of the present specification may include the output controller SCTR6.

The output controller SCTR6 may include the plurality of stages STG1 to STG10. The plurality of stages STG1 to STG10 may output the plurality of pull-up control signals PUS1 to PUS10 and the plurality of pull-down control signals PDS1 to PDS10 on the basis of the plurality of clock signals CLK1 and CLK2 and the plurality of control clock signals CCLK1 to CCLK10. In this case, the plurality of stages STG1 to STG10 may have substantially the same configuration.

In the exemplary embodiment, the plurality of stages STG1 to STG10 included in the output controller SCTR6 may be formed in the unit of at least two or more horizontal lines. For example, as illustrated in FIG. 22, the plurality of stages STG1 to STG10 may be formed in the unit of two horizontal lines. Therefore, in the exemplary embodiment in FIG. 22, the plurality of stages STG1 to STG10 included in the output controller SCTR6 may control in common the two scan stages formed in the unit of two horizontal lines among the plurality of scan stages included in the scan driver.

The plurality of stages STG1 to STG10 may include carry parts CRY1 to CRY10 configured to output carry signals CR1 to CR10, and output parts OUT1 to OUT10 configured to output the pull-up control signals PUS1 to PUS10 and the pull-down control signals PDS1 to PDS10.

The plurality of carry parts CRY1 to CRY10 included in the plurality of stages STG1 to STG10 may each receive the light emission control signal from the light emission driver EDV.

In the exemplary embodiment, the k-th (here, k is an integer larger than 0) stage may receive the light emission control signal outputted from the (2k-1)th light emission stage or (2k)th light emission stage. For example, the first carry part CRY1 included in the first stage STG1 may receive the first light emission control signal EM1 outputted from the first light emission stage EST1, the second carry part CRY2 included in the second stage STG2 may receive the third light emission control signal EM3 outputted from the third light emission stage EST3, the third carry part CRY3 included in the third stage STG3 may receive the fifth light emission control signal EM5 outputted from the fifth light emission stage EST5, the fourth carry part CRY4 included in the fourth stage STG4 may receive the seventh light emission control signal EM7 outputted from the seventh light emission stage EST7, the fifth carry part CRY5 included in the fifth stage STG5 may receive the ninth light emission control signal EM9 outputted from the ninth light emission stage EST9, the sixth carry part CRY6 included in the sixth stage STG6 may receive the eleventh light emission control signal EM11 outputted from the eleventh light emission stage EST11, the seventh carry part CRY7 included in the seventh stage STG7 may receive the thirteenth light emission control signal EM13 outputted from the thirteenth light emission stage EST13, the eighth carry part CRY8 included in the eighth stage STG8 may receive the fifteenth light emission control signal EM15 outputted from the fifteenth light emission stage EST15, the ninth carry part CRY9 included in the ninth stage STG9 may receive the seventeenth light emission control signal EM17 outputted from the seventeenth light emission stage EST17, and the tenth carry part CRY10 included in the tenth stage STG10 may receive the nineteenth light emission control signal EM19 outputted from the nineteenth light emission stage EST19. But the present disclosure is not limited thereto.

Because the plurality of stages STG1 to STG10 control in common the two scan stages formed in the unit of two horizontal lines as described above, the plurality of carry parts CRY1 to CRY10 respectively included in the plurality of stages STG1 to STG10 may receive the light emission control signal from one light emission stage among the two light emission stages formed in the unit of two horizontal lines.

Meanwhile, substantially similar to the configuration described with reference to FIG. 6B, the first carry part CRY1 included in the first stage STG1 may receive the light emission start signal EVST. In this case, in the case of the remaining stages excluding the first stage STG1, the l-th (here, 1 is an integer larger than 1) stage may receive the light emission control signal outputted from the (2(l-1))th light emission stage, without being limited thereto.

The carry signals CR1 to CR10 outputted through the output terminals of the plurality of carry parts CRY1 to CRY10 may be provided to the output parts OUT1 to OUT10 of the corresponding stages.

In addition, the plurality of output parts OUT1 to OUT10 may each receive any one of the plurality of control clock signals CCLK1 to CCKL10.

In the exemplary embodiment, the output part included in the i-th (here, i is an integer larger than 0) stage may receive the first control clock signal CCLK1, the output part included in the (i+1)th stage may receive the second control clock signal CCLK2, the output part included in the (i+2)th stage may receive the third control clock signal CCLK3, the output part included in the (i+3)th stage may receive the fourth control clock signal CCLK4, the output part included in the (i+4)th stage may receive the fifth control clock signal CCLK5, the output part included in the (i+5)th stage may receive the sixth control clock signal CCLK6, the output part included in the (i+6)th stage may receive the seventh control clock signal CCLK7, the output part included in the (i+7)th stage may receive the eighth control clock signal CCLK8, the output part included in the (i+8)th stage may receive the ninth control clock signal CCLK9, and the output part included in the (i+9)th stage may receive the tenth control clock signal CCLK10. Embodiments are not limited thereto. As an example the order of the stages and and the order of the control clock signals may be changed in various ways.

For example, the first output part OUT1 may receive the first control clock signal CCLK1, the second output part OUT2 may receive the second control clock signal CCLK2, the third output part OUT3 may receive the third control clock signal CCLK3, the fourth output part OUT4 may receive the fourth control clock signal CCLK4, the fifth output part OUT5 may receive the fifth control clock signal CCLK5, the sixth output part OUT6 may receive the sixth control clock signal CCLK6, the seventh output part OUT7 may receive the seventh control clock signal CCLK7, the eighth output part OUT8 may receive the eighth control clock signal CCLK8, the ninth output part OUT9 may receive the ninth control clock signal CCLK9, and the tenth output part OUT10 may receive the tenth control clock signal CCLK10.

As an example, the plurality of control clock signals CCLK1 to CCLK10 may have waveforms having the same cycle and the same pulse width and having phases that do not overlap one another, without being limited thereto.

For example, with reference further to FIG. 23, in case that the gate driver 2220 operates in the second mode and the plurality of control clock signals CCLK1 to CCLK10 toggle, as described above, the second control clock signal CCLK2 may be set to a signal shifted by about 1/2 cycle from the first control clock signal CCLK1, the third control clock signal CCLK3 may be set to a signal shifted by about 1/2 cycle from the second control clock signal CCLK2, the fourth control clock signal CCLK4 may be set to a signal shifted by about 1/2 cycle from the third control clock signal CCLK3, the fifth control clock signal CCLK5 may be set to a signal shifted by about 1/2 cycle from the fourth control clock signal CCLK4, the sixth control clock signal CCLK6 may be set to a signal shifted by about 1/2 cycle from the fifth control clock signal CCLK5, the seventh control clock signal CCLK7 may be set to a signal shifted by about 1/2 cycle from the sixth control clock signal CCLK6, the eighth control clock signal CCLK8 may be set to a signal shifted by about 1/2 cycle from the seventh control clock signal CCLK7, the ninth control clock signal CCLK9 may be set to a signal shifted by about 1/2 cycle from the eighth control clock signal CCLK8, and the tenth control clock signal CCLK10 may be set to a signal shifted by about 1/2 cycle from the ninth control clock signal CCLK9. The present disclosure is not limited thereto.

As an example, the first control clock signal CCLK1, the third control clock signal CCLK3, the fifth control clock signal CCLK5, the seventh control clock signal CCLK7, and the ninth control clock signal CCLK9 may be set to have a difference of a multiple of 1 cycle and have substantially the same waveform, and the second control clock signal CCLK2, the fourth control clock signal CCLK4, the sixth control clock signal CCLK6, the eighth control clock signal CCLK8, and the tenth control clock signal CCLK10 may be set to have a difference of a multiple of 1 cycle and have substantially the same waveform. The present disclosure is not limited thereto.

In the exemplary embodiment, the signal level of at least any one of the plurality of control clock signals CCLK1 to CCLK10 may be controlled depending on the driving mode. For example, the signal levels of the plurality of control clock signals CCLK1 to CCLK10 may be controlled independently.

Therefore, the signal levels of the plurality of pull-up control signals PUS1 to PUS10 and the plurality of pull-down control signals PDS1 to PDS10 outputted from the plurality of output parts OUT1 to OUT10 may be controlled.

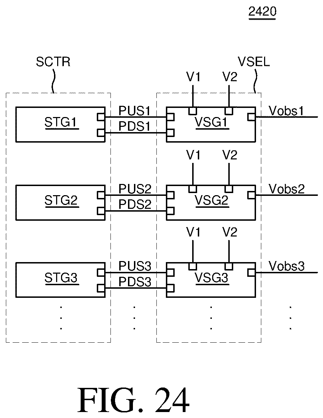

FIG. 24 is a block diagram illustrating the gate driver according to the exemplary embodiment of the present specification.

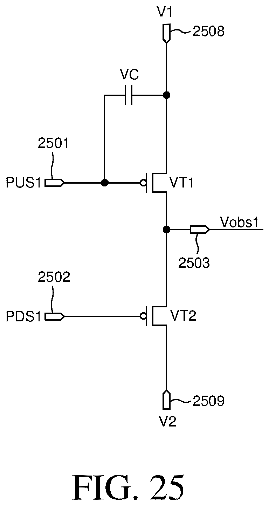

FIG. 25 is a circuit diagram illustrating an example of a first selection stage of a voltage selector included in the gate driver in FIG. 24.

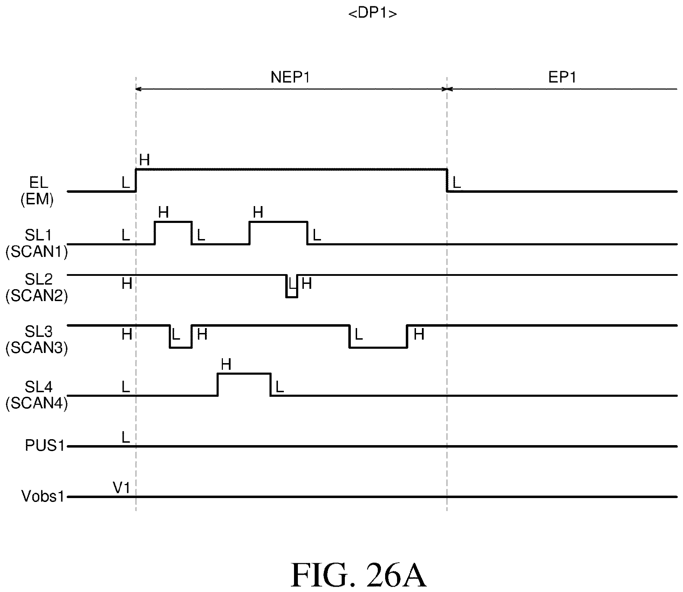

FIGS. 26A to 26C are waveform diagrams for explaining an example of an operation of the first selection stage in FIG. 25.

Meanwhile, a gate driver 2420 represents a modified exemplary embodiment related to a voltage selector VSEL illustrated in FIG. 24. Therefore, for convenience of description, redundant descriptions will not be repeated or briefly given.

Meanwhile, FIGS. 26A to 26C illustrate various signals, which are inputted to operate the pixel PX described with reference to FIG. 3, together with the pull-up control signal PUS1 and a bias voltage Vobs1 in order to explain an operation of the voltage selector VSEL.

With reference to FIG. 24, the gate driver 2420 according to the exemplary embodiment of the present specification may include the output controller SCTR and the voltage selector VSEL.

According to the exemplary embodiment, the output controller SCTR may be implemented as any one of the output controller SCTR1 described with reference to FIG. 6A, the output controller SCTR2 described with reference to FIG. 15, the output controller SCTR3 described with reference to FIG. 16, the output controller SCTR4 described with reference to FIG. 18, the output controller SCTR5 described with reference to FIG. 20, and the output controller SCTR6 described with reference to FIG. 22. As an example, the plurality of stages STG1 to STG3 included in the output controller SCTR may output the pull-up control signals PUS1 to PUS3 and the pull-down control signals PDS1 to PDS3.

The voltage selector VSEL may include a plurality of selection stages VSG1 to VSG3. The plurality of selection stages VSG1 to VSG3 may output a plurality of bias voltages Vobs1 to Vobs3 on the basis of the plurality of pull-up control signals PUS1, PUS2, PUS3, and PUS4, the plurality of pull-down control signals PDS1 to PDS4, first voltage V1, and a second voltage V2.

In the exemplary embodiment, the plurality of selection stages VSG1 to VSG3 included in the voltage selector VSEL may be cascaded.

For example, a second selection stage VSG2 may be cascaded to a first selection stage VSG1, and a third selection stage VSG3 may be cascaded to the second selection stage VSG2. In this case, the plurality of selection stages VSG1 to VSG3 may have substantially the same configuration.

In the exemplary embodiment, the plurality of selection stages VSG1 to VSG3 may output one of a first voltage V1 and the second voltage V2 as the bias voltages Vbos1 to Vobs3 on the basis of the pull-up control signals PUS1 to PUS3 and the pull-down control signals PDS1 to PDS3 provided to the corresponding selection stage.

More specifically, among the plurality of selection stages VSG1 to VSG3, the first selection stage VSG1 will be described with reference further to FIG. 25. The first selection stage VSG1 may receive the first pull-up control signal PUS1 through a first selection input terminal 2501, e.g., the first selection input terminal 2501 connected to the second output terminal 726 of the first output part OUT1 included in the first stage STG1 of the output controller SCTR1 and receive the first pull-down control signal PDS1 through a second selection input terminal 2502, e.g., the second selection input terminal 2502 connected to the third output terminal 727 of the first output part OUT1 included in the first stage STG1 of the output controller SCTR1.

The first selection stage VSG1 may output the first voltage V1 supplied from a first voltage terminal 2508 or the second voltage V2 supplied from a second voltage terminal 2509 as a first bias voltage Vobs1 on the basis of the signal levels of the first pull-up control signal PUS1 and the first pull-down control signal PDS1.

To this end, the first selection stage VSG1 may include a first selection transistor VT1 and a second selection transistor VT2. In the exemplary embodiment, the first selection stage VSG1 may further include an auxiliary capacitor VC connected between the first selection input terminal 2501 and the first voltage terminal 2508.

The first selection transistor VT1 may be connected between the first voltage terminal 2508 and a voltage output terminal 2503 and may include a gate electrode connected to the first selection input terminal 2501 through which the first pull-up control signal PUS1 is provided.

When the first pull-up control signal PUS1 has the gate-on level, e.g., the low level, the first selection transistor VT1 may be turned on and output the first voltage V1, which is provided from the first voltage terminal 2508, to the voltage output terminal 2503. As an example, in case that the first selection transistor VT1 is turned on, the first bias voltage Vobs1 may have the voltage level of the first voltage V1.

The second selection transistor VT2 may be connected between the second voltage terminal 2509 and the voltage output terminal 2503 and may include a gate electrode connected to the second selection input terminal 2502 through which the first pull-down control signal PDS1 is provided.

When the first pull-down control signal PDS1 has the gate-on level, e.g., the low level, the second selection transistor VT2 may be turned on and output the second voltage V2, which is provided from the second voltage terminal 2509, to the voltage output terminal 2503. As an example, in case that the second selection transistor VT2 is turned on, the first bias voltage Vobs1 may have the voltage level of the second voltage V2.

In the exemplary embodiment, the voltage level of the first voltage V1 and the voltage level of the second voltage V2 may be different from each other. For example, as described above, the bias voltage Vobs may be a voltage for controlling the driving transistor DT included in the pixel PX in the on-bias state. Both the first voltage V1 and the second voltage V2 have positive voltage levels, and the voltage level of the first voltage V1 may be higher than the voltage level of the second voltage V2.

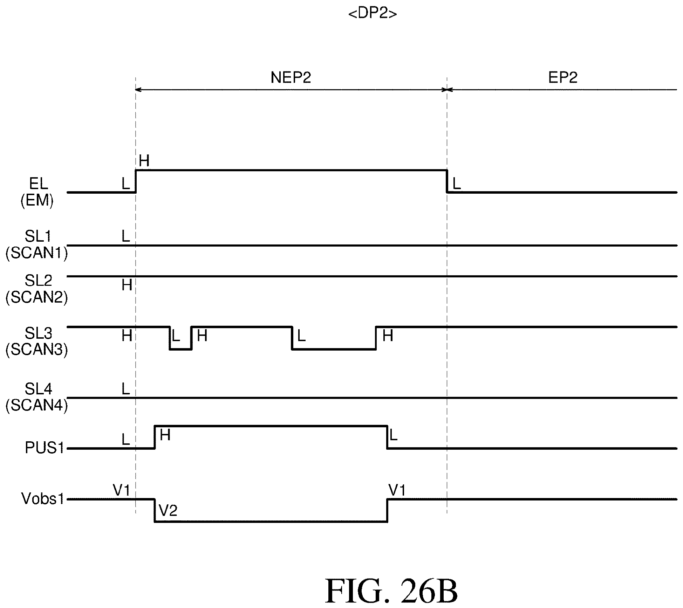

More specifically, with reference to FIGS. 26A and 26B, for the first display period DP1, e.g., the period for which the output controller SCTR operates in the first mode and the first pull-up control signal PUS1 has the gate-on level, i.e., the low level L as illustrated in FIG. 26A, the first selection transistor VT1 may be turned on by the first pull-up control signal PUS1 with the low level L, and the second selection transistor VT2 may be turned off by the first pull-down control signal PDS1 with the high level H.

Therefore, the first selection stage VSG1 may output the first bias voltage Vobs1 of the first voltage V1 through the voltage output terminal 2503, and the first bias voltage Vobs1 of the first voltage V1 may be supplied to the driving transistor DT of the pixel PX by the turned-on seventh switching transistor M7 in the interval in which the third scan signal SCAN3 has the gate-on level, e.g., the low level L.

In addition, for the second display period DP2, e.g., the period for which the output controller SCTR operates in the second mode and the first pull-up control signal PUS1 has the pulse with the gate-off level, i.e., the high level H in at least a partial interval as illustrated in FIG. 26B, the second selection transistor VT2 may be turned on by the first pull-down control signal PDS1 having the pulse with the low level L, and the first selection transistor VT1 may be turned off by the first pull-up control signal PUS1 having the pulse with the high level H for the corresponding period.

Therefore, the first selection stage VSG1 may output the first bias voltage Vobs1 of the second voltage V2 through the voltage output terminal 2503, and the first bias voltage Vobs 1 of the second voltage V2 may be supplied to the driving transistor DT of the pixel PX by the turned-on seventh switching transistor M7 in the interval in which the third scan signal SCAN3 has the gate-on level, e.g., the low level L.

In this case, a change in luminance may occur for each sub-display area because of a difference in threshold voltage Vth properties of the driving transistor DT in accordance with a change in driving frequency when the display device 100 controls the driving frequency for each sub-display area of the display area AA.

Therefore, when the gate driver 2420 according to the exemplary embodiment of the present specification controls the driving frequency for each sub-display area of the display area AA, the voltage levels of the bias voltages Vobs for shifting the threshold voltage of the driving transistor DT are differently controlled in the first display period DP1 and the second display period DP2, e.g., in the first mode and the second mode, such that a deviation of the threshold voltage properties of the driving transistor DT in accordance with the change in driving frequency may be improved. Therefore, even though the driving frequency is differently controlled for each sub-display area of the display area AA, the display quality may not deteriorate.

According to the exemplary embodiment, in order to apply the first bias voltage Vobs1 of the second voltage V2 to the pixel PX through the turned-on seventh switching transistor M7 for the second display period DP2 in the interval in which the third scan signal SCAN3 has the gate-on level, the pulse with the high level H of the first pull-up control signal PUS1 may at least partially overlap the pulse with the low level L of the third scan signal SCAN3. For example, the pulse of the high level H of the first pull-up control signal PUS1 may overlap both the pulses of the two low levels L included in the third scan signal SCAN3.

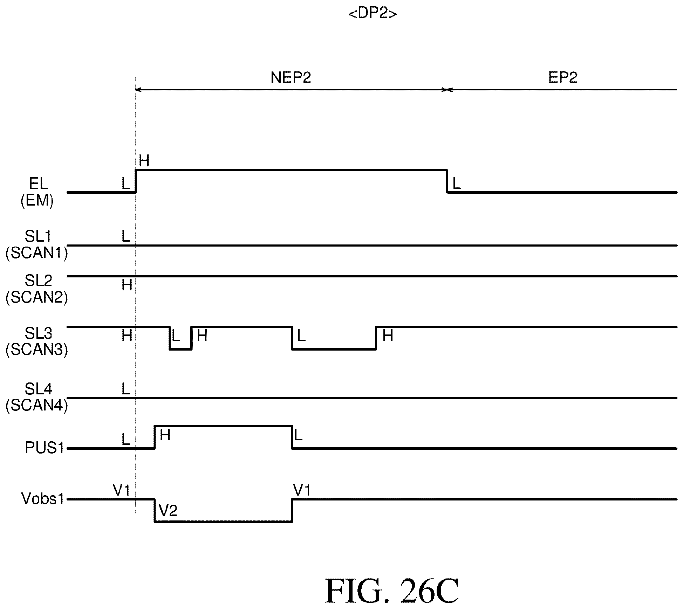

However, the present specification is not limited thereto. With reference to FIG. 26C, the pulse of the high level H of the first pull-up control signal PUS1 may overlap one of the pulses of the two low levels L included in the third scan signal SCAN3. In this case, the first bias voltage Vobs1 of the second voltage V2 may be supplied to the pixel PX in a partial interval of the second display period DP2, and the first bias voltage Vobs1 of the first voltage V1 may be supplied to the pixel PX in another partial interval. As described above, it is possible to control an average voltage level of the bias voltage Vobs to be applied to the pixel PX by adjusting the pulse width of the high level H of the first pull-up control signal PUS1.

Meanwhile, as described above, the output controller SCTR included in the gate driver 2420 illustrated in FIG. 24 may be implemented as any one of the output controller SCTR1 described with reference to FIG. 6A, the output controller SCTR2 described with reference to FIG. 15, the output controller SCTR3 described with reference to FIG. 16, the output controller SCTR4 described with reference to FIG. 18, the output controller SCTR5 described with reference to FIG. 20, and the output controller SCTR6 described with reference to FIG. 22. Therefore, because the pull-up control signals PUS 1 to PUS3 and the pull-down control signals PDS1 to PDS3 outputted from the plurality of stages STG1 to STG3 of the output controller SCTR are formed in the unit of at least two or more horizontal lines, the plurality of selection stages VSG1 to VSG3 included in the voltage selector VSEL may provide the bias voltages Vobs1 to Vobs3 to the plurality of pixels PX formed in the unit of at least two or more horizontal lines while corresponding to the output controller SCTR.

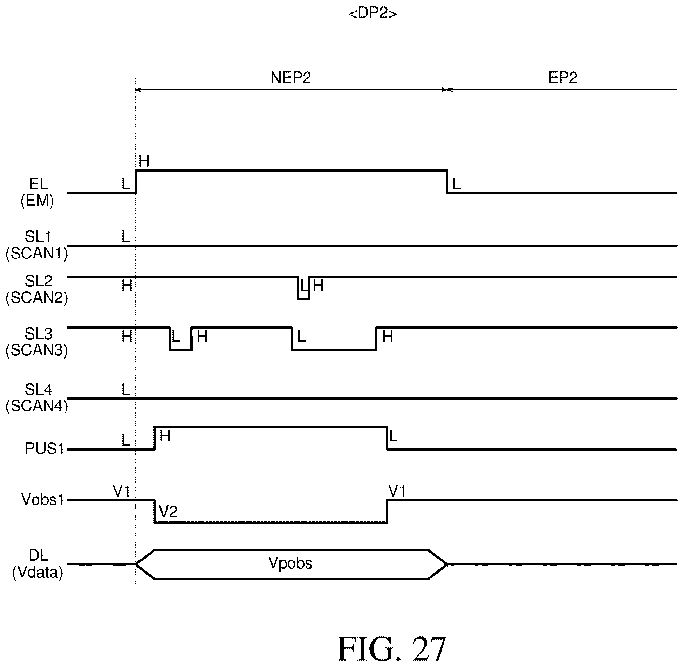

FIG. 27 is a waveform diagram for explaining another example of the operation of the pixel in FIG. 3.

For example, the waveform diagram illustrated in FIG. 27 represents a modified exemplary embodiment of the waveform diagram described with reference to FIG. 26B.

With reference to FIGS. 3, 24, and 27, as described above, for the second display period DP2, e.g., the period for which the output controller SCTR operates in the second mode and the first pull-up control signal PUS1 has the pulse with the gate-off level, i.e., the high level H in at least a partial interval, the first bias voltage Vobs1 of the second voltage V2 outputted from the first selection stage VSG1 may be supplied to the pixel PX.

However, in some instances, a degree to which the threshold voltage is shifted may not be sufficient even though the first bias voltage Vobs1 is supplied to the pixel PX, e.g., the driving transistor DT. In this case, the hysteresis characteristics may not be improved.

Therefore, in the exemplary embodiment, the second scan signal SCAN2 supplied to the second scan line SL2 for the second display period DP2 may have the pulse with the gate-on level, e.g., the low level L, and the data signal Vdata supplied to the data line DL may have a parking voltage Vpobs. In this case, the parking voltage Vpobs may have a voltage level corresponding to the bias voltage Vobs.

Therefore, the data signal Vdata having the parking voltage Vpobs is supplied to the first electrode, e.g., the source electrode of the driving transistor DT through the first switching transistor M1 turned on by the second scan signal SCAN2 for the second display period DP2, and the driving transistor DT has the on-bias state, such that the hysteresis characteristics may be more effectively implemented.

As described above, in the case of the gate driver and the display device including the same according to the exemplary embodiment of the present specification, the gate driver may include the output controller configured to control the output level of the gate signal outputted from the scan driver.

Therefore, the gate driver and the display device including the same according to the exemplary embodiment of the present specification may freely divide the display area in response to the display image and control the driving frequency for each area without being limited to the fixed area. Therefore, the driving frequency is controlled in response to the display image, such that power consumption may be improved.

In addition, the gate driver according to the exemplary embodiment of the present specification controls the signal level of the gate signal by using the output controller connected in common to the plurality of scan drivers without including a separate controller for controlling the signal level of the gate signal outputted from the plurality of scan drivers, thereby reducing or minimizing the size of the bezel area in which the gate driver is disposed.

In addition, the gate driver according to the exemplary embodiment of the present specification may include the voltage selector configured to control the voltage level of the bias voltage, which is provided to control the on-bias state of the pixel, for each display area in accordance with the driving frequency. Therefore, even though the driving frequency is differently controlled for each sub-display area of the display area, the display quality may not deteriorate.

The exemplary embodiments of the present disclosure can also be described as follows:

According to an aspect of the present disclosure, a gate driver includes a light emission driver comprising a plurality of light emission stages cascaded and configured to output a plurality of light emission control signals on the basis of a light emission start signal and a plurality of light emission clock signals and an output controller comprising a plurality of stages cascaded and configured to output a plurality of pull-up control signals and a plurality of pull-down control signals on the basis of the plurality of light emission control signals, a plurality of clock signals, a plurality of control clock signals, a first power source, and a second power source having a lower voltage level than the first power source, wherein the plurality of stages each includes a carry part configured to output a carry signal on the basis of at least one of the plurality of light emission control signals, at least one of the plurality of clock signals, the first power source, and the second power source, and an output part configured to output a respective one of the plurality of pull-up control signals and a respective one of the plurality of pull-down control signals on the basis of the carry signal, at least one of the plurality of control clock signals, the first power source, and the second power source.

The gate driver may further include a scan driver comprising a plurality of gate stages cascaded and configured to output a plurality of gate signals on the basis of a gate start signal, a plurality of gate clock signals, the plurality of pull-up control signals, and the plurality of pull-down control signals.

Signal levels of the plurality of gate signals may be controlled on the basis of the plurality of pull-up control signals and the plurality of pull-down control signals.

Each of the plurality of pull-up control signals and each of the plurality of pull-down control signals may have phases opposite to each other. In other words, each pull-up control signal may have a phase that is opposite to a phase of a pull-down control signal corresponding to the pull-up control signal.

The plurality of control clock signals each may have a waveform that toggles between a gate-on level and a gate-off level or is maintained at the gate-on level.

The scan driver may be configured to output the gate signal having a pulse with the gate-on level in an interval in which the at least one control clock signal has the gate-on level, and the scan driver may be configrued to output the gate signal maintained at the gate-off level in an interval in which the at least one control clock signal toggles between the gate-on level and the gate-off level.

The plurality of gate stages may be grouped into a plurality of gate stages groups, and the respective gate stages included in a respective one of the plurality of gate stages groups each may receive the same pull-up control signal among the plurality of pull-up control signals and may receive the same pull-down control signal among the plurality of pull-down control signals.

The carry part include a first transistor connected between a first input terminal, through which the light emission control signal is provided, and a first control node and comprising a gate electrode connected to a second input terminal through which the at least one clock signal is provided, a second transistor connected between a second control node and a first power input terminal, through which a voltage of the first power source is supplied, and comprising a gate electrode connected to the first input terminal, a third transistor connected between the second input terminal and a first QB node and comprising a gate electrode connected to the second control node, a fourth transistor connected between the first power input terminal and the first QB node and comprising a gate electrode connected to the first control node, a fifth transistor connected between a second power input terminal, through which a voltage of the second power source is supplied, and a first output terminal, through which the carry signal is outputted, and comprising a gate electrode connected to a first Q node, a sixth transistor connected between the first power input terminal and the first output terminal and comprising a gate electrode connected to the first QB node, a first bridge voltage transistor connected between the first control node and the first Q node and comprising a gate electrode connected to the second power input terminal, and a first capacitor connected between the second input terminal and the second control node.

The carry part may further include a second capacitor connected between the first Q node and the first output terminal and a third capacitor connected between the first QB node and the first power input terminal.

The output part may include a seventh transistor connected between a third input terminal, through which the carry signal is provided, and a third control node and comprising a gate electrode connected to a fourth input terminal through which the at least one control clock signal is provided, an eighth transistor connected between a fourth control node and a first power input terminal, through which a voltage of the first power source is supplied, and comprising a gate electrode connected to the third input terminal, a ninth transistor connected between the fourth input terminal and a second QB node and comprising a gate electrode connected to the fourth control node, a tenth transistor connected between the first power input terminal and the second QB node and comprising a gate electrode connected to the third control node, an eleventh transistor connected between a second power input terminal, through which a voltage of the second power source is supplied, and a second output terminal, through which the pull-up control signal is outputted, and comprising a gate electrode connected to a second Q node, a twelfth transistor connected between the first power input terminal and the second output terminal and comprising a gate electrode connected to the second QB node, a second bridge voltage transistor connected between the third control node and the second Q node and comprising a gate electrode connected to the second power input terminal and a fourth capacitor connected between the fourth input terminal and the fourth control node, and wherein the pull-down control signal may be outputted through a third output terminal connected to the second QB node.

The output part may further include a fifth capacitor connected between the second Q node and the second output terminal and a sixth capacitor connected between the second QB node and the first power input terminal.

The plurality of gate stages each may include a gate signal generator configured to control a voltage of an output node on the basis of the gate start signal, the plurality of gate clock signals, the first power source, and the second power source, and a masking part configured to control a signal level of the gate signal on the basis of the pull-up control signal and the pull-down control signal.

The masking part may include a first masking transistor connected between the output node and a gate output terminal, through which the gate signal is outputted, and comprising a gate electrode configured to receive the pull-up control signal, and a second masking transistor connected between the gate output terminal and a first power input terminal, through which a voltage of the first power source is supplied, or between the gate output terminal and a second power input terminal, through which a voltage of the second power source is supplied, and comprising a gate electrode configured to receive the pull-down control signal.

The gate driver may further include a voltage selector comprising a plurality of selection stages cascaded and configured to output a plurality of bias voltages on the basis of the plurality of pull-up control signals, the plurality of pull-down control signals, a first voltage, and a second voltage having a voltage level different from that of the first voltage.

The plurality of bias voltages may have a voltage level of the first voltage or a voltage level of the second voltage on the basis of the plurality of pull-up control signals and the plurality of pull-down control signals.

The voltage selector may include a first selection transistor connected between a first voltage terminal, through which the first voltage is supplied, and a voltage output terminal, through which the bias voltage is outputted, and comprising a gate electrode configured to receive the pull-up control signal, and a second selection transistor connected between the voltage output terminal and a second voltage terminal, through which the second voltage is supplied, and comprising a gate electrode configured to receive the pull-down control signal.

According to another aspect of the present disclosure, a gate driver includes an output controller comprising a plurality of stages cascaded and configured to output a plurality of pull-up control signals and a plurality of pull-down control signals on the basis of a plurality of light emission control signals, a plurality of clock signals, a plurality of control clock signals, a first power source, and a second power source having a lower voltage level than the first power source and a scan driver comprising a plurality of gate stages cascaded and configured to output a plurality of gate signals on the basis of a gate start signal, a plurality of gate clock signals, the plurality of pull-up control signals, and the plurality of pull-down control signals, wherein the plurality of stages each includes a carry part configured to output a carry signal on the basis of at least one of the plurality of light emission control signals, at least one of the plurality of clock signals, the first power source, and the second power source, and an output part configured to output a respective one of the plurality of pull-up control signals and a respective one of the plurality of pull-down control signals on the basis of the carry signal, at least one of the plurality of control clock signals, the first power source, and the second power source.

According to an aspect of the present disclosure, a display device includes a display panel comprising a plurality of pixels, a scan driver configured to output a plurality of gate signals to the plurality of pixels, a light emission driver configured to output a plurality of light emission control signals to the plurality of pixels and an output controller comprising a plurality of stages configured to output a plurality of pull-up control signals and a plurality of pull-down control signals on the basis of the plurality of light emission control signals, a plurality of clock signals, a plurality of control clock signals, a first power source, and a second power source having a lower voltage level than the first power source, wherein the plurality of stages each includes a carry part configured to output a carry signal on the basis of at least one of the plurality of light emission control signals, at least one of the plurality of clock signals, the first power source, and the second power source, and an output part configured to output a respective one of the plurality of pull-up control signals and a respective one of the plurality of pull-down control signals on the basis of the carry signal, at least one of the plurality of control clock signals, the first power source, and the second power source.

Each of the plurality of pull-up may control signals and each of the plurality of pull-down control signals may have phases opposite to each other.

A display area of the display panel may be divided into a plurality of sub-display areas, and the scan driver may be configured to output different gate signals in accordance with the plurality of sub-display areas.

## Claims

1. A gate driver (120, 620, 1520, 1620, 2420) comprising:
a light emission driver (EDV) comprising a plurality of light emission stages (EST1, ..., EST32) cascaded and configured to output a plurality of light emission control signals (EM1, ..., EM32) on the basis of a light emission start signal (EVST) and a plurality of light emission clock signals (ECLK1, ECLK2); and
an output controller (SCTR, SCTR1, SCTR2) comprising a plurality of stages (STG1, ..., STG4) cascaded and configured to output a plurality of pull-up control signals (PUS1, ..., PUS4) and a plurality of pull-down control signals (PDS1, ..., PDS4) on the basis of the plurality of light emission control signals (EM1, ..., EM32), a plurality of clock signals (CLK1, CLK2), a plurality of control clock signals (CCLK1, ..., CCLK4), a first power source (VGH), and a second power source (VGL) having a lower voltage level than the first power source (VGH),
wherein the plurality of stages (STG1, ..., STG4) each comprise:
a carry part (CRY1, ..., CRY4) configured to output a carry signal (CR1, ..., CR4) on the basis of at least one of the plurality of light emission control signals (EM1, ..., EM32), at least one of the plurality of clock signals (CLK1, CLK2), the first power source (VGH), and the second power source (VGL); and
an output part (OUT1, ..., OUT4) configured to output a respective one of the plurality of pull-up control signals (PUS1, ..., PUS4) and a respective one of the plurality of pull-down control signals (PDS1, ..., PDS4) on the basis of the carry signal (CR1, ..., CR4), at least one of the plurality of control clock signals (CCLK1, ..., CCLK4), the first power source (VGH), and the second power source (VGL).

2. The gate driver (120, 620, 1520, 1620, 2420) of claim 1, further comprising:
a scan driver (SDV) comprising a plurality of gate stages (GST1, ..., GST32) cascaded and configured to output a plurality of gate signals (GATE1, ..., GATE32) on the basis of a gate start signal (GVST), a plurality of gate clock signals (GCLK1, GCLK2), the plurality of pull-up control signals (PUS1, ..., PUS4), and the plurality of pull-down control signals (PDS1, ..., PDS4).

3. The gate driver (120, 620, 1520, 1620, 2420) of claim 2, wherein signal levels of the plurality of gate signals (GATE1, ..., GATE32) are controlled on the basis of the plurality of pull-up control signals (PUS1, ..., PUS4) and the plurality of pull-down control signals (PDS1, ..., PDS4).

4. The gate driver (120, 620, 1520, 1620, 2420) of claim 3, wherein each of the plurality of pull-up control signals (PUS1, ..., PUS4) and each of the plurality of pull-down control signals (PDS1, ..., PDS4) have phases opposite to each other.

5. The gate driver (120, 620, 1520, 1620, 2420) of any of claims 2 to 4, wherein the plurality of control clock signals (CCLK1, ..., CCLK4) each have a waveform that toggles between a gate-on level (H) and a gate-off level (L) or is maintained at the gate-on level (H).

6. The gate driver (120, 620, 1520, 1620, 2420) of claim 5, wherein the scan driver (SDV) is configured to output the gate signal having a pulse with the gate-on level (H) in an interval in which the at least one control clock signal has the gate-on level (H), and
wherein the scan driver (SDV) is configured to output the gate signal maintained at the gate-off level (L) in an interval in which the at least one control clock signal toggles between the gate-on level (H) and the gate-off level (L).

7. The gate driver (120, 620, 1520, 1620, 2420) of any of claims 2 to 6, wherein the plurality of gate stages (GST1, ..., GST32) are grouped into a plurality of gate stages groups (GSG1, ..., GSG4), and the respective gate stages included in a respective one of the plurality of gate stages groups (GSG1, ..., GSG4) each receive the same pull-up control signal among the plurality of pull-up control signals (PUS1, ..., PUS4) and receive the same pull-down control signal among the plurality of pull-down control signals (PDS1, ..., PDS4).

8. The gate driver (120, 620, 1520, 1620, 2420) of any of claims 1 to 7, wherein the carry part ( CRY1, ..., CRY4) comprises:
a first transistor (T1) connected between a first input terminal (721), through which the light emission control signal (EM1) is provided, and a first control node (CN1), and comprising a gate electrode connected to a second input terminal (722), through which the at least one clock signal (CLK1) is provided;
a second transistor (T2) connected between a second control node (CN2) and a first power input terminal (728), through which a voltage of the first power source (VGH) is supplied, and comprising a gate electrode connected to the first input terminal (721);
a third transistor (T3) connected between the second input terminal (722) and a first QB node (QB1), and comprising a gate electrode connected to the second control node (CN2);
a fourth transistor (T4) connected between the first power input terminal (728) and the first QB node (QB1), and comprising a gate electrode connected to the first control node (CN1);
a fifth transistor (T5) connected between a second power input terminal (729), through which a voltage of the second power source (VGL) is supplied, and a first output terminal (723), through which the carry signal (CR1) is outputted, and comprising a gate electrode connected to a first Q node (Q1);
a sixth transistor (T6) connected between the first power input terminal (728) and the first output terminal (723), and comprising a gate electrode connected to the first QB node (QB1);
a first bridge voltage transistor (Tbv1) connected between the first control node (CN1) and the first Q node (Q1), and comprising a gate electrode connected to the second power input terminal (729); and
a first capacitor (C1) connected between the second input terminal (722) and the second control node (CN2),
wherein, preferably, the carry part (CRY1, ..., CRY4) further comprises:
a second capacitor (C2) connected between the first Q node (Q1) and the first output terminal (723); and
a third capacitor (C3) connected between the first QB node (QB1) and the first power input terminal (728).

9. The gate driver (120, 620, 1520, 1620, 2420) of any of claims 1 to 8, wherein the output part (OUT1, ..., OUT4) comprises:
a seventh transistor (T7) connected between a third input terminal (724), through which the carry signal (CR1) is provided, and a third control node (CN3), and comprising a gate electrode connected to a fourth input terminal (725) through which the at least one control clock signal (CCLK1) is provided;
an eighth transistor (T8) connected between a fourth control node (CN4) and a first power input terminal (728), through which a voltage of the first power source (VGH) is supplied, and comprising a gate electrode connected to the third input terminal (724);
a ninth transistor (T9) connected between the fourth input terminal (725) and a second QB node (QB2), and comprising a gate electrode connected to the fourth control node (CN4);
a tenth transistor (T10) connected between the first power input terminal (728) and the second QB node (QB2), and comprising a gate electrode connected to the third control node (CN3);
an eleventh transistor (T11) connected between a second power input terminal (729), through which a voltage of the second power source (VGL) is supplied, and a second output terminal (726), through which the pull-up control signal (PUS1) is outputted, and comprising a gate electrode connected to a second Q node (Q2);
a twelfth transistor (T12) connected between the first power input terminal (728) and the second output terminal (726), and comprising a gate electrode connected to the second QB node (QB2);
a second bridge voltage transistor (Tbv2) connected between the third control node (CN3) and the second Q node (Q2), and comprising a gate electrode connected to the second power input terminal (729); and
a fourth capacitor (C4) connected between the fourth input terminal (725) and the fourth control node (CN4), and
wherein the pull-down control signal (PDS1) is outputted through a third output terminal (727) connected to the second QB node (QB2),
wherein, preferably, the output part (OUT1, ..., OUT4) further comprises:
a fifth capacitor (C5) connected between the second Q node (Q2) and the second output terminal (726); and
a sixth capacitor (C6) connected between the second QB node (QB2) and the first power input terminal (728).

10. The gate driver (120, 620, 1520, 1620, 2420) of claim 2 or any of claims 3 to 9 referring, directly or indirectly, back to claim 2, wherein the plurality of gate stages (GST1, ..., GST32) each comprise:
a gate signal generator (SRO, SRO_1) configured to control a voltage of an output node (PN) on the basis of the gate start signal (GVST), the plurality of gate clock signals (GCLK1, GCLK2), the first power source (VGH), and the second power source (VGL); and
a masking part (MSK, MSK_1) configured to control a signal level of the gate signal (GATE1) on the basis of the pull-up control signal (PUS1) and the pull-down control signal (PDS1).

11. The gate driver (120, 620, 1520, 1620, 2420) of claim 10, wherein the masking part (MSK, MSK_1) comprises:
a first masking transistor (PT1) connected between the output node (PN) and a gate output terminal (1108, 1308), through which the gate signal (GATE1) is outputted, and comprising a gate electrode configured to receive the pull-up control signal (PUS1); and
a second masking transistor (PT2) connected between the gate output terminal (1308) and a first power input terminal (1304), through which a voltage of the first power source (VGH) is supplied, or between the gate output terminal (1108) and a second power input terminal (1104), through which a voltage of the second power source (VGL) is supplied, and comprising a gate electrode configured to receive the pull-down control signal (PDS1).

12. The gate driver (120, 620, 1520, 1620, 2420) of any of claims 1 to 11, further comprising:
a voltage selector (VSEL) comprising a plurality of selection stages (VSG1, VSG2, VSG3) cascaded and configured to output a plurality of bias voltages (Vobs1, Vobs1, Vobs3) on the basis of the plurality of pull-up control signals (PUS1, ..., PUS4), the plurality of pull-down control signals (PDS1, ..., PDS4), a first voltage (V1), and a second voltage (V2) having a voltage level different from that of the first voltage (V1).

13. The gate driver (120, 620, 1520, 1620, 2420) of claim 12, wherein the plurality of bias voltages (Vobs 1, Vobs2, Vobs3) has a voltage level of the first voltage (V1) or a voltage level of the second voltage (V2) on the basis of the plurality of pull-up control signals (PUS1, ..., PUS4) and the plurality of pull-down control signals (PDS1, ..., PDS4), and/or
wherein the voltage selector (VSEL) comprises:
a first selection transistor (VT1) connected between a first voltage terminal (2508), through which the first voltage (V1) is supplied, and a voltage output terminal (2503), through which a respective bias voltage (Vobs1) of the plurality of bias voltages (Vobs1, Vobs2, Vobs3) is outputted, and comprising a gate electrode configured to receive the pull-up control signal (PUS1); and
a second selection transistor (VT2) connected between the voltage output terminal (2503) and a second voltage terminal (2509), through which the second voltage (V2) is supplied, and comprising a gate electrode configured to receive the pull-down control signal (PDS1).

14. A display device (100) comprising:
a display panel (140) comprising a plurality of pixels (PX); and the gate driver (120, 620, 1520, 1620, 2420) of claim 2 or any of claims 3 to 13 referring, directly or indirectly, back to claim 2,
wherein the scan driver (SDV) of the gate driver (120, 620, 1520, 1620, 2420) is coupled to the plurality of pixels (PX) and configured to output the plurality of gate signals (GATE1, ..., GATE32) to the plurality of pixels (PX).

15. The display device (100) of claim 14, wherein each of the plurality of pull-up control signals (PUS1, ..., PUS4) and each of the plurality of pull-down control signals (PDS1, ..., PDS4) have phases opposite to each other, and/or
wherein a display area (AA) of the display panel (140) is divided into a plurality of sub-display areas (AA1, AA2, AA3), and the scan driver (SDV) is configured to output different gate signals in accordance with the plurality of sub-display areas (AA1, AA2, AA3).
